# FASCICULE DE BREVET EUROPEEN

(11) **EP 1 602 128 B1**
(45) Date de publication et mention de la délivrance du brevet: **17.08.2016**
(21) Numéro de dépôt: 04710910.3
(22) Date de dépôt: 13.02.2004
(51) Int. Cl.: H05K 3/10, H05K 3/18, H05K 3/24, C23C 18/18, H05K 3/38, C23C 18/28, H01L 21/48

(54) **PROCEDE DE REVETEMENT D UNE SURFACE, FABRICATION D'INTERCONNEXIONS EN MICROELECTRONIQUE UTILISANT CE PROCEDE, ET CIRCUITS INTEGRES**
OBERFLÄCHENBESCHICHTUNGSVERFAHREN, HERSTELLUNG VON MIKROELEKTRONISCHEN VERBINDUNGEN DURCH DAS VERFAHREN UND INTEGRIERTE SCHALTUNGEN
SURFACE-COATING METHOD, PRODUCTION OF MICROELECTRONIC INTERCONNECTIONS USING SAID METHOD AND INTEGRATED CIRCUITS

(30) Priorité: 17.02.2003 FR 0301873
(43) Date de publication de la demande: 07.12.2005
(73) Titulaire: Commissariat à l'Énergie Atomique et aux Énergies Alternatives, 75015 Paris (FR); Alchimer, 91300 Massy (FR)
(72) Inventeur: BUREAU, Christophe, F-92150 Suresnes (FR); HAUMESSER, Paul-Henri, F-38500 Saint Cassien (FR); MAITREJEAN, Sylvain, F-38000 Grenoble (FR); MOURIER, Thierry, F-38240 Meylan (FR)
(74) Mandataire: Ahner, Philippe
(86) Numéro de dépôt international: PCT/FR2004/050057
(87) Numéro de publication internationale: WO 2004/075248

(56) Documents cités:
- EP-A- 0 250 867
- EP-A- 0 250 867
- EP-A- 0 256 680
- EP-A- 0 430 333
- WO-A-01/24239
- US-A- 3 615 483
- US-A- 5 147 518
- US-A1- 2002 014 651
- DENIAU G ET AL: "Comparative study of acrylonitrile, 2-butenenitrile, 3-butenenitrile, and 2-methyl-2-propenenitrile electropolymerization on a nickel cathode" COMPENDEX, 1 janvier 1992 (1992-01-01), XP002438463
- DATABASE INSPEC [Online] INSTITUTE OF ELECTRICAL ENGINEERS, STEVENAGE, GB; Inspec No. 7074764 2001, TAO WANG ET AL: "High-aspect-ratio microstructures for magnetoelectronic applications" XP002268605 Database accession no. 7771584 & MICROMACHINING AND MICROFABRICATION PROCESS TECHNOLOGY VII, SAN JOSE, CA, USA, 27-29 JAN. 2003, vol. 4979, janvier 2003 (2003-01), pages 464-471, Proceedings of the SPIE - The International Society for Optical Engineering, 2003, SPIE-Int. Soc. Opt. Eng, USA ISSN: 0277-786X
- TADA M ET AL: "Barrier-metal-free (BMF), Cu dual-damascene interconnects with Cu-epi-contacts buried in anti-diffusive, low-k organic film" 2001 SYMPOSIUM ON VLSI TECHNOLOGY. DIGEST OF TECHNICAL PAPERS. KYOTO, JAPAN, JUNE 12 - 14, 2001, SYMPOSIUM ON VLSI TECHNOLOGY, TOKYO: JSAP, JP, 12 juin 2001 (2001-06-12), pages 13-14, XP010551976 ISBN: 4-89114-012-7

## Description

### DOMAINE TECHNIQUE

La présente invention se rapporte à un procédé de revêtement d'une surface d'un substrat par un film de germination d'un matériau métallique, à un procédé de fabrication d'interconnexions en microélectronique, ainsi qu'à des éléments d'interconnexion en microélectronique, des microsystèmes électroniques et des circuits intégrés obtenus par ces procédés.

Les surfaces concernées par la présente invention présentent la particularité d'être des surfaces conductrices ou semi-conductrices de l'électricité et de présenter des creux et/ou des saillies, qui sont par exemple des microgravures, par exemple des trous d'interconnexion ou vias destinés à l'élaboration de systèmes microélectroniques, par exemple de circuits intégrés.

L'invention se rapporte de façon générale à un procédé de dépôt homogène - et notamment conforme - de couches de métaux sur des surfaces conductrices ou semi-conductrices de l'électricité, et à leurs applications, notamment aux procédés et méthodes de fabrication de circuits intégrés, et plus particulièrement à la formation de réseaux d'interconnexions métalliques, par exemple à base de cuivre, ainsi qu'aux procédés et méthodes de fabrication de micro-systèmes et de connecteurs.

### ETAT DE LA TECHNIQUE ANTERIEURE

Dans ce qui suit, l'Art antérieur est restreint au domaine de la microélectronique, car il est représentatif à la fois des dispositifs et procédés actuellement disponibles pour obtenir des dépôts métalliques homogènes, ainsi que de l'aggravation des difficultés techniques pour obtenir des dépôts métalliques homogènes - et notamment conformes - à mesure que la demande en processeurs plus rapides, à gravures de plus en plus fines, se fait plus pressante. L'homme du métier pourra donc facilement transposer ces problèmes aux autres applications telles que les microsystèmes ou les connecteurs, le problème étant le même à une échelle simplement différente. Tout au plus apparaissent de nouvelles contraintes, notamment de coût, qui font que certains des procédés et dispositifs décrits ci-dessous pour la microélectronique ne sont pas applicables pour ces domaines.

Les circuits intégrés sont fabriqués par formation de dispositifs semi-conducteurs discrets à la surface de plaquettes (« wafers », en anglais) de silicium. Un réseau d'interconnexion métallurgique est ensuite établi sur ces dispositifs, de façon à établir le contact entre leurs éléments actifs et à réaliser entre eux le câblage nécessaire pour obtenir le circuit désiré. Un système d'interconnexions est constitué de plusieurs niveaux. Chaque niveau est formé par des lignes de métal et ces lignes sont reliées entre elles par de contacts appelés « trous d'interconnexion » ou « vias ».

Le développement technologique des microsystèmes a entraîné une augmentation de la densité d'intégration et de ce fait une diminution de la taille des composants. La longueur des interconnexions augmente, leur largeur diminue ainsi que l'espacement entre les lignes. Lorsqu'elles sont réalisées en aluminium ou en tungstène, ces interconnexions conduisent alors à des résistances de plus en plus inacceptables à mesure que leur taille se réduit. Ces résistances élevées augmentent en effet l'impédance des circuits, les délais de propagation des signaux électriques et peuvent limiter les vitesses d'horloge des microprocesseurs. L'aluminium est, de plus, susceptible d'électro-migrer sous une forte densité de courant. Ceci peut se produire dans des conducteurs de section très faible et provoquer des discontinuités qui conduisent à des dysfonctionnements des circuits.

La conductivité du cuivre, supérieure à celle de l'aluminium, du tungstène ou des autres matériaux conducteurs utilisés dans les circuits intégrés, est un avantage important qui motive son utilisation dans la réalisation des interconnexions métalliques. Le cuivre est également plus résistant au phénomène d'électro-migration. Ces deux critères revêtent une importance décisive aux yeux des fabricants de circuits ultra intégrés (« Ultra-Large-Scale-Integration (ULSI) Integrated Circuits (ICs) » en anglais). La conductivité du cuivre est approximativement deux fois celle de l'aluminium, et plus de trois fois celle du tungstène. Le recours au cuivre pour la fabrication des interconnexions métalliques est donc clairement avantageux pour des circuits présentant des finesses de gravure de plus en plus élevées. De plus, le cuivre est, en outre, environ dix fois moins sensible à l'électro-migration que l'aluminium, ce qui permet d'anticiper sa meilleure capacité à maintenir l'intégrité électrique des circuits. Malheureusement, les techniques actuellement disponibles pour fabriquer des interconnexions, en particulier de cuivre ne sont pas assez précises pour des interconnexions inférieures à 100nm, et/ou entraînent des coût très élevés.

Bien que le cuivre soit le plus utilisable avec les techniques actuelles, l'alternative d'interconnexions en cuivre doit faire face à deux problèmes majeurs : le cuivre est difficile à graver. On ne peut donc pas, de façon simple, réaliser les motifs de câblage par des procédés de ce type, pourtant traditionnels ; et le cuivre est un élément à haut pouvoir de diffusion dans de nombreux matériaux. Cette diffusion peut conduire à la mise en court-circuit de pistes voisines, et donc au dysfonctionnement global du circuit.

L'utilisation du procédé Damascène a permis de résoudre ces deux problèmes. Ce procédé repose sur une succession d'étapes qui sont les suivantes : dépôt d'une couche diélectrique isolante inter niveaux ; gravure des motifs (« patterns » en anglais) d'interconnexion, constitués de lignes et vias, dans la couche diélectrique, par gravure ionique réactive (« Reactive Ion Etching » en anglais) ; dépôt d'une couche barrière, servant à empêcher la migration du cuivre ; remplissage des lignes et vias par du cuivre ; et élimination du cuivre en excès par polissage mécano-chimique (« Chemical Mechanical Polishing (CMP) » en anglais).

Une description des procédés Damascène et dual-Damascène est proposée par exemple dans : Chang, C. Y. and Sze, S. M., « ULSI Technology » McGraw-Hill, New York, (1996), p. 444 - 445. Les propriétés des couches barrières et leurs procédés de dépôt sont décrits dans : Kaloyeros and Eisenbraun, in « Ultrathin diffusion barrier/liner for gigascale copper metallization », Ann. Rev. Mater. Sci (2000), 30, 363-85. Le procédé de remplissage des tranchées et puits par du cuivre métallique est décrit dans : Rosenberg et al., in « Copper metallization for high performance silicon technology », Ann. Rev. Mater. Sci (2000), 30, 229-62.

Le procédé de remplissage de cuivre utilisé dans le procédé Damascène doit, au niveau industriel, répondre à certaines spécifications qui sont les suivantes : la résistivité du cuivre doit être aussi proche que possible de la résistivité intrinsèque du cuivre ; le procédé de dépôt de cuivre doit permettre un remplissage complet des tranchées et des puits, sans création de vides, même - et surtout - pour des gravures présentant de forts facteurs de forme ; l'adhésion du cuivre sur la couche barrière doit être suffisamment importante pour éviter la délamination lors de l'étape de polissage mécano-chimique et permettre d'obtenir des interfaces fortes ne générant pas de zones de rupture sous contrainte électrique ou thermique; le coût du procédé doit être le plus bas possible. Il en est de même pour les autres métaux utilisables pour la fabrication d'interconnexions.

Pour cela, le dépôt de cuivre par électrodéposition (« Electroplating (EP) » en anglais) offre de bonnes performances en ce qui concerne la qualité du dépôt, en permettant un remplissage effectif depuis le fond des tranchées et des puits jusqu'à leur ouverture. Ce procédé est basé sur le dépôt galvanique de cuivre à partir d'un bain contenant notamment du sulfate de cuivre (CuSO₄) et des additifs. On connaît également les procédés de dépôt chimiques autocatalytiques (« Electroless » en anglais) : il s'agit de procédés en solution dans lesquels, comme pour l'électrodéposition, le dépôt de cuivre est obtenu par réduction d'ions cuivriques à partir d'une solution aqueuse les contenant. A la différence de l'électrodéposition, les électrons nécessaires à cette réduction sont fournis par un agent chimique réducteur présent dans la même solution et non par une source externe de courant, d'où leur dénomination de procédé « Electroless ». Les solutions les plus utilisées sont des solutions aqueuses basiques contenant un sel de cuivre complexé et du formaldéhyde (HCHO) comme réducteur, avec lequel les ions cuivriques sont réduits en cuivre métallique selon une réaction thermodynamiquement favorable (S. James, H. Cho et al., « Electroless Cu for VLSI », MRS Bulletin, 20 (1993) 31-38).

Ces deux procédés de dépôt de cuivre métallique sont, de plus, peu coûteux en regard des procédés de dépôts physique ou chimique à partir d'une phase vapeur (« Physical Vapour Deposition (PVD) » et « Chemical Vapour Deposition (CVD) » en anglais, respectivement), traditionnellement utilisés pour ce genre de dépôt dans l'industrie de la microélectronique. Ces méthodes utilisent des réacteurs de dépôt monosubstrats sous vide.

Cependant, électrodéposition étant une réaction électro-suivie (c'est-à-dire que l'épaisseur de cuivre déposée est proportionnelle à la charge passée dans le circuit lors de l'électrolyse), la topologie du dépôt métallique est sensible à la cartographie de chute ohmique du substrat. Or, cette cartographie est typiquement très inhomogène dans le cas d'une surface semi-conductrice étendue comme celle offerte par la couche barrière déposée sur l'ensemble de la plaquette de substrat servant à la fabrication du circuit intégré (« wafer »). Les matériaux utilisés pour la couche barrière (nitrure de titane, nitrure de tantale, carbure de tungstène...) étant en effet semi-conducteurs, leur conductivité est insuffisante pour permettre un dépôt de cuivre homogène.

Parallèlement, la réaction d'oxydation du formaldéhyde par les ions du cuivre dans le procédé autocatalytique est certes thermodynamiquement favorable, mais cinétiquement inopérante sans apport d'un catalyseur. Les catalyseurs les plus efficaces semblent être les catalyseurs hétérogènes, et notamment le cuivre. Il a en effet été observé que la vitesse du dépôt est considérablement augmentée dès qu'une première couche de cuivre métallique est disponible, le procédé étant ainsi autocatalytique (« electroless »).

Ces problèmes peuvent, dans un cas comme dans l'autre, être résolus en effectuant le dépôt d'une mince couche de cuivre métallique, appelée couche de germination (« seed layer » en anglais), qui est dans l'art antérieur uniquement métallique, à la suite de l'étape de dépôt de la couche barrière et avant l'étape d'électrodéposition. Dans le cas de l'électrodéposition, cette couche de cuivre permet de recouvrer une surface de conductivité améliorée et suffisamment homogène. Dans le cas du procédé autocatalytique « electroless »), elle offre un catalyseur efficace précisément à l'endroit où l'on souhaite réaliser le dépôt de cuivre épais permettant le remplissage des lignes et vias.

La couche barrière et une couche de germination uniquement métallique sont actuellement déposées selon différents procédés (PVD ou CVD), et dans le même bâti sous vide, ce qui permet d'éviter un retour à l'atmosphère entre ces deux étapes, et donc une oxydation de la couche barrière, source d'apparition d'une résistance électrique parasite au niveau des vias.

Ces étapes de procédé, dépôt de la couche barrière, dépôt de la couche de germination uniquement métallique et électrodéposition du cuivre, sont aujourd'hui courantes dans l'industrie de la microélectronique. Les trois étapes nécessitent l'emploi de deux équipements, l'un pour la PVD/CVD, et l'autre soit pour l'électrodéposition, soit pour l'étape autocatalytique (« electroless ») ce qui entraîne un coût important pour la mise en oeuvre de ces techniques.

Un premier procédé de l'art antérieur consiste à déposer une couche de germination uniquement métallique de cuivre par PVD sur la couche barrière sans retour à l'atmosphère après l'étape de dépôt de cette couche barrière, également par PVD. La PVD améliore l'adhésion du cuivre sur la couche barrière. Cependant, on observe que les dépôts de cuivre par PVD présentent des couvertures de marche faibles lorsque les facteurs de forme sont élevés (c'est à dire le nombre de creux et/ou gravures est élevé), ce qui est le cas dans la réalisation des lignes et vias d'interconnexion.

Selon un second procédé de l'art antérieur, la couche de germination, qui est uniquement métallique, est déposée par CVD. Les films de cuivre obtenus par les procédés de CVD conventionnels présentent une conformité à la topologie de la surface supérieure à ceux obtenus par PVD. Toutefois, pour la plupart des précurseurs, le dépôt de cuivre CVD présente une faible adhérence sur les matériaux de la couche barrière. De plus, le prix élevé des précurseurs de CVD rend ce procédé particulièrement coûteux.

Selon une variante de la CVD, la couche de germination uniquement métallique de cet art antérieur est déposée par ALD ou ALCVD ou ALE (« Atomic Layer Deposition » ou « Atomic Layer Chemical Vapour Deposition » ou « Atomic Layer Epitaxy », en anglais). Ce procédé, considéré actuellement comme très prometteur pour les circuits ultra-intégrés à très haute finesse de gravure, est basé sur le même principe que la CVD, mais à partir d'un mélange de précurseurs gazeux tel que les réactions de croissance du dépôt sont auto-limitantes (US4038430 (1977), Ritala, M., Leskelä, M., In : Nalwa, H. S., Ed., Handbook of Thin Film Materials, Academic Press, San Diego, 2001, Vol.1, Ch.2). L'ALD procède donc par une succession de cycles de dépôt et de purge, ce qui permet un contrôle des épaisseurs supérieur aux techniques précitées (les taux de croissance étant typiquement de l'ordre de 0,1 nm/cycle), et donc de corriger certains des défauts de la CVD traditionnelle : bon contrôle de l'épaisseur des couches ultra-fines, modification modérée du ratio d'aspect des gravures, faible dépendance par rapport aux paramètres d'alimentation (flux d'entrée). Cette technique présente cependant, dans une moindre mesure, certains des défauts de la CVD traditionnelle : adhérence faible et difficulté pour obtenir une couche de germination présentant les propriété requises.

Avec la réduction des tailles de gravure qui ne cesse d'évoluer, les défauts de la PVD et de la CVD sont de plus en plus exacerbés, et rendent ces procédés de plus en plus inadaptés à répondre au défi de la réalisation de couches de germination pour les générations de gravure postérieures aux générations actuelles.

L'électrodéposition et le procédé autocatalytique conduisant à un dépôt préférentiel de cuivre sur les zones déjà métallisées (soit du fait de leur faible résistivité, soit du fait de leurs propriétés catalytiques), il est nécessaire que l'ensemble de la gravure reçoive un dépôt servant de couche de germination, ce que la PVD semble de pas pouvoir offrir. L'apparition de discontinuités et la faible conformité à la topologie de la surface sont notamment problématiques au fond des puits, tranchées et autres structurations de surface de forts ratios d'aspect. Lorsqu'elle est appliquée sur une couche de germination uniquement métallique obtenue par PVD, le dépôt du cuivre par électrodéposition ou par procédé autocatalytique deviennent donc de plus en plus difficiles dans ces zones à mesure que la taille de chaque structuration se réduit. De plus, dans le cas du dépôt autocatalytique, les dégagements d'hydrogène associés à ces procédés conduisent à des microporosités et autres défauts préjudiciables à la structure du matériau en régime de production. De plus, les bains autocatalytiques, de part leur caractère métastable, posent des problèmes de stabilité dans le temps.

Dans les procédés conventionnels de CVD, un film de cuivre continu et de haute conformité ne peut être obtenu qu'au-delà d'une épaisseur critique. En effet, le film de cuivre présente l'inconvénient grave qu'il est discontinu lorsqu'il est trop fin. L'intégrité structurale de cette couche de germination uniquement métallique peut alors être affectée par la solution d'électrodéposition ou de dépôt autocatalytique. Or, l'épaisseur critique étant non négligeable devant la taille des structurations de la gravure (typiquement de l'ordre de 30 à 50 nm actuellement, à comparer des finesses de gravure destinées à être inférieures à 100 nm), le dépôt conforme obtenu par CVD peut conduire à une augmentation significative du facteur de forme, et donc exacerber les problèmes liés à un remplissage électrochimique des lignes et vias par le fond lors de l'étape d'électrodéposition ou de dépôt autocatalytique. De plus, ces procédés présentent en général des problèmes d'adhérence.

Parallèlement, l'ALD étant par nature un procédé séquentiel basé sur une succession de cycles, il est lent. De plus, les mélanges doivent être choisis de façon à ne comporter que des réactifs gazeux et des produits gazeux, sauf un, qui est celui que l'on souhaite déposer. La présence de plusieurs réactifs dans le mélange précurseur, ainsi que celle de produits non désirés sur la surface qui doivent être gazeux pour être évacués, conduit à un cumul des contraintes, notamment techniques. Les problèmes d'adhérence rencontrés en CVD se retrouvent avec ce procédé. De plus, si le contrôle d'épaisseur obtenu par ALD est de bonne qualité, on observe que, pour certains types de mélanges, le dépôt procède par nucléation, ce qui réintroduit l'existence d'une épaisseur seuil pour obtenir des dépôts homogènes comme cela est décrit dans M. Juppo, « Atomic Layer Deposition of Metal and Transition Metal Nitride Thin Films and In Situ Mass Spectrometry Studies », Academic Dissertation, University of Helsinki, Faculty of Science, Department of Chemistry, Laboratory of Inorganic Chemistry, Helsinki, Finland, december 14th 2001, ISBN 952-10-0221-2, p.39. Ces difficultés conduisent à raffiner les structures chimiques candidates, à la fois pour les précurseurs et pour les co-réactifs. Ainsi, l'ALD n'est pas encore opérationnelle et ne répond malheureusement pas à l'ensemble des contraintes actuelles. Cela reste également un procédé coûteux aussi bien du fait des précurseurs et co-réactifs que de la lenteur du procédé).

Des problèmes de l'art antérieur, on observe donc qu'il existe un réel besoin de disposer d'un procédé permettant d'améliorer l'adhérence de la couche de germination sur la couche barrière, sans sacrifier à l'obtention d'une couche conforme, comme c'est le cas avec la PVD. Il existe également un réel besoin de réaliser une couche de germination sur des gravures de fort ratio d'aspect à l'aide d'un procédé peu coûteux, et offrant des couches de germination présentant une bonne adhérence, contrairement à ce que la CVD peut offrir. Enfin, il existe un réel besoin de disposer d'un procédé permettant de réaliser des dépôts de cuivre, mais également d'autres métaux, par exemple tel que le platine, dans un équipement unique, sans oxydation de la couche barrière, et à des températures de mise en oeuvre compatibles avec l'intégrité des autres matériaux déjà présents sur le substrat.

### EXPOSÉ DE L'INVENTION

Le présente invention a précisément pour objet un procédé permettant de répondre à l'ensemble de ces besoins, qui satisfait aux spécifications précitées, et qui permet de résoudre en outre les nombreux problèmes précités de l'art antérieur notamment pour la fabrication d'interconnexions métalliques, notamment pour la fabrication de circuits intégrés et autres microsystèmes.

Le procédé de la présente invention est un procédé de revêtement d'une surface d'un substrat par un film de germination d'un matériau métallique, ladite surface étant une surface conductrice ou semi-conductrice de l'électricité et présentant des creux et/ou des saillies, ledit procédé comprenant les étapes suivantes :
- disposer sur ladite surface un film organique adhérant à ladite surface et ayant une épaisseur telle que la face libre de ce film suit de manière conforme les creux et/ou saillies de ladite surface conductrice ou semi-conductrice de l'électricité sur laquelle il est disposé,
- insérer au sein dudit film organique disposé sur ladite surface un précurseur du matériau métallique, en même temps que, ou après, l'étape consistant à disposer sur ladite surface ledit film organique,
- transformer ledit précurseur du matériau métallique inséré au sein dudit film organique en ledit matériau métallique de manière à ce que ce matériau métallique se forme conformément audits creux et/ou saillies de ladite surface à revêtir et au sein dudit film organique pour constituer avec ce dernier ledit film de germination.

Le film de germination obtenu grâce au procédé de la présente invention comprend donc le film organique et le matériau métallique entremêlés, avec ou sans interactions ou liaisons chimiques entre eux, suivant la nature chimique des matériaux utilisés.

Les inventeurs ont d'abords constaté que obtention d'un film organique présentant les caractéristiques requises - et notamment conforme à la surface dû substrat - est plus facilement réalisable qu'un film de matériau métallique, notamment parce que la chimie spontanée de surface et/ou bien les réactions chimiques initiées à partir de la surface pour l'obtention du film organique permet(tent) de respecter la topologie géométrique de la surface et de s'affranchir, partiellement ou totalement, de la cartographie de chute ohmique. Dans un deuxième temps ils ont constaté la propriété de nombreux matériaux organiques constituant de tels film de pouvoir abriter et/ou de supporter un ou plusieurs précurseur(s) de matériaux métalliques et de permettre la transformation de ces précurseurs en lesdits matériaux métalliques au sein même ou à la surface de ces films organiques. Ils ont ensuite utilisé de manière tout à fait astucieuse ces constatations, en combinant l'utilisation de ces films organiques et de ces précurseurs de matériaux métalliques pour former sur des surfaces des films de germination conformes aux creux et/ou saillies de celles-ci même à de très petites échelles, résolvant ainsi les nombreux problèmes précités de l'art antérieur.

Ainsi, selon l'invention, la difficulté d'obtention d'un film de germination par les techniques de l'art antérieur a été reportée et résolues sur la base de la capacité à réaliser un film organique adhérent, homogène, conforme à la surface du substrat qui soit capable de contenir un précurseur du matériau métallique, et dont l'épaisseur soit suffisamment faible pour ne pas modifier le ratio d'aspect de la surface, par exemple de gravures.

Les surfaces concernées par la présente invention sont aussi nombreuses que les différentes applications possibles de la présente invention. Il peut s'agir de surfaces conductrices ou semi-conductrices d'objets tridimensionnels, ou des surfaces totalement ou partiellement semi-conductrices. Par surface tridimensionnelle, on entend une surface dont les irrégularités topologiques sont dimensionnellement non négligeables par rapport à l'épaisseur du revêtement que l'on cherche à obtenir. Il s'agit par exemple de surfaces de substrats utilisés pour la fabrication de microsystèmes ou de circuits intégrés, par exemple des surfaces de substrats de silicium (« wafer ») et autres matériaux connus de l'homme du métier dans le domaine technique considéré. Selon l'invention, le substrat peut être par exemple une couche inter niveaux pour la fabrication d'un circuit intégré. La présente invention trouve aussi une application, par exemple, dans la réalisation d'une couche conductrice sur un système micro-électromécanique (MEMS : "Micro-Electromechanical System") pour établir un contact électrique quand deux pièces mobiles du système se rejoignent.

Par « creux et/ou saillies » on entend toute variation de la topologie de la surface volontaire ou non. Il peut s'agir par exemple d'une rugosité de surface liée au substrat ou à son procédé de fabrication, d'accidents de surface, tels que des rayures, ou de gravures réalisées volontairement sur ledit substrat par exemple pour la fabrication de microsystèmes, de circuits intégrés, d'interconnexions. La surface présentant des creux et/ou des saillies peut être par exemple une surface de micropuce.

De façon générale, dans l'étape du procédé de l'invention consistant à disposer un film organique sur la surface conductrice ou semi-conductrice de l'électricité, on pourra utiliser tout procédé connu de l'homme du métier permettant d'obtenir un film organique adhérant sur la surface du substrat, conforme à ladite surface et ayant une épaisseur telle qu'elle est définie dans la présente. L'adhérence souhaitée est celle qui permet autant que possible d'éviter que le film disposé sur la surface ne se décolle au cours des étapes ultérieures du procédé de l'invention. Le choix de la technique dépend donc du choix des matériaux utilisés, notamment de la nature chimique du substrat, de la nature chimique de la surface du substrat, de la nature chimique de la couche barrière lorsqu'elle est présente, du polymère choisi pour former le film organique, de la topologie de la surface à revêtir et de la destination de l'objet fabriqué, par exemple circuit intégré ou autre. Ce choix dépend aussi des techniques choisies dans les étapes ultérieures du procédé de l'invention. De nombreuses techniques utilisables dans la présente invention, ainsi que leur caractéristiques, sont décrites dans l'exposé détaillé ci-dessous.

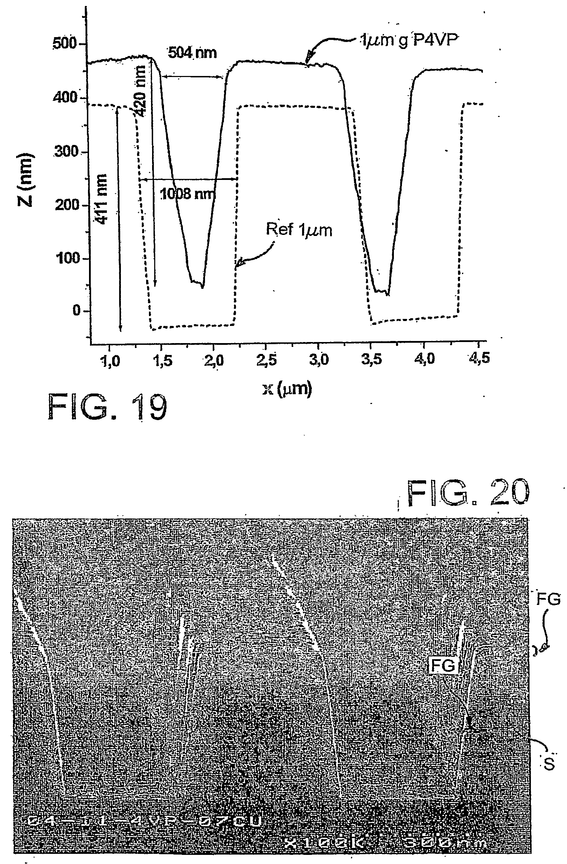

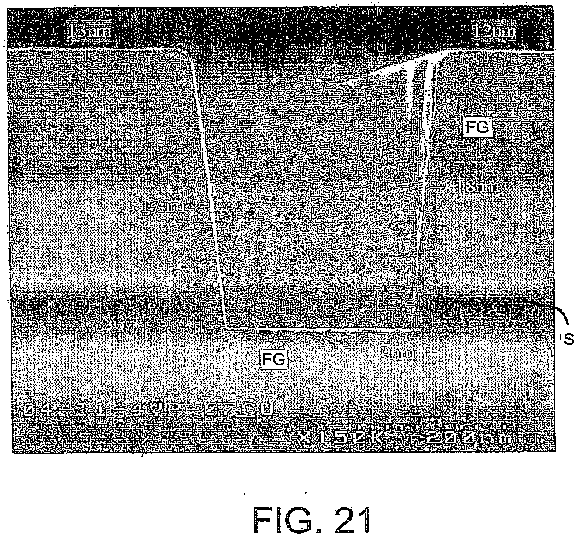

Par « conforme », on entend qui suit intimement, c'est-à-dire conformément, toutes les aspérités de la surface, c'est à dire toute la surface des creux et/ou saillies sans les combler ou les aplanir. Que les gravures et/ou des saillies soient présentes sur la surface de manière volontaire, c'est à dire par gravure, ou non, le procédé de la présente invention permet de déposer de manière homogène et conforme un film métallique à partir du film de germination sur toute la surface même à l'intérieur des gravures et/ou le long des saillies comme cela est visible sur les micrographies des figures 20 et 21, et même à de très petites échelles allant jusqu'au nm. Le procédé de la présente invention vient donc résoudre les nombreux problèmes précités de l'art antérieur où, à ces échelles, les procédés conduisent à des revêtements qui passent au-dessus des gravures, sans toucher le fond, comblent les creux et/ou saillies ou ne fonctionnent pas du tout et ne permettent donc pas un tel revêtement, ou alors seulement au prix de techniques extrêmement complexes et onéreuses ou alors à des échelles très supérieures à 100 nm. Le procédé de l'invention donne en outre accès à des dimensions d'interconnexions métalliques jamais atteintes.

La technique permettant de disposer le film organique sur la surface en répondant aux spécifications précitées peut être choisie par exemple parmi les techniques de polymérisation électro-suivie, d'électro-greffage, électro-initiée, de centrifugation, de trempage ou de pulvérisation. De manière préférée, lorsque l'épaisseur du film à déposer est très faible, par exemple de l'ordre de 1 à 500nm, et/ou lorsque le dépôt de ce film est sensible à la cartographie de chute ohmique du substrat, la technique utilisée sera de préférence une technique de polymérisation électro-initiée. En effet, cette technique permet de surmonter les problèmes chute ohmique et d'obtenir un film homogène même à ces très petites échelles. Ces techniques et leurs caractéristiques sont décrites dans l'exposé détaillé ci-dessous.

Grâce aux procédés précités, l'épaisseur de ce film peut aisément se situer, sans être limitée à ces dimensions, dans une fourchette allant de 0,001 à 500µm, par exemple de 0,001 à 100µm, par exemple de 0,001 à 10µm.

Selon l'invention, le film organique peut être une macromolécule organique ou un polymère. De nombreux exemples de macromolécules ou polymères qui peuvent être utilisés sont également décrits ci-dessus dans l'exposé détaillé de la présente invention. Par exemple, le film organique peut être obtenu à partir d'un précurseur chimique permettant d'obtenir ce film, ledit précurseur étant choisi dans le groupe constitué des monomères vinyliques, d'ester de l'acide méthacrylique ou acrylique, des sels de diazonium fonctionnalisés ou non, des sels de sulfonium fonctionnalisés ou non, des sels de phosphonium fonctionnalisés ou non, des sels d'iodonium fonctionnalisés ou non, des précurseurs de polyamides obtenus par polycondensation, des monomères cycliques clivables par attaque nucléophile ou électrophile et de leurs mélanges.

Par exemple, le film organique peut être obtenu à partir d'un ou de plusieurs monomère(s) vinylique(s) activé(s), de structure (I) suivante : 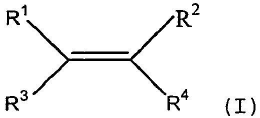 dans laquelle R¹, R², R³, R⁴, sont des groupements organiques choisis indépendamment les uns des autres dans le groupe constitué des fonctions organiques suivantes : hydrogène, hydroxyle, amine, thiol, acide carboxylique, ester, amide, imide, imido-ester, halogénure d'acide, anhydride d'acide, nitrile, succinimide, phtalimide, isocyanate, époxyde, siloxane, benzoquinone, benzophénone, carbonyle-diimidazole, para-toluène sulfonyle, para-nitrophényl chloroformiate, éthylénique, vinylique, et aromatique.

Selon l'invention, le film organique peut être par exemple un polymère obtenu par polymérisation d'un monomère vinylique choisi dans le groupe constitué des monomères vinyliques comme l'acrylonitrile, le méthacrylonitrile, le méthacrylate de méthyle, le méthacrylate d'éthyle, le méthacrylate de butyle, le méthacrylate de propyle, le méthacrylate d'hydroxyéthyle, le méthacrylate d'hydroxypropyle, le méthacrylate de glycidyle, les acrylamides et notamment les méthacrylamides d'amino- éthyle, propyle, butyle, pentyle et hexyle, les cyanoacrylates, le polyéthylène glycol di-méthacrylate, l'acide acrylique, l'acide méthacrylique, le styrène, le parachloro-styrène, la N-vinyl pyrrolidone, la 4-vinyl pyridine, les halogénures de vinyle, le chlorure d'acryloyle, le chlorure de méthacryloyle, et de leur dérivés.

Selon l'invention, le film organique peut comprendre avantageusement des groupes fonctionnels ligands pour des ions métalliques précurseurs du matériau métallique. Par exemple, dans le ou les monomère(s) vinylique(s) activé(s), de structure (I) précitée, au moins un de R¹, R², R³, R⁴ peut être un groupement fonctionnel pouvant piéger le précurseur du matériau métallique.

Lorsque le film organique est disposé sur la surface du substrat, l'étape suivante du procédé de l'invention consiste à accrocher à la surface du film et/ou à insérer au sein de ce film un précurseur du matériau métallique.

Selon l'invention, par « précurseur du matériau métallique, on entend un ou un mélange d'un ou de plusieurs des précurseurs précités. L'homme du métier pourra aisément sélectionner le précurseur nécessaire en fonction du film de germination qu'il désire fabriquer par la mise en oeuvre du procédé de l'invention. En outre, ce précurseur du matériau métallique peut avantageusement être choisi tel qu'il peut être transformé en ledit matériau métallique par une technique choisie parmi une précipitation, une cristallisation, une réticulation, une agrégation ou une électrodéposition. En effet, ces techniques sont particulièrement pratiques et efficaces pour la mise en oeuvre du procédé de l'invention.

Par exemple, selon l'invention, le précurseur du matériau métallique peut être un ion du matériau métallique. Il peut par exemple être choisi dans le groupe constitué par les ions du cuivre, les ions du zinc, les ions de l'or, les ions de l'étain, du titane, du vanadium, du chrome, du fer, du cobalt, du lithium, du sodium, de l'aluminium, du magnésium, du potassium, du rubidium, du césium, du strontium, de l'yttrium, du niobium, du molybdène, du ruthénium, du rhodium, du palladium, de l'argent, du cadmium, de l'indium, du lutécium, de l'hafnium, du tantale, du tungstène, du rhénium, de l'osmium, de l'iridium, du platine, du mercure, du thallium, du plomb, du bismuth, des lanthanides et des actinides. Il peut également être intéressant, dans certains cas, d'avoir recours à des mélanges d'ions pouvant par exemple être choisis ans la liste précédente.

Selon l'invention, par exemple pour la fabrication d'interconnexions pour des microsystèmes, par exemple des circuits intégrés, le matériau métallique peut être avantageusement du cuivre, du palladium ou du platine et le précurseur respectivement des ions du cuivre, du palladium ou du platine.

Selon l'invention, le précurseur peut être sous la forme de particules ou d'agrégats métalliques éventuellement enrobés dans une gangue de protection choisie dans le groupe constitué des micelles, des nanosphères de polymères, des fullerènes, des nanotubes de carbone, et des cyclodextrines, et dans lequel l'étape de transformation du précurseur en ledit matériau métallique est réalisée par libération des particules ou des agrégats métalliques de leur gangue.

L'accrochage du précurseur du matériau métallique sur, ou l'insertion dans, le film organique peut être réalisée au moyen de toute technique appropriée compte tenu de la nature chimique du film et du précurseur du matériau métallique. Les techniques utilisables entrant dans le cadre de la présente invention pour cette étape sont donc nombreuses, elles vont d'une simple mise en contact du précurseur du matériau métallique avec le film organique disposé sur la surface, par exemple par trempage du film organique déposé sur la surface du substrat dans une solution appropriée dudit précurseur (« dip coating » en anglais), par exemple du type de celles utilisées dans l'art antérieur pour l'électrodéposition, à des techniques plus élaborées telles que l'utilisation d'un bain électrolytique ou la centrifugation (« spin coating » en anglais), sur ladite surface.

L'un ou l'autre moyen de réalisation précité permet ainsi d'obtenir un film ultramince de précurseur du matériau métallique, adhérent, homogène - et notamment conforme. En effet, contrairement à tous les procédés de l'art antérieur, le procédé selon l'invention permet de forcer la localisation du précurseur du matériau métallique au voisinage de la surface de la couche barrière, au sein du film organique conforme aux creux et/ou saillies. De plus, grâce au procédé de l'invention, l'épaisseur de la couche de précurseur de matériau métallique au-dessus de la surface du substrat, et le cas échéant de la couche barrière, peut être ajustée en ajustant l'épaisseur du film organique disposé sur ladite surface et servant de support ou de matrice pour le piégeage du précurseur du matériau métallique, et/ou en ajustant la pénétration du précurseur métallique dans ledit film organique.

Si le film organique ne permet pas une insertion aisée du précurseur du matériau métallique en son sein, ou si cette insertion doit être favorisée, ou même forcée, selon l'invention, on peut avantageusement utiliser une solution d'insertion qui est à la fois un solvant ou transporteur du précurseur du matériau métallique, et un solvant et/ou une solution qui gonfle le film organique, ladite solution d'insertion comprenant le précurseur du matériau métallique. Par solution qui « gonfle » le film organique, on entend une solution qui s'insère au sein de ce film et qui en déploie la structure pour permettre l'insertion en son sein du précurseur du matériau métallique. Par exemple, il peut s'agir d'une solution aqueuse, par exemple qui hydrate le film organique. Ainsi, certains polymères vinyliques sont gonflés par l'eau, notamment la poly 4-vinyl pyridine, P4VP qui n'est pas soluble dans l'eau ou encore le poly hydroxyéthyle méthacrylate, PHEMA, soluble dans l'eau) et donc également gonflé par ce solvant. Une solution aqueuse est par exemple utilisable avec un film organique constitué d'un polymère vinylique et un précurseur du matériau métallique tel que du cuivre.

Cette solution d'insertion est également une solution qui permet de véhiculer le précurseur du matériau métallique au sein du film organique. Il s'agira donc d'une solution qui permet une solubilisation ou une dispersion suffisante du précurseur pour la mise en oeuvre de la présente invention. En effet, dans le cas des sels insolubles du précurseur du matériau métallique, cette solution devra de préférence pouvoir disperser suffisamment le précurseur du matériau métallique pour pouvoir permettre d'insérer ce précurseur dans le film organique. La solution d'insertion sera donc choisie en fonction de nombreux critères. Parmi ceux-ci, on peut citer : en fonction de la surface : par exemple pour éviter des interactions chimiques telle que l'oxydation de la surface au cours de la mise en oeuvre du procédé ; en fonction du film organique : de façon à ce que cette solution ne retire pas film de la surface sur laquelle il a été déposé ; en fonction du précurseur du matériau métallique : elle doit permettre sa solubilisation, mais aussi sa transformation en matériau métallique; en fonction du matériau métallique: elle doit permettre sa formation au sein du film organique, et notamment la réalisation de son procédé de dépôt, par exemple l'électro-dépôt du matériau métallique ou son dépôt autocatalytique.

Par exemple, l'art antérieur étant abondant d'une part sur l'obtention de films métalliques par électrodéposition à partir de solutions aqueuses, et d'autre part sur leur propriétés de solubilité dans l'eau, la solution d'insertion appropriée préférée selon l'invention est une solution aqueuse de ce type, notamment lorsque le film organique est un polymère qui peut être gonflé par l'eau, par exemple sous forme d'un film d'armature électro-greffé. D'autres solutions d'insertion et procédés d'insertion du précurseur du matériau métallique au sein du film organique sont décrits ci-dessous. L'homme du métier saura choisir encore d'autres solvants adéquats.

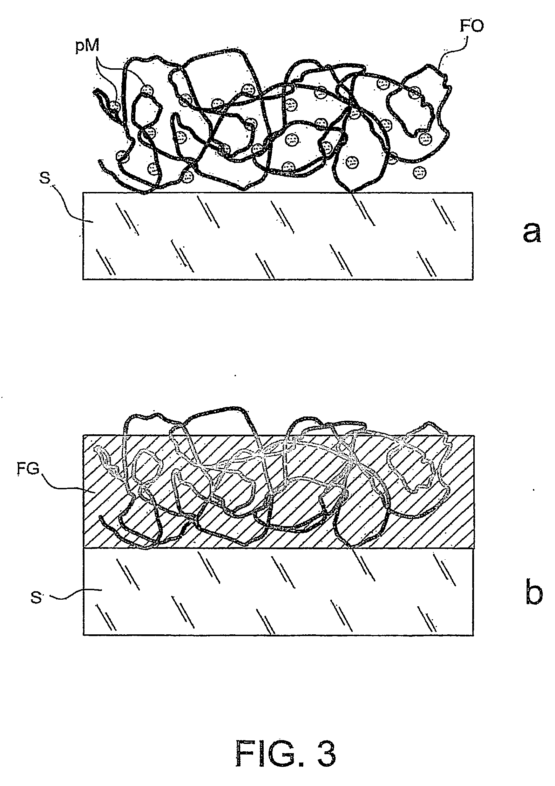

Selon un premier mode de particulier de réalisation de la présente invention, l'étape consistant à insérer le précurseur du matériau métallique au sein du film organique disposé sur ladite surface peut être réalisée en même temps que l'étape consistant à disposer sur ladite surface le film organique au moyen d'une solution d'insertion comprenant à la fois ledit film organique ou un précurseur dudit film organique, et le précurseur du matériau métallique. Ce mode de réalisation est schématisé sur la figure 3 annexée. Ce mode de réalisation est particulièrement avantageux par exemple lorsqu'il est difficile de trouver une solution d'insertion efficace pour insérer le précurseur du matériau métallique dans le film organique disposé sur le substrat. Ainsi, lors de la première étape consistant à disposer le film organique (FO) sur le substrat, le précurseur du matériau métallique (pM) est pris au sein du film organique (FO) et, lorsque le film est disposé sur la surface (S), il est possible d'appliquer l'étape du procédé de l'invention consistant à transformer le précurseur du matériau métallique en ledit matériau métallique au sein dudit film organique pour former le film de germination (FG).

L'étape d'insertion du précurseur du matériau métallique dans le film organique peut être suivie d'un rinçage approprié pour retirer l'excès de précurseur et améliorer ainsi son confinement dans le film organique. Ainsi, dans certains cas, on pourra améliorer l'homogénéité du film de germination obtenu après transformation du précurseur.

Une fois accroché sur, et/ou inséré dans, le film organique, le précurseur du matériau métallique peut ensuite être transformé en ledit matériau métallique, par exemple par réduction, sur ou au sein du film organique. Ainsi, lorsque le précurseur est un ion d'un métal, il est réduit en ledit métal. Par exemple par un procédé de type galvanique, tel que l'électrodéposition (« electroplating » ou « Electro Chemical Deposition » (ECD)), ou par un dépôt autocatalytique (« electroless »). Dans le cas de particules ou d'agrégats métalliques enrobés la réduction peut porter sur les molécules d'enrobage. On peut en effet facilement synthétiser des agrégats métalliques (Au, Cu, Ni, Fe, etc.) de quelques nanomètres à quelques dizaines de nanomètres par exemple par réduction d'une solution de précurseurs ioniques de ces métaux dans un milieu biphasique ou contenant des micelles inverses, tel qu'indiqué par exemple dans M. Brust, M. Walker, D. Bethell, D.J. Schiffrin and R. Whyman, « Synthesis of thiolderivatised gold nanoparticles in a two-phase liquid-liquid system », Journal of the Electrochemical society, Chemical Communications, 801 (1994) . De tels agrégats sont très utilisés comme marqueurs dans le domaine de la biochimie ou de la biologie moléculaire, car ils s'avèrent être fluorescents. On en trouve donc facilement dans le commerce, en dispersions aqueuses ou encore couplés avec des protéines, polysaccharides, oligonucléotides, etc. De même, on sait emprisonner des agrégats métalliques de taille nanométrique dans des objets nanométriques comme des fullerènes ou des nanotubes de carbone. On obtient des agrégats de métaux (c'est à dire à l'état d'oxydation zéro) enrobés dans une gangue organique, par exemple de tensio-actifs et/ou de thiols, qui les stabilisent. Par électroréduction, on peut décrocher la gangue des agrégats, ce qui entraîne leur coalescence pour aboutir à des grains métalliques voire à la précipitation d'un métal sur la surface. Dans certains cas, le même résultat nécessite une réaction d'oxydation, selon la nature chimique du matériau constituant la gangue des agrégats et en particulier la nature de leurs liaisons avec ces agrégats.

Quels que soient les précurseurs, on peut donc obtenir la réduction de ceux qui ont été préalablement confinés dans le film organique : soit au moment de la fabrication de ce film organique sur la surface ; soit a posteriori en insérant et/ou en déposant ces précurseurs - par exemple par trempage du film accrochage et/ou simple diffusion des précurseurs en son sein, ou encore sous l'effet de stimulis divers, tels que par électro-attraction de manière à forcer ou favoriser l'accrochage et/ou l'insertion du précurseur dans le film, etc.

Si l'objectif de la mise en oeuvre du procédé de l'invention est simplement de réaliser une couche de germination, une seule étape d'insertion de précurseur du matériau métallique dans le film et de transformation de ce précurseur peut suffire. Un remplissage des creux peut ensuite être réalisé si tel est l'objectif de la mise en oeuvre du procédé de l'invention, à partir de la couche de germination ainsi créée, selon les procédés de l'art antérieur, de préférence par électrodéposition ou par dépôt autocatalytique.

Selon un deuxième mode particulier de réalisation de la présente invention, l'étape d'accrochage ou d'insertion du précurseur du matériau métallique dans le film organique peut être réalisée au moyen d'une première solution contenant le précurseur du matériau métallique, et l'étape de transformation du précurseur métallique en ledit matériau métallique au sein du film organique est réalisée au moyen d'une deuxième solution ne contenant pas ledit précurseur du matériau métallique. Ainsi, on réalise un film organique sur la surface à revêtir, puis cette surface est trempée dans deux bains différents : Un trempage dans un premier bain contenant les précurseurs du matériau métallique permet de remplir et/ou de couvrir le film avec des précurseurs (insertion et/ou accrochage). La surface est ensuite sortie du premier bain « de remplissage » (et/ou d'accrochage »), éventuellement rincée, puis plongée dans une deuxième solution contenant divers agents chimiques à l'exception des précurseurs du matériau métallique du bain précédent. Ces agents chimiques peuvent être des agents d'oxydoréduction, par exemple pour un procédé de réduction du précurseur du matériau métallique de type autocatalytique, ou des électrolytes pour assurer la conduction électrique dans un procédé de réduction de type électrodéposition. Lorsque la réduction a lieu dans ce second bain, les ions contenus sur et/ou dans le film constituent le seul « réservoir » de précurseurs mis à la disposition de la réaction pour conduire à la formation du film métallique, puisqu'ils sont absents dans le bain. Pour peu que le film organique soit homogène - et notamment conforme - on parvient ainsi à confiner la réaction d'électrodéposition dans un espace homogène - et notamment conforme à la surface.

En procédant de cette façon, on évite le réapprovisionnement en précurseurs de métallisation depuis la solution, notamment dans les zones plus conductrices si elles existent, et on s'affranchit des travers de l'électrodéposition ou du procédé autocatalytique pour cette étape de réalisation de la couche de germination : on promeut la construction du film métallique (par réduction) à l'endroit où les précurseurs avaient été piégés grâce au film organique et uniquement à cet endroit, c'est-à-dire sur ou dans une pellicule ultramince homogène et conforme à la structuration de la surface de la couche barrière.

Lorsque l'on a couvert et/ou rempli le film avec les précurseurs du matériau métallique à la sortie du premier bain, les gradients de concentration entre le film (rempli) et la solution du second bain (vide) sont favorables à un relargage des précurseurs dans le bain de rinçage éventuel et surtout dans le second bain de trempage. On pourra certes s'affranchir de ce relargage en piégeant résolument les précurseurs sur et/ou dans le film organique (via une complexation lorsque l'on insère des ions, ou bien via un couplage chimique et/ou une réticulation dans le cas des agrégats). Cependant, on observe d'ordinaire que l'utilisation, dans le second bain, d'un liquide qui ne soit pas un solvant voire même ni un bon gonflant du film organique, peut suffire à s'affranchir du relargage. Plus généralement, toute amélioration opératoire qui permettra de rendre la cinétique de relargage lente devant celle de la déposition du métal dans le film à partir des précurseurs, sera acceptable et conforme à l'esprit de la présente invention.

Si l'objectif de la mise en oeuvre du procédé de l'invention est d'effectuer un remplissage très progressif, homogène et conforme, on peut multiplier les passages successifs dans les deux bains ci-dessus, de façon - certes - à ré approvisionner le film en précurseurs, mais de toujours pouvoir veiller à ce que ce réapprovisionnement se limite spatialement à l'épaisseur du film, dont les « racines » sont de plus en plus enfouies à mesure que les passages en solution ou bain d'insertion du précurseur du matériau métallique puis en bain de déposition se succèdent. Ainsi, selon l'invention, les étapes d'insertion du précurseur du matériau métallique dans le film organique et de transformation dudit précurseur en ledit matériau métallique peuvent être répétées plusieurs fois alternativement.

Selon l'invention, le substrat peut comporter à sa surface conductrice et/ou semi-conductrice de l'électricité présentant des creux et/ou des saillies une couche barrière empêchant une migration du matériau métallique dans ledit substrat, ladite couche barrière ayant une épaisseur telle que la face libre de cette couche suit de manière conforme les creux et/ou saillies dudit substrat sur laquelle elle est déposée. La fonction de cette couche barrière est exposée ci-dessus dans la partie art antérieur, elle permet d'éviter la migration du matériau métallique dans le substrat. Ceci est donc valable pour certains substrats, avec certains matériaux métalliques. Il s'agit par exemple d'un substrat de silicium et d'un matériau métallique à base de cuivre.

Selon l'invention, avant l'étape consistant à disposer sur ladite surface du substrat le film organique, le procédé de l'invention peut comprendre en outre une étape consistant à déposer ladite couche barrière. Ce dépôt peut être effectué par une des techniques connues de l'homme du métier, par exemple par la technique décrite dans le document Kaloyeros and Eisenbraun, in « Ultrathin diffusion barrier/liner for gigascale copper metallization », Ann. Rev. Mater. Sci (2000), 30, 363-85.

Selon l'invention, les matériaux servant à réaliser les couches barrière, par exemple dans le domaine de l'interconnexion cuivre, par exemple en microélectronique, sont généralement semi-conducteurs. Il peut s'agir des matériaux utilisés dans l'art antérieur. Par exemple, la couche barrière peut être une couche d'un matériau choisi dans le groupe constitué de titane ; de tantale ; des nitrures de titane, de tantale et de tungstène ; de carbure de titane et de tungstène ; de carbonitrure de tantale, tungstène et chrome ; de nitrure de titane ou tantale dopé au silicium ; et d'alliages ternaires comportant du cobalt ou du nickel allié à un réfractaire tel que du molybdène, du rhénium ou du tungstène, et à un dopant tel que du phosphore ou du bore. Par exemple, la couche barrière peut être une couche de TiN ou de TiN(Si), et le matériau métallique du cuivre.

Selon l'invention, la couche barrière peut être déposée sur le substrat par une des techniques précitées de l'art antérieur, par exemple par une technique choisie dans le groupe constitué des techniques de dépôt chimique ou physique en phase vapeur. Une de cette technique est par exemple décrite dans le document précité.

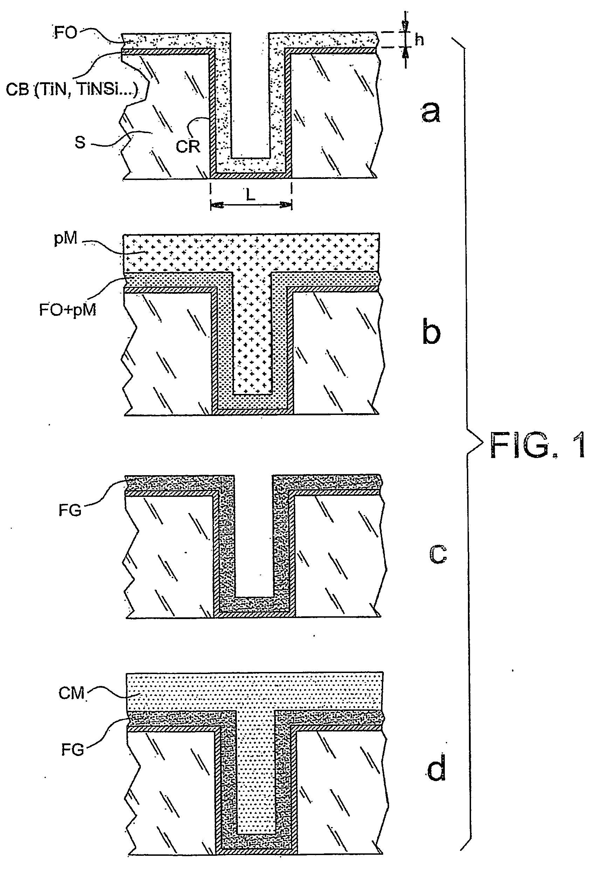

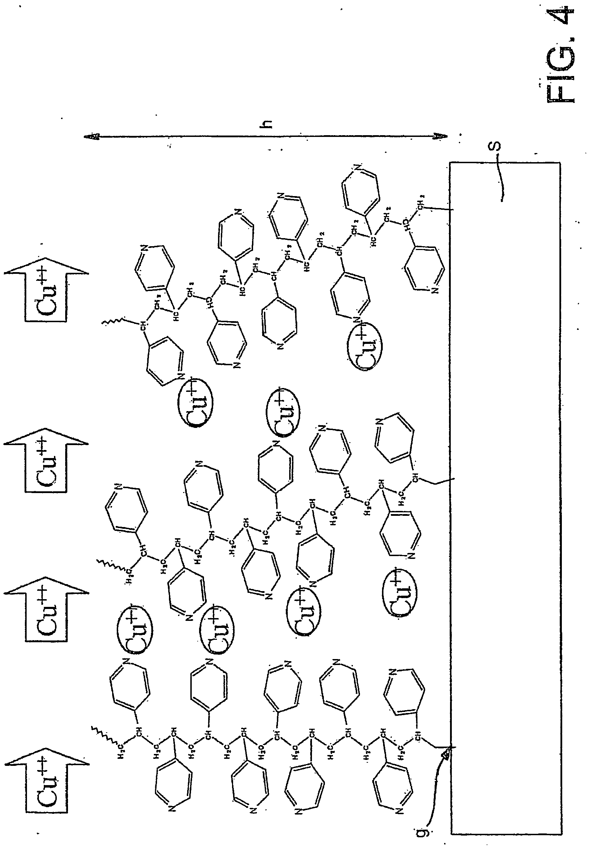

Pour l'application précitée à l'interconnexion métallique en microélectronique, par exemple l'interconnexion cuivre, la problématique de la couche de germination apparaît le plus fortement dans les techniques de l'art antérieur sur les générations de gravure de 0,1 →m et en deçà. Le procédé de la présente invention permet aisément d'obtenir des films de germination ayant une épaisseur « h » dans la gamme de 1 et 100 nm, et même de 1 et 50 nm, en fonction de la taille du creux et/ou de la saillie à revêtir (figure 1(a) et 4). De façon plus générale, les épaisseurs requises pour la fabrication de microsystèmes peuvent être de 1 nm à 100 →m par exemple, et plus particulièrement de 500 nm à 5 →m : ces épaisseurs peuvent être obtenues aisément grâce au procédé de la présente invention. De la même manière, les épaisseurs requises pour la connectique qui peuvent être plus volontiers entre 1 et 500 →m, et plus particulièrement entre 1 et 10 →m : elles peuvent également être obtenues aisément grâce au procédé de la présente invention.

Aussi, la présente invention se rapporte également à un procédé de fabrication d'interconnexions en microélectronique, utilisant le procédé précité, lesdites interconnexions étant constituées d'un matériau métallique. Le procédé de fabrication d'interconnexions de l'invention peut comprendre, dans cet ordre, les étapes consistant à :
a) graver dans un substrat diélectrique des motifs d'interconnexions, lesdits motifs formant des creux, et éventuellement des saillies, sur et/ou à travers ledit substrat,
b) déposer sur ledit substrat diélectrique gravé une couche barrière conductrice empêchant la migration du matériau métallique d'interconnexions dans ledit substrat, ladite couche barrière ayant une épaisseur telle que la face libre de cette couche suit de manière conforme les motifs d'interconnexions dudit substrat sur laquelle elle est déposée,
c) revêtir la couche barrière conductrice déposée sur le substrat gravé par un film de germination d'un matériau métallique au moyen du procédé de revêtement précité de l'invention, et
d) remplir les creux par ledit matériau métallique à partir dudit film de germination pour former lesdites interconnexions métallique constituées dudit matériau métallique.

Le substrat, les étapes b) et c) et les matériaux utilisables dans ce procédé ont été exposés ci-dessus.

L'étape de gravure peut être réalisée par les techniques habituelles de gravure et de micro ou nano gravure de substrat, et même, du fait de l'accès du procédé de l'invention à des échelle allant jusqu'au nm, par les techniques connues de l'homme du métier pour obtenir de telles gravures. Par exemple les techniques de gravure ionique réactive (« Reactive Ion Etching ») peuvent être utilisées pour mettre en oeuvre le procédé de l'invention.

Selon l'invention, l'étape de remplissage des creux dans le procédé de fabrication interconnexion peut être réalisée par toute technique connue de l'homme du métier pour remplir une gravure par un métal dans la fabrication des microsystèmes et circuits intégrés, par exemple par les techniques de dépôt électrolytique de matériaux métalliques ou de dépôt chimique autocatalytique à partir de la couche de germination. De préférence, afin de résoudre les problèmes précités de chute ohmique, et grâce au procédé de l'invention, l'étape de remplissage peut être réalisée au moyen d'une technique de dépôt autocatalytique à partir d'une solution de précurseur du matériau métallique. Des techniques utilisables pour ce dépôt sont décrites dans le document Chang, C. Y. and Sze, S. M., « ULSI Technology » McGraw-Hill, New York, (1996), p. 444 - 445.

Selon l'invention, le procédé peut comprendre en outre, après l'étape de remplissage des creux par le matériau métallique, une étape de polissage du matériau métallique qui se trouve en excès sur ladite surface. Cette étape peut être réalisée au moyen des procédés classiques utilisés pour la fabrication des microsystèmes, par exemple par polissage mécano-chimique (« Chemical Mechanical Polishing » (CMP)). Une de ces techniques est décrite dans le procédé précité.

La présente invention se rapporte également à un procédé de galvanisation d'une surface, ladite surface étant une surface conductrice ou semi-conductrice de l'électricité et présentant des creux et/ou des saillies, ledit procédé pouvant comprendre les étapes suivantes :
- revêtement de ladite surface par un film de germination d'un matériau métallique suivant le procédé de revêtement d'une surface par un film de germination selon la présente invention, et
- dépôt galvanique d'une couche métallique dudit matériau métallique à partir dudit film de germination obtenu.

L'étape de dépôt galvanique précitée peut être réalisée de la même manière que l'étape de remplissage précitée. Les autres matériaux et techniques de ce procédé sont ceux décrits ci-dessus. Le revêtement galvanique obtenu présente les caractéristiques d'être conforme à la surface sur laquelle il est déposé, même à l'échelle nanométrique, sur des surfaces comprenant des creux et/ou des saillies.

### EXPOSÉ DÉTAILLÉ DE L'INVENTION ET DE MODES PARTICULIERS DE RÉALISATION DE L'INVENTION

Le procédé de la présente invention repose sur la réalisation d'un film organique adhérant à la surface d'un substrat conducteur ou semi-conducteur par exemple grâce à des réactions chimiques ou électrochimiques, de manière à y abriter et/ou à y supporter et à y permettre la croissance d'un dépôt métallique à partir d'un précurseur, pour obtenir un film de germination conforme à ladite surface et résoudre les inconvénients précités de l'Art antérieur. Plus précisément, le procédé de l'invention permet de construire sur la surface d'un substrat conducteur ou semi-conducteur, un film organique adhérent, de préférence homogène, et conforme comme représenté sur la figure 1a annexée. La notion de conformité est essentiellement reliée à la taille caractéristique des accidents topologiques de la surface ou des gravures volontaires de ladite surface. Dans le cas général, on pourra considérer que le film est conforme à la surface s'il préserve, en tout point de la surface et à une tolérance près, le rayon de courbure local présent avant que le film ne soit déposé.

Dans le cas de la micro-électronique, le procédé de l'invention permet de réaliser une couche de germination métallique grâce à une succession d'étapes chimiques ou électrochimiques, directement sur la surface du substrat lorsque cela est possible, ou sur la couche barrière lorsqu'elle est nécessaire. Dans le cas d'un dépôt galvanique sur une pièce macroscopique, le procédé de l'invention permet de réaliser une couche dont l'épaisseur est du même ordre de grandeur que le plus petit rayon de courbure de l'une quelconque des parties de la surface de la pièce considérée, y compris dans les creux et/ou saillies de ladite surface. Cette couche métallique conforme à la surface est obtenue grâce au film de germination obtenu par le procédé de la présente invention.

La figure 1 est une représentation schématique du procédé de l'invention, les schémas a) à c) montrant la fabrication d'un film de germination (FG), et le schéma d) montrant le remplissage d'un creux avec un matériau métallique (CM) à partir d'un film de germination (FG).

Le schéma a) montre le dépôt d'un film organique (FO) sur la surface d'un substrat (S) présentant un creux (CR). Une couche barrière (CB) est également représentée sur ce schéma, bien que sa présence ne soit pas toujours nécessaire.

Dans le cas d'une application du procédé de l'invention dans la microélectronique, par exemple, l'épaisseur devrait être suffisamment faible pour ne pas augmenter les ratios d'aspect (figure 1a) et handicaper les étapes suivantes de formation du film de germination, et le cas échéant de remplissage du creux (figures 1b, 1c et, le cas échéant, figure 1d). Le procédé de l'invention utilise donc de préférence des procédés de dépôt d'un film organique permettant d'obtenir des épaisseurs sensiblement inférieures à d, où d est la largeur de la gravure, et plus particulièrement inférieures à d/2. Pour une gravure à 0,1 →m, l'épaisseur de la couche sera comprise par exemple entre 1 et 100 nm, et plus particulièrement entre 1 et 50 nm. Il est suffisamment homogène, c'est-à-dire que l'épaisseur - faible - donnée en consigne devrait être assurée, à une valeur de tolérance près jugée acceptable, sur l'ensemble de la surface revêtue du substrat. Il est de préférence conforme à la structuration topologique de la surface du substrat, cette préférence étant en fait une conséquence des deux précédentes.

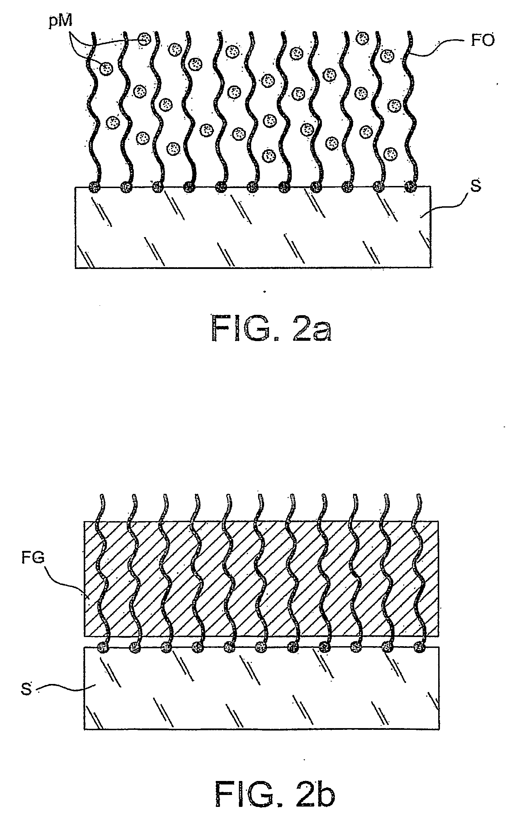

La force requise d'adhérence ou fixation du film organique sur la surface est essentiellement guidée par les étapes qui suivent sa formation. Si l'on insère par exemple les précurseurs par trempage dans une solution du type de celles utilisées pour l'électrodéposition, on privilégie avantageusement les procédés de fixation du film organique qui donneront un revêtement qui ne sera pas lavé par ces solutions, par exemple en n'y étant pas soluble, ou bien encore en étant solidement accroché sur la surface via des liens physico-chimiques tel que le greffage comme représenté sur les figures 2 et 4. De préférence, on retiendra les procédés susceptibles de promouvoir la formation de liaisons à l'interface surface du substrat ou de la couche barrière barrière/film organique, et de préférence des liaisons chimiques covalentes, ioniques ou datives, correspondant à des interactions acide-base de Lewis. Cependant, comme on le verra dans les exemples de réalisation, on peut également désirer obtenir une couche métallique adhérente, par exemple sur la surface d'un semi-conducteur, en provoquant la réduction des précurseurs au sein d'une couche organique simplement déposée sur la surface comme cela est représenté sur la figure 3 annexée. Cela peut être obtenu, par exemple, en réalisant le dépôt d'un film organique (FO) déjà rempli avec les précurseurs (pM) (figure3a) : on évite ainsi une étape de remplissage, c'est-à-dire d'insertion, spécifique, qui doit forcément comporter l'utilisation d'un solvant ou d'un gonflant du polymère, susceptible de conduire à un lavage de la surface. Ici, l'étape consistant à disposer le film organique sur la surface et l'étape d'insertion du précurseur du matériau métallique du procédé de l'invention sont réalisées simultanément. Le précurseur du matériau métallique est alors transformé en ledit matériau métallique au sein du film organique (figure 3b) pour obtenir le film de germination (FG) selon la présente invention.

Le film organique peut par exemple être disposé sur la surface du substrat par centrifugation (« spin coating ») par trempage (« dip coating »), ou par pulvérisation ou nébulisation (« spray ») à partir d'une solution contenant les molécules ou macromolécules servant à fabriquer le film organique dans les deux cas (i) et (ii) suivants :
(i) Lorsque le résidu sec constitué par ces molécules ou macromolécules est insoluble dans les formulations utilisées dans les étapes consécutives du procédé de l'invention, et notamment dans celles de l'électrodéposition ou du dépôt autocatalytique destinées à la transformation du précurseur du matériau métallique en ledit matériau métallique. Ceci pourra par exemple être obtenu avec des polymères réticulables après dépôt, soit par action extérieure d'un agent de réticulation spécifique, soit grâce à leur mise en formulation (mélange) avec des agents de réticulation, soit les deux. Ces polymères ou leurs précurseurs de polymères sont donc solubles dans leur solvant de dépôt parce que non réticulés. Une fois la solution déposée, on peut réaliser la polymérisation et la réticulation sur la surface lorsque le bain contient les précurseurs de ces polymères. Dans le cas où la solution contient un polymère déjà formé, on peut cuire ; irradier, par exemple par des photons, des électrons, des ions, etc. ; ou bien appliquer toute forme de stimulus adéquat tels qu'une variation de pH, de température, etc. sur ces polymères, de façon à provoquer leur réticulation. Cette réticulation les rend en particulier insolubles dans le solvant de leur dépôt et dans de nombreux autres solvants, même pour des taux de réticulation faibles. Sont par exemple utilisables, selon l'invention, les polymères vinyliques, et notamment le poly(méthyle méthacrylate) (PMMA) et autres polymères dont les monomères sont basés sur des esters de l'acide méthacrylique ou acrylique comme le poly(hydroxyéthyle méthacrylate) (PHEMA), les poly cyanoacrylates, les polyacrylamides, la poly(4-vinyl pyridine), la poly(2-vinyl pyridine), le poly(vinyle carbazole) ; les polymères obtenus par polycondensation comme les polyamides et notamment le nylon, les polysiloxanes, les poly amino siloxanes ; les polymères obtenus à partir de monomères cycliques clivables par attaque nucléophile ou électrophile, et notamment les lactides, les époxy, les oxiranes, les lactames, les lactones, et notamment 1'→-caprolactone ; les macromolécules non polymériques comme la cellulose et ses dérivés et notamment l'hydroxy propyle méthyle cellulose, les dextranes, les chitosanes, fonctionnalisés ou non. Ces macromolécules sont soit réticulables directement, sans agent réticulant supplémentaire, soit réticulables via l'introduction d'un agent de réticulation. Ces agents, présents dans la formulation, sont ceux connus de l'homme du métier, on peut citer notamment les molécules portant au moins deux groupements fonctionnels compatibles avec les groupements fonctionnels du polymère ou créés sur le polymère par action extérieure, par exemple par variation du pH, thermique, par irradiation, etc. Il peut s'agir par exemple des molécules choisies dans le groupe constitué par : le divinyl benzène ou le penta érithrytol tétraméthacrylate ; les diamines telles que, par exemple, l'hexaméthylène diamine ; l'épichlorhydrine ; l'anhydride glutarique ; le glutaraldéhyde ; les bis-époxy ; les diacides carboxyliques comme l'acide azélaïque ; les bis siloxanes ; les amino siloxanes comme le →-aminopropyl triéthoxysilane →-APS) ; les bis chlorosilanes ; les bis isocyanates, etc. De préférence, les molécules ou macromolécules utilisées dans la formulation peuvent porter, avantageusement, en plus de leurs groupements fonctionnels intrinsèques, des groupements fonctionnels complémentaires, et notamment des groupements fonctionnels pouvant servir de ligands pour des ions, et notamment les ions métalliques précurseurs de métallisation. Parmi ces groupements fonctionnels présents intrinsèquement ou additionnellement sur les macromolécules du film organique, on peut notamment citer les amines, les amides, les éthers, les carbonyles, les carboxyles et les carboxylates, les phosphines, les oxydes de phosphines, les thio-éthers, les disulfures, les urées, les éther-couronnes, les aza-couronnes, les thio-couronnes, les cryptands, les sépulcrands, les podands, les porphyrines, les calixarènes, les pyridines, les bipyridines, les terpyridines, les quinoléines, les composés de l'orthophénantroline, les naphtols, les iso-naphtols, les thiourées, les sidérophores, les antibiotiques, l'éthylène glycol, les cyclodextrines, ainsi que les structures moléculaires substituées et/ou fonctionnalisées à partir de ces groupes fonctionnels ;
(ii) Lorsque les molécules et macromolécules de la formulation portent des groupements fonctionnels spécifiques, qui peuvent former des liaisons avec la surface de la couche barrière de façon spontanée lorsque ces groupements entrent au contact de la surface de la couche barrière. Ces molécules, de structure générique pouvant s'écrire A-B, sont constituées d'une extrémité réactive B, susceptibles de se fixer spontanément sur la surface de la couche barrière par contact de cette couche avec une phase liquide contenant les molécules A-B ou leur précurseur organiques, et d'un corps A portant différents groupements réactifs, notamment des ligands pour les cations précurseurs de la métallisation. On peut par exemple citer les sels de diazonium de formule {R-→-N₂⁺, X⁻}, dans laquelle A = R et B = →. On sait en effet que les sels de diazonium peuvent, à température ambiante, être clivés pour donner un radical aromatique R-→• pouvant se fixer sur la surface. Dans la formule ci-dessus, → est un noyau aromatique ; X⁻ est un anion choisi notamment dans le groupe constitué par un tétrafluoroborate, un halogénure, un sulfate, un phosphate, un carboxylate, un perchlorate, un hexafluorophosphate, un ferrocyanure, un ferricyanure ; et R est un groupement organique quelconque, linéaire ou non, ramifié ou non, éventuellement de nature macromoléculaire, comportant des groupements fonctionnels basiques, au sens de Lewis, susceptibles de constituer des ligands pour les acides de Lewis, et notamment les cations précurseurs de la métallisation. Parmi ces groupements fonctionnels, on peut notamment citer les amines, les amides, les éthers, les carbonyles, les carboxyles et les carboxylates, les phosphines, les oxydes de phosphines, les thio-éthers, les disulfures, les urées, les éther-couronnes, les aza-couronnes, les thio-couronnes, les cryptands, les sépulcrands, les podands, les porphyrines, les calixarènes, les pyridines, les bipyridines, les terpyridines, les quinoléines, les composés de l'orthophénanthroline, les naphtols, les iso-naphtols, les thiourées, les sidérophores, les antibiotiques, l'éthylène glycol, les cyclodextrines, ainsi que les structures moléculaires substituées et/ou fonctionnalisées à partir de ces groupes fonctionnels. Le groupement R peut notamment être l'une quelconque des macromolécules mentionnées dans la liste du cas (i) ci-dessus. Parmi les molécules pouvant s'adsorber spontanément sur la surface, par exemple par activation thermique, on peut également citer les molécules substituées par des précurseurs, thermiques ou photochimiques, de formation de radicaux, comme par exemple des amorceurs de polymérisation radicalaire comme les nitroxydes comme par exemple le 2,2,6,6-tetramethylpiperidinyloxy (TEMPO) ; les alkoxyamines ; les triphényls substitués ; les dérivés du verdazyl ; du thiazolinyl ; les peroxydes comme par exemple le peroxyde de benzoyle ; les thioesters ; les dithioesters ; et les disulfures.

La centrifugation ou « spin coating », parfois appelé « spin on » en microélectronique, est en effet un procédé permettant le dépôt de films organiques très fins, même s'il est surtout efficace sur des surfaces non rugueuses, étant donné que l'uniformité des films obtenus est optimale lorsque l'écoulement du flux est laminaire, ce qui peut parfois ne pas être le cas à l'aplomb d'irrégularités de surface (« spirales d'Eckman »). De plus, il a été observé que, pour des films ultraminces, l'évaporation du solvant pendant l'application du procédé augmente - de façon parfois localement inhomogène - la viscosité du fluide et conduit à des inhomogénéités d'épaisseur. Des dispositifs spécifiques, utilisables dans la présente invention, nécessitant un contrôle des pressions de vapeur saturante, de température et même d'humidité, ont sont décrits par exemple dans US 5,954,878 (1997) et US 6,238,735 (1999). Selon une variante, d'autres procédés utilisables selon l'invention sont les procédés de recuit par solvant de revêtements organiques déposés par « spin-coating », décrits par exemple dans US 6,312,971 (2000). A l'image du recuit thermique réactif réalisé sur les films hybrides US 5,998,522 (1998) également utilisable dans la présente invention, ces procédés nécessitent une étape supplémentaire au simple dépôt pour obtenir une couche homogène, à savoir l'étape de recuit.

Le substrat selon l'invention étant de préférence conducteur ou semi-conducteur de l'électricité, selon l'invention, le film organique peut également être disposé sur la surface en utilisant toute la panoplie des réactions de croissance et/ou de greffage de films organiques initiées par électrochimie. Cependant, comme on l'a vu plus haut, les réactions utilisable sont de préférence celles permettant de fournir des films d'épaisseur homogène et conformes à ladite surface quelle que soit la topologie géométrique de la surface. Comme précédemment, il est donc préférable de sélectionner des réactions électrochimiques qui sont peu sensibles à la topologie de champ électrique de la surface. De façon générale, les réactions électro-initiées répondent à cette contrainte, et sont donc des réactions utilisables pour la formation du film organique destiné à abriter dans les étapes suivantes du procédé de l'invention la réduction des précurseurs du matériau métallique pour obtenir la couche de germination. Par réactions électro-initiées, on entend des réactions électrochimiques comprenant au moins une étape de transfert de charge avec la surface de travail couplée, de façon antécédente ou consécutive, à des réactions chimiques dont aucune n'est une réaction de transfert de charge avec la même surface de travail. Il peut s'agir par exemple des réactions suivantes :
- les réactions d'électro-greffage de polymères : l'électro-greffage de polymères permet d'initier la croissance de chaînes de polymères grâce à une surface métallique polarisée électriquement, qui sert d'amorceur. Qu'il s'agisse de réactions d'électro-greffage - cathodique ou anodique - de précurseurs vinyliques ou de précurseurs cycliques clivables par attaque nucléophile ou électrophile, tel que décrit par exemple dans EP 038 244 ou dans EP 665 275, ou encore de réactions d'électro-greffage anodique, sur surfaces de silicium, d'alcynes fonctionnalisés, tel que décrit par exemple dans : E.G. Robins, M.P. Stewart, J.M. Buriak, « Anodic and cathodic electrografting of alkynes on porous silicon », Chemical Communications, 2479 (1999), des chaînes de polymères sont obtenues par croissance purement chimique (réactions de propagation) sous l'impulsion de cet amorçage : une seule réaction de transfert de charge donne donc lieu à une chaîne complète, dont la croissance ne fait intervenir aucune réaction de transfert de charge supplémentaire. L'expérience acquise dans le domaine montre que la gamme d'épaisseur comprise entre 2 nm et 1 →m est accessible à ce type de procédé. Une des particularités de l'électro-greffage de polymères est qu'il conduit à la formation de véritables liens covalents carbone/surface entre le polymère et la surface (Figure 2). Les monomères précurseurs des réactions d'électro-greffage de polymères vinyliques utilisables selon l'invention sont par exemple les monomères contenant des groupements vinyliques activés, c'est-à-dire porteurs de substituants électro-attracteurs ou électro-donneurs, et/ou des cycles clivables par attaque nucléophile ou électrophile, éventuellement activés. Il s'agit notamment de l'acrylonitrile ; du méthacrylonitrile ; des méthacrylates substitués et notamment du méthacrylate de méthyle, du méthacrylate d'éthyle, du méthacrylate de butyle, du méthacrylate de propyle, du méthacrylate d'hydroxyéthyle, du méthacrylate d'hydroxypropyle, du méthacrylate de glycidyle ; des acrylamides et notamment les méthacrylamides d'amino- éthyle, propyle, butyle, pentyle et hexyle ; des cyanoacrylates, des cyanométhacrylates, du polyéthylène glycol di-méthacrylate ; et plus généralement des téléchéliques di-acrylates ou di-méthacrylates ainsi que des macromolécules porteuses de groupements acrylate ou méthacrylate et plus généralement de groupements vinyliques activés ; de l'acide acrylique, de l'acide méthacrylique, du styrène, du parachloro-styrène et plus généralement des styrènes substitués activés, de la N-vinyl pyrrolidone, de la 4-vinyl pyridine, de la 2-vinyl pyridine, des halogénures de vinyle, du chlorure d'acryloyle, du chlorure de méthacryloyle, du Di-Vinyl Benzène (DVB), du penta-érythritol tétraméthacrylate et plus généralement les agents réticulants à base acrylate, méthacrylate ou vinylique, et de leur dérivés. Sont notamment utilisables pour conduire à la formation de films électro-greffés les solutions comportant un ou un mélange de plusieurs des composés de la liste ci-dessus, ce qui permet d'envisager la formation de copolymères et/ou de réseaux réticulés. Parmi les composés à cycles clivables par attaque nucléophile ou électrophile, sont utilisables notamment les époxydes, les oxiranes, les lactones et notamment les caprolactones, les lactames, ainsi que toute molécule ou macromolécule porteuse de tels groupements. Les alcynes fonctionnalisés utilisables dans la présente invention, par exemple pour un électro-greffage anodique sur surface de silicium, sont par exemple les composés de formule générique R-C=C-H, où R est un groupement organique tout à fait quelconque, linéaire ou non, ramifié ou non, éventuellement de nature macromoléculaire, comportant des groupements fonctionnels basiques, au sens de Lewis, susceptibles de constituer des ligands pour les acides de Lewis, et notamment les cations précurseurs de la métallisation. Parmi ces groupements fonctionnels, on peut notamment citer les amines, les amides, les éthers, les carbonyles, les carboxyles et les carboxylates, les phosphines, les oxydes de phosphines, les thio-éthers, les disulfures, les urées, les éther-couronnes, les aza-couronnes, les thio-couronnes, les cryptands, les sépulcrands, les podands, les porphyrines, les calixarènes, les pyridines, les bipyridines, les terpyridines, les quinoléines, les composés de l'orthophénanthroline, les naphtols, les iso-naphtols, les thiourées, les sidérophores, les antibiotiques, l'éthylène glycol, les cyclodextrines, ainsi que les structures moléculaires substituées et/ou fonctionnalisées à partir de ces groupes fonctionnels. Le groupement R peut être une structure moléculaire de taille arbitraire, et notamment une macromolécule quelconque, et notamment un polymère ;
- les réactions d'électro-greffage de fragments organiques par réactions d'électro-clivage : il s'agit en fait du cas particulier des réactions électro-initiées où les réactions couplées au transfert de charge sont le clivage de la molécule électro-réduite ou électro-oxydée (clivage homolytique ou hétérolytique), et l'adsorption sur la surface de travail d'au moins une des deux espèces clivées. Sont notamment utilisables dans cette catégorie les réactions d'électro-réduction ou d'électro-oxydation de sels de diazonium, telles que celles décrites dans WO 98 44172, de sulfonium telles que celles décrites dans US 6,238,541, de phosphonium, d'iodonium, de peroxo-disulfates, de persulfates, de thiosulfates, du ferrocène, d'acides carboxyliques et notamment benzoïques, par exemple réaction de Kolbe décrite dans WO 98 40450, ou de peracides, ainsi que - en particulier sur les surfaces de silicium - les réactions d'électro-greffage cathodique d'alcynes telles que celles décrites dans E.G. Robins, M.P. Stewart, J.M. Buriak, « Anodic and cathodic electrografting of alkynes on porous silicon », Chemical Communications, 2479 (1999), op.cit. Ces réactions permettent de fixer solidement des couches organiques ultra-fines sur tout substrat conducteur ou semi-conducteur de l'électricité, avec formation de liaisons covalentes d'interface, en pré-fonctionnalisant le précurseur avec les groupements fonctionnels d'intérêt que l'on souhaite fixer sur la surface. Dans le cadre de la présente invention, on peut par exemple utiliser des sels de diazonium de formule {R-→-N2⁺,X⁻} pour obtenir, par électroréduction, le greffage de fragments R-→- sur la surface de travail. Dans la formule ci-dessus, → est un noyau aromatique, X⁻ est un anion et notamment un tétrafluoroborate, un halogénure, un sulfate, un phosphate, un carboxylate, un perchlorate, un hexafluorophosphate, un ferrocyanure, un ferricyanure, et R est un groupement organique quelconque, linéaire ou non, ramifié ou non, éventuellement de nature macromoléculaire, comportant des groupements fonctionnels basiques, au sens de Lewis, susceptibles de constituer des ligands pour les acides de Lewis, et notamment les cations précurseurs de la métallisation. Parmi ces groupements fonctionnels, on peut notamment citer les amines, les amides, les éthers, les carbonyles, les carboxyles et les carboxylates, les phosphines, les oxydes de phosphines, les thio-éthers, les disulfures, les urées, les éther-couronnes, les aza-couronnes, les thio-couronnes, les cryptands, les sépulcrands, les podands, les porphyrines, les calixarènes, les pyridines, les bipyridines, les terpyridines, les quinoléines, les composés de l'orthophénanthroline, les naphtols, les iso-naphtols, les thiourées, les sidérophores, les antibiotiques, l'éthylène glycol, les cyclodextrines, ainsi que les structures moléculaires substituées et/ou fonctionnalisées à partir de ces groupes fonctionnels. Le groupement R peut être une structure moléculaire de taille arbitraire, et notamment une macromolécule quelconque, et notamment un polymère. Il est également possible en particulier d'utiliser une voie alternative à celle décrite dans l'alinéa précédent pour greffer des polymères sur des surfaces : au lieu de construire le polymère brique par brique sur la surface, par amorçage direct (électro-greffage de polymères), on peut considérer un polymère déjà fabriqué que l'on fonctionnalise avec des groupements amines aromatiques (-→-NH2), que l'on tranforme ensuite en sels de diazonium par une procédure adéquate connue de l'homme de l'Art, telle qu'une réaction avec HCl/NaNO₂ ou avec NOBF₄, avant d'appliquer un potentiel cathodique permettant le greffage de ces groupements - et donc du polymère sur lequel ils sont solidarisés - sur ladite surface. Un tel polymère pourra notamment être choisi, comme indiqué plus haut, pour ses propriétés de capture des ions précurseurs du film métallique. De la même manière, on pourra avoir recours à des alcynes, de formule générale R-C=C-H, où le groupement R est également un groupement quelconque, ayant les mêmes caractéristiques que précédemment.
- les réactions d'électro-polymérisation électro-initiées : il s'agit de réactions où l'on utilise un mélange comportant au moins un amorceur électro-activable, de préférence radicalaire, et un monomère polymérisable. Il peut s'agir par exemple de mélanges contenant les composés décrits précédemment, à savoir comprenant au moins un sel de diazonium et au moins un monomère vinylique. La polarisation cathodique d'une surface dans un tel mélange conduit à l'électroréduction du sel de diazonium et à la formation de radicaux R-→•, qui peuvent initier la polymérisation radicalaire du monomère vinylique. Comme on le voit, seule l'étape d'initiation utilise une réaction de transfert de charge, alors que la formation du film de polymère procède par étapes purement chimiques : il s'agit donc bien de réactions électro-initiées au sens de l'invention.

Les réactions électro-initiées considérées ici ont ceci de particulier que seule l'étape d'initiation est consommatrice ou génératrice de courant électrique. Dans chacune des réactions électro-initiées mentionnées ci-dessus, le courant sert essentiellement à augmenter la densité de greffons par unité de surface (puisque chaque réaction de transfert de charge est associée à la formation d'une liaison d'interface), alors que la croissance du film organique - lorsqu'elle a lieu (comme par exemple dans le cas de l'électro-greffage de polymères vinyliques) - n'est contrôlée que par des réactions chimiques. Le nombre maximal de chaînes greffées par unité de surface est égal au nombre de sites par unité de surface (soient environ 10¹⁵ sites/cm²), avec lesquels la formation d'une liaison d'interface carbone/métal est possible. Si le taux de couverture maximal - quel qu'il soit - peut être obtenu, par exemple à potentiel imposé, en polarisant pendant environ 1 minute, on en déduit que les courants électriques mis en jeu sont de l'ordre de la dizaine à la centaine de micro-ampères par cm² de surface réelle, quelle que soit le type de réaction électro-initiée considérée. Comme on le verra dans les exemples de réalisation, cet ordre de grandeur s'avère tout à fait correct dans la plupart des cas, à rugosités de surface identiques. Ces courants sont donc de deux à trois ordres de grandeur inférieurs - à épaisseur comparable - à ceux que l'on peut rencontrer dans des réactions électro-suivies (électrodéposition de polymères conducteurs, de métaux, de poly-électrolytes, etc.), où la croissance de la couche est en général reliée à la charge (c'est-à-dire à l'intégrale temporelle du courant).

Ainsi, si l'on considère une surface non équipotentielle électrique, par exemple une plaquette pour la fabrication d'un circuit intégré (« wafer ») d'un matériau semi-conducteur comme le silicium, ou encore une surface recouverte d'une couche barrière semi-conductrice de nitrure métallique comme le nitrure de titane ou de tantale, deux points quelconques de cette surface entre lesquels existe une résistance par exemple de l'ordre de la dizaine de kilo-ohms verront un potentiel électrochimique différent de seulement quelques centaines de millivolts dans le cas d'une réaction électro-initiée, alors que la différence de potentiel pourra atteindre plusieurs volts voire plusieurs dizaines de volts dans le cas d'une réaction électro-suivie. Si la nature des réactions électrochimiques qui ont lieu sur une surface polarisée est sensible à des écarts de potentiel de l'ordre du volt ou de quelques volts, on peut par contre espérer des effets bien moindres de la part de situations espacées de quelques centaines de millivolts seulement. Ainsi les réactions électro-initiées sont intrinsèquement moins sensibles aux effets de chute ohmique mineure, comme ceux pouvant apparaître dans une cellule électrochimique imparfaite. De plus, les réactions électro-suivies sont intrinsèquement des réactions « à seuil de potentiel », c'est-à-dire qu'il existe un potentiel électrique au-delà duquel les caractéristiques (notamment taux de greffage et épaisseur) du film déposé, à composition de solution égale, sont tout simplement insensibles aux effets de chute ohmique : appelons V_{bloc} le potentiel au-delà duquel (en valeur absolue) on obtient le taux de greffage maximal (saturation de la surface), par exemple suite à un dépôt à potentiel imposé. Effectuer une polarisation à V_{bloc} + →V, au-delà du potentiel de blocage, conduira - dans la même solution - au même film, puisqu'à ce potentiel, on obtient également le taux de greffage maximal. Comme l'épaisseur, à taux de greffage maximal, ne dépend que de la longueur des chaînes et donc uniquement de la composition chimique de la solution, un film ayant les mêmes caractéristiques est obtenu pour tout protocole de potentiel impliquant au moins une gamme supérieure à V_{bloc}. Le potentiel V_{bloc} peut facilement être déterminé pour un polymère donné en traçant un graphique de la quantité de polymère greffé en fonction du potentiel appliqué, le potentiel V_{bloc} correspond sur ce graphique au potentiel (en valeur absolue) à partir duquel le taux de greffage du polymère est maximal.

En résumé, les réactions électro-initiées possèdent une propriété intrinsèque que ne possèdent pas les réactions électro-suivies : elles peuvent avantageusement niveler les effets de chute ohmique sur une surface ne constituant pas une équipotentielle électrique. Un revêtement homogène et d'épaisseur uniforme peut ainsi être facilement obtenu sur une surface non équipotentielle à l'aide d'un dépôt issu d'une réaction électro-initiée : il suffit de polariser la surface à l'aide d'un protocole comportant une gamme de potentiel supérieure (en valeur absolue) à V_{bloc} + →V, où →V est la plus grande chute de potentiel sur la surface à traiter du fait de la prise de contact électrique qui a été effectuée. Cette caractéristique des réactions électro-initiées permet notamment d'obtenir des revêtements conformes même sur des surfaces ayant des ratios d'aspect élevés, et donc des zones à très faible rayon de courbure (arrêtes, pointes, etc.) : les réactions électro-initiées s'avèrent essentiellement sensibles à la topologie géométrique, et non à la cartographie de chutes ohmique de la surface.

Ces réactions constituent donc des réactions adéquates pour l'obtention de films organiques conformes selon l'invention, dans lesquels on pourra abriter la formation du matériau métallique à partir de son précurseur, comme illustré dans les exemples de réalisation présentés ci-après.

Une autre catégorie de réactions pouvant être utilisée pour la réalisation de films organiques minces et homogènes sur les surfaces de conducteur et de semi-conducteur dans le procédé de la présente invention est consituée des réactions d'électro-polymérisation conduisant à des polymères isolants électriques.

Les réactions d'électro-polymérisation sont des réactions de polymérisation initiées par une réaction de transfert de charge, et dont la progression résulte d'une succession de réactions, dont, notamment, des réactions de transfert de charge. Il s'agit donc de réactions intrinsèquement différentes des réactions d'électro-greffage précédemment décrites, car elles ne sont pas électro-initiées mais électro-suivies : la formation de l'électro-polymère se poursuit tant que le potentiel de l'électrode de travail est suffisant pour maintenir l'ensemble des réactions de transfert de charge. Ces réactions conduisent en général à un dépôt organique sur la surface, par précipitation du polymère formé au voisinage de la surface. Les réactions d'électro-polymérisation ne conduisent en général pas à un greffage, au sens du paragraphe précédent. Un bon moyen de les distinguer consiste par exemple à réaliser leur dépôt sur une électrode tournante ayant une vitesse de rotation élevée. Dans le cas de l'électro-polymérisation du pyrrole, on n'observe plus de polymère sur l'électrode - en fin de réaction - dès que sa vitesse de rotation est supérieure à 5000 tours/minute. Dans le cas de l'électro-greffage du méthacrylonitrile, on obtient du polymère sur la surface de l'électrode même à 10.000 tours/minute, c'est-à-dire au seuil de turbulence. De plus, on observe que la quantité de polyméthacrylonitrile greffé est la même que lorsque l'électrode ne tourne pas comme cela est décrit dans P. Viel, C. Bureau, G. Deniau, G. Zalczer and G. Lécayon, « Electropolymerization of methacrylonitrile on a rotating disk at high spinning rate », Journal of Electroanalytical Chemistry, 470, 14 (1999).

De même que l'on ne peut électrogreffer que des molécules porteuses de groupements vinyliques ou de cycles clivables par attaque nucléophile ou électrophile, seuls certains précurseurs spécifiques peuvent être électro-polymérisés. Selon l'invention, sont utilisables en particulier le pyrrole, l'aniline, le thiophène, l'acétylène et leurs dérivés, qui conduisent à la formation de polymères conducteurs. Les polymères formés à partir de ces précurseurs étant conducteurs, leur formation et leur précipitation sur la surface ne bloquent pas l'électrode de travail, et ces polymères peuvent « pousser » sur eux-mêmes tant que le courant électrique est maintenu. La quantité de polymère formée est reliée à la charge électrique (c'est-à-dire à l'intégrale temporelle du courant) passée dans le circuit : il se forme donc davantage de polymère dans les zones de champ électrique fort, là où les courants locaux sont plus intenses. Cette caractéristique fait de l'électro-polymérisation des précurseurs de polymères conducteurs des réactions moins intéressantes pour l'obtention de films homogènes - et notamment conformes - sur des surfaces présentant une topologie non uniforme de chutes ohmiques, et notamment lorsque la surface de l'électrode de travail est très structurée, comme c'est notamment le cas dans la microélectronique. Leur utilisation pour la présente invention, sera plus appropriée aux situations où les écarts d'épaisseurs entre deux zones de l'électrode de travail demeurent inférieurs à la tolérance admise pour conclure à l'homogénéité et de la conformité du dépôt.

Il existe cependant certains précurseurs de films organiques qui peuvent être électro-polymérisés, mais dont l'électro-polymère produit est isolant. C'est le cas par exemple des diamines, et notamment de l'éthylène diamine, du 1,3-diamino propane, et autres diamines. L'électro-polymérisation de l'éthylène diamine, par exemple, conduit à la formation de polyéthylène imine (PEI) qui est un polymère isolant hydrophile. A la différence des précurseurs de polymères conducteurs, les diamines conduisent à un polymère isolant, qui précipite sur la surface et la passive : la croissance de l'électro-polymère est donc auto-limitée, en l'occurrence par sa précipitation, qui est un phénomène non électrochimique. En conséquence, tout comme pour les réactions d'électro-greffage, la formation de la couche devient indépendante du courant électrique et n'est dictée que par la précipitation, ce qui fait qu'elle est également indépendante de la topologie de potentiel électrique et permet donc l'obtention de revêtements homogènes - et en particulier conformes utilisables pour la mise en oeuvre du procédé de la présente invention.

Dans l'exposé qui suit, la présente invention est illustrée de manière non limitative pour l'obtention d'une couche de germination de cuivre sur une couche barrière de TiN, TiN(Si) ou TaN pour l'interconnexion cuivre en micro-électronique. Il apparaîtra clairement à l'homme du métier que cette restriction ne nuit pas à la généralisation de l'invention, ni au cas de couches de germinations métalliques sur toute surface, avec si nécessaire une couche barrière conductrice ou semi-conductrice de l'électricité, ni à l'obtention de couches métalliques homogènes - et notamment conformes - ayant d'autres fonctions que la couche barrière, dans les autres domaines d'applications de la présente invention.

### BRÈVE DESCRIPTION DES DESSINS

Sur ces figures, « g » représente un greffage (film organique sur une surface) ; « eg » électrogreffé ; « h » l'épaisseur du film organique ; « Tr (%) la transmission en % ; « No (cm⁻¹) » le nombre d'onde en cm⁻¹ ; « F (Hz) » la fréquence en Hertz ; « Im (Ω) » l'impédance en Ohms ; « E(eV) » l'énergie en eV ; « ref » référence ; « prot » protocole ; « t d » trempé diazo.
- La figure 1 représente un mode de réalisation du procédé de la présente invention comprenant : une étape (a) de dépôt d'un film organique « FO » sur une surface « S » gravée d'un creux « CR » (« L » indique la largeur de la gravure), la surface gravée comportant une couche barrière « CB » ; une étape (b) d'insertion d'un précurseur d'un matériau métallique « pM » au sein du film organique FO ; une étape (c) de transformation du précurseur pM en ledit matériau métallique au sein dudit film organique pour constituer le film de germination (FG) selon l'invention ; et une étape (d) de remplissage du creux par ledit matériau métallique pour obtenir une couche métallique (CM).
- Les figures 2a et 2b représentent un agrandissement schématique des étapes (b) et (c) représentées sur la figure 1 lorsque le film organique (FO) est greffé sur la surface S. Sur la figure 2a, le film organique est déjà greffé sur la surface (les points noirs indiquent les points de greffage du film sur la surface) et le précurseur du matériau métallique (pM) est inséré au sein de ce film organique. La profondeur de pénétration des précurseurs au sein du film est ici arbitrairement représentée comme totale, c'est-à-dire que les précurseurs sont enfouis dans la film jusqu'à « toucher » la surface. En fait, le remplissage peut n'être que partiel (si par exemple le solvant de remplissage n'est qu'un gonflant médiocre du film électro-greffé). Sur la figure 2b, le précurseur du matériau métallique a été transformé en ledit matériau métallique au sein dudit film organique pour former le film de germination FG de la présente invention sur la surface S. De la même manière, la proportion effective du volume du film électro-greffée finalement occupée par la couche métallique dépendra de la quantité d'ions précurseurs qui ont été accrochés et/ou insérés dans ledit film.
- Les figures 3a et 3b représentent un agrandissement schématique des étapes (b) et (c) représentées sur la figure 1 lorsque le film organique (FO) est déposé sur la surface S. Sur la figure 3a, le film organique est déjà déposé sur la surface et le précurseur du matériau métallique (pM) est inséré au sein de ce film organique. Sur la figure 3b, le précurseur du matériau métallique a été transformé en ledit matériau métallique au sein dudit film organique pour former le film de germination FG de la présente invention sur la surface S. La profondeur de pénétration effective des précurseurs dans le film est ici arbitraitement fixée à l'épaisseur du film déposé, mais les situations intermédiaires où la pénétration n'est que partielle (voire même lorsqu'il n'y a d'accrochage qu'en surface du film) sont également acceptables pour la présente invention, puisqu'elles exploitent de même la conformité du film organique.
- La figure 4 représente le détail moléculaire d'un mode de réalisation de la présente invention suivant le procédé représenté sur la figure 2 (film organique greffé). L'épaisseur (h) du film organique (FO) greffé est de 100nm, la surface est une surface d'inox 316L, « g » indique les points de greffage des molécules consituant le film organique. Le précurseur du matériau métallique (pM) est ici sous la forme d'ions du cuivre, pour obtenir un film de germination de cuivre. Le film étant un film de P4VP, il pourra être intégralement rempli d'ions cuivriques en milieu aqueux, et incomplètement en milieu organique (acétonitrile...) ou en milieu aqueux très acide.

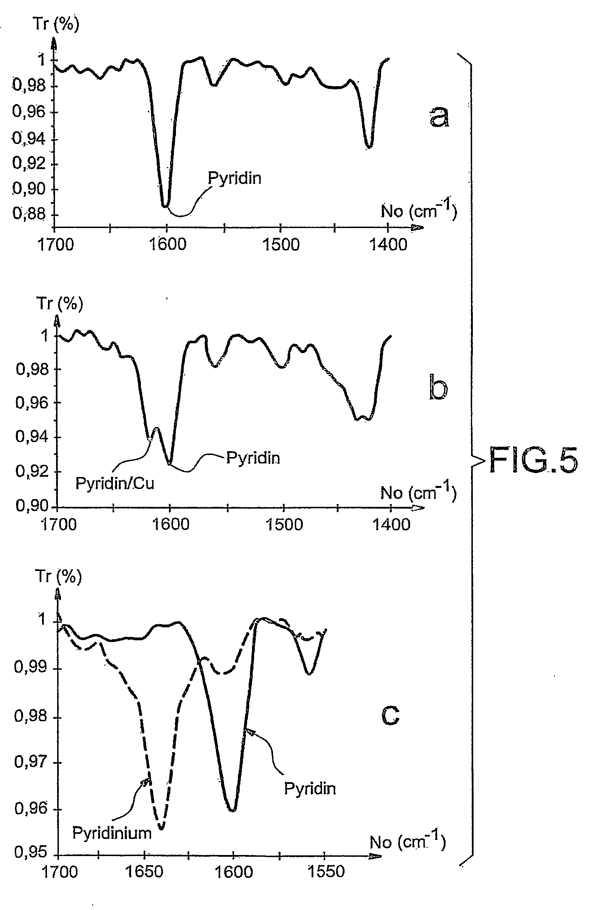

- Les figures 5a, 5b et 5c représentent des spectres infrarouges (IRRAS) de films de P4VP ayant une épaisseur de 100 nm sur nickel avant (5a) et après (5b) trempage 10 minutes dans une solution aqueuse à 5 g/l en sulfate de cuivre. Le dédoublement du pic à 1617 cm⁻¹ est caractéristique de la formation de complexes cuivre/pyridine prouvant la pénétration de la solution dans le film. La figure 5c représente un spectre après traitement du film en milieu acide.

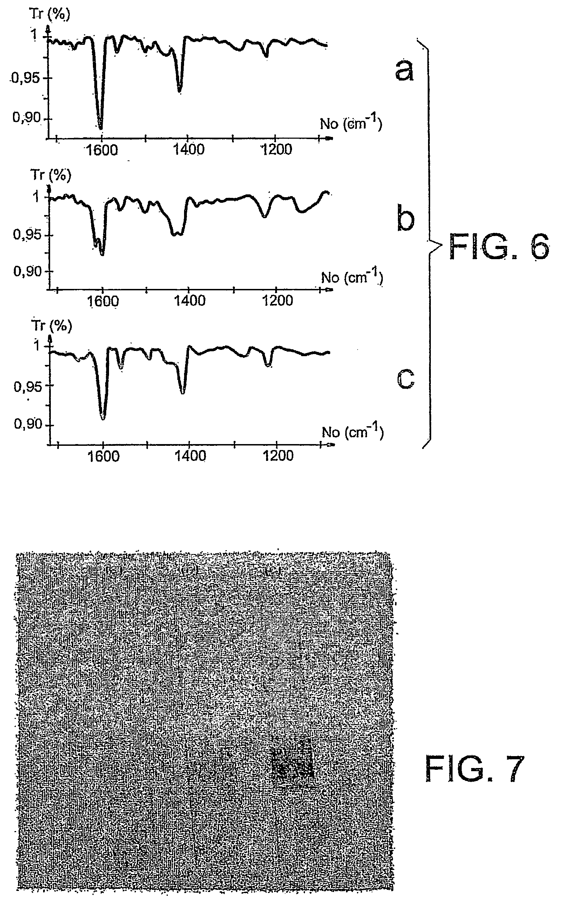

- Les figures 6a, 6b et 6c représentent des spectres IRRAS d'une lame obtenue respectivement selon le même protocole que celui de la figures 5a (Figure 6a), chargée en ions cuivriques selon le même protocole que celui de la figure 5b (Figure 6b), puis d'une lame selon la figure 6b traitée pendant 5 minutes dans une solution d'hydroxyde d'ammonium à 9 mol/l (Figure 6c).
- La figure 7 est une photographie de trois lames obtenues par fixation de cuivre sur une surface d'inox 316L grâce à un film organique constitué de P4VP électro-greffé conformément au procédé de la présente invention. Le cuivre déposé à partir de son précurseur dans le film est obtenu par une électrodéposition potentiostatique de durée variable. De gauche à droite, on observe le résultat d'une électrodéposition pendant 50 (lame (a)), 120 (lame (b)) et 240 (lame (c)) secondes, respectivement.

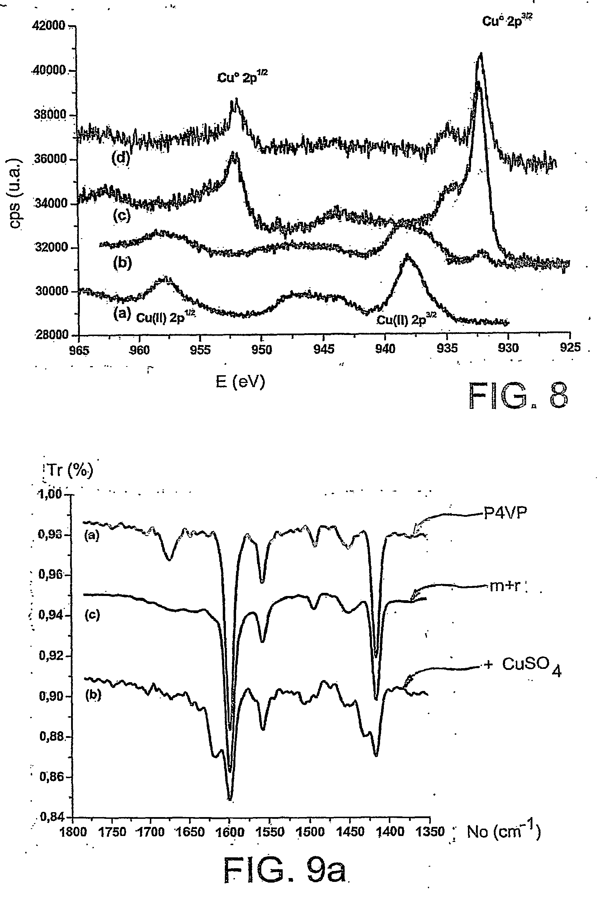

- La figure 8 rend compte des spectres de photoélectrons X (XPS) des lames de la Figure 6, dans la région des orbitales 2p du cuivre. Le spectre (a) est celui obtenu après trempage des lames d'inox recouvertes du film de P4VP électro-greffé dans la solution d'ions cuivriques (voir exemple n°1); les spectres (b), (c) et (d) sont ceux obtenus après électrodéposition du précurseur du cuivre en cuivre dans les films de P4VP, montrant la conversion progressive des ions cuivriques du film en atomes de cuivre.

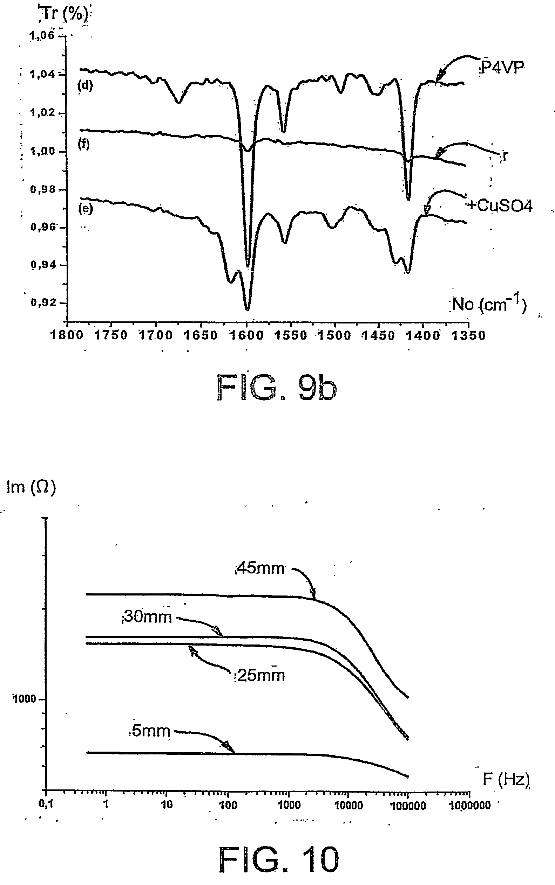

- Les figures 9a et 9b sont des spectres infrarouges de lames obtenues notamment lors des différentes étapes du procédé de l'invention. Pour obtenir ces spectres, un film de P4VP est déposé sur une lame (surface) d'or par centrifugation. Les spectres (a) et (d) correspondent au film P4VP vierge ; les spectres (b) et (e)) au film P4VP dans lequel on a inséré un précurseur de cuivre par trempage de la lame dans une solution concentrée en cuivre (+CuSO₄) ; le spectre (c) correspond au film P4VP dans lequel on a inséré comme précédemment puis transformé le précurseur du cuivre en cuivre et rincé le film de germination ainsi obtenu (m+r) ; le spectre (f) correspond au film P4VP dans lequel on a inséré le précurseur de cuivre comme précédemment puis rincé (r), la transformation du précurseur n'ayant pas été réalisée.
- La figure 10 représente un graphique de mesures d'impédances (Im), en Ohms, dans la gamme de fréquences comprise entre 0,5 Hz et 100 kHz obtenues entre deux points d'une lame de silicium de 2 x 10 cm, recouverte par dépôt chimique en phase vapeur (CVD, Chemical Vapor Deposition, en anglais) d'une couche de TiN d'épaisseur environ de 20 nm. Un premier contact électrique est établi à l'aide d'une pince crocodile à une extrémité de la lame et un second contact est pris de la même façon à des distances croissantes du premier, de 5 à 45 mm, avec une précision de l'ordre du mm.

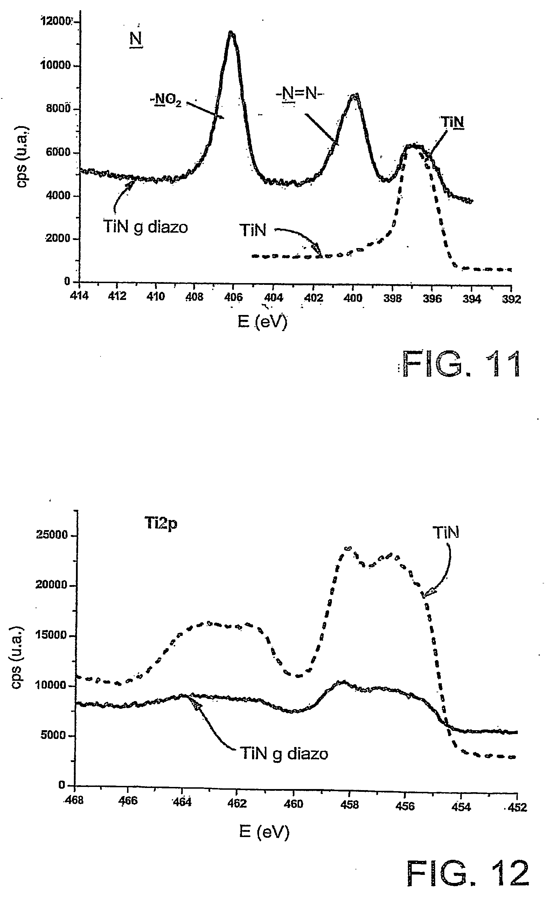

- Les figures 11 et 12 représentent des spectres d'analyse de surface en spectroscopie de photoélectrons X (XPS) effectués sur une lame obtenue par greffage d'un film organique sur TiN par électroréduction de sels de diazonium. En pointillés, TiN seul, et en trait continu, TiN greffé diazo (TiN g diazo).

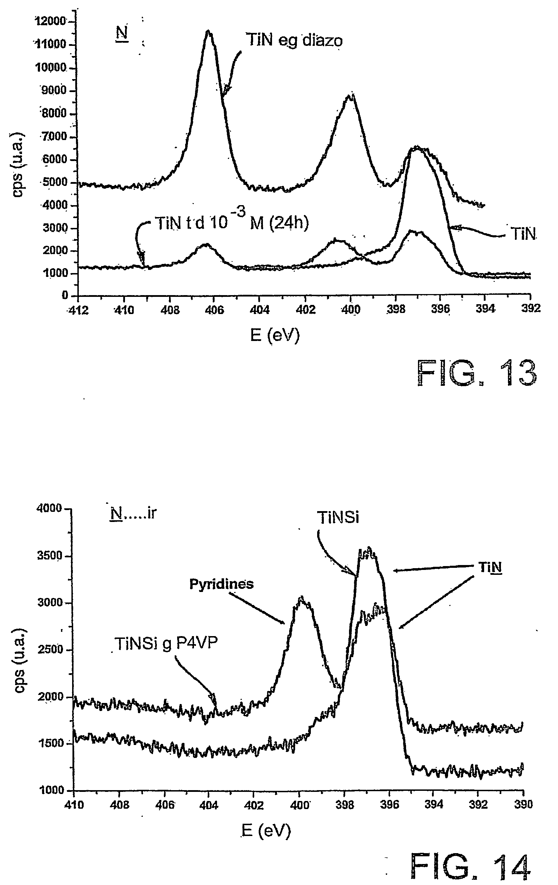

- La figure 13 représente la région N1s des spectres d'analyse de surface en spectroscopie de photoélectrons X (XPS) d'une lame de TiN mise à tremper dans une solution de tétrafluoroborate de 4-nitro-phényl diazonium (TiN t d 10⁻³M (24h)) dans l'acétonitrile pendant 24 heures en comparaison de la lame de TiN initiale et d'une lame TiN électrogreffé diazo (TiN eg diazo).
- La figure 14 représente la région N1s du spectre d'analyse de surface en spectroscopie de photoélectrons X (XPS) d'une lame de silicium, recouverte, par CVD, d'une couche de 20 nm de TiNSi, plongée dans une solution de 4-vinyl pyridine dans la di-méthyle formamide, en présence de perchlorate de tétra-éthyle ammonium (TiNSi g P4VP), en comparaison de celui de la lame de TiNSi de départ.

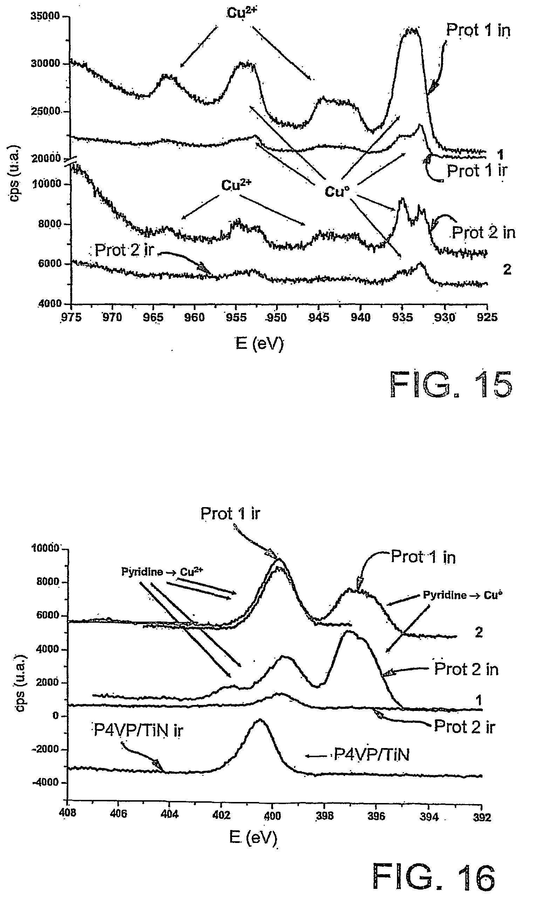

- La figure 15 représente des spectres d'analyse de surface en spectroscopie de photoélectrons X (XPS) effectués lame de TiN recouverte de P4VP, reliée à un potentiostat en tant qu'électrode de travail, mettant en évidence l'insertion d'un précurseur du cuivre (sulfate de cuivre [CuSO₄, 5 H₂O]) dans le film de P4VP. La région des orbitales 2p du cuivre du spectre XPS de la lame est représentée sur la partie supérieure de la Figure 15.
- La Figure 16 représente la région N1s du spectre XPS de la figure 15. Sur les figures 15 et 16, « in » représente les mesures par incidence normale et « ir » par incidence rasante.

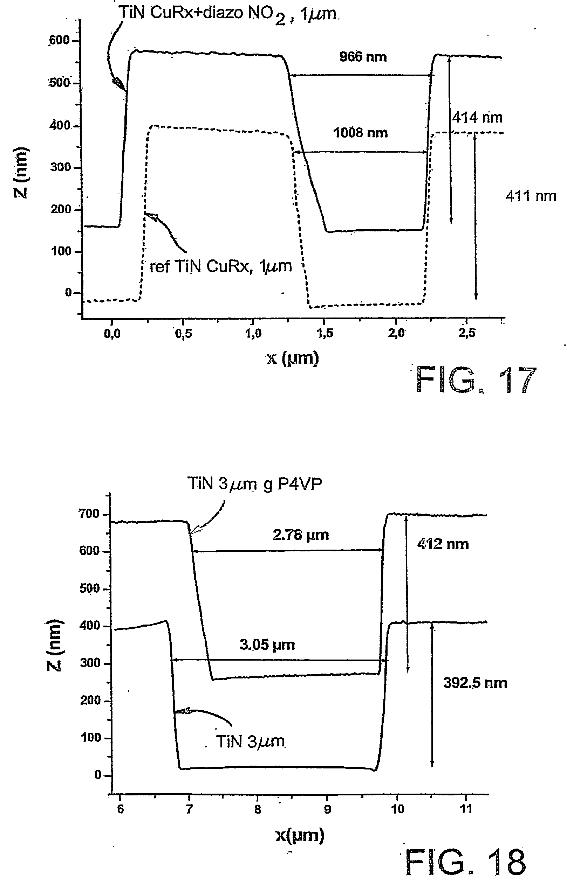

- Les figures 17, 18 et 19 représentent la comparaison de profils, obtenus au moyen d'un microscope à force atomique (AFM) de substrats présentant des gravures sous forme de tranchées régulièrement espacées, avant et après revêtement par un film de germination d'un matériau métallique obtenu selon des procédés de la présente invention. « z » représente des dimensions en nm et « x » des dimensions en µm, « g » = greffé.
- Les figures 20 et 21 sont des micrographies de microscopie électronique à balayage (MEB) d'un substrat de silicium présentant des gravures régulières sous forme de tranchées de 200 nm de largeur environ, et espacées de 300 nm, revêtues d'une couche barrière de nitrure de titane de 10 nm environ, et revêtues d'un film de polymère (P4VP) électro-greffé servant à l'élaboration d'une couche de germination selon la présente invention, montrant la conformité du revêtement. Il s'agit d'un grossissement x100000 (figure 20) (l'échelle est indiquée par les pointillés et la cote 300 nm sur la micrographie) et d'un grossissement x150000 (figure 21)(l'échelle est indiquée par les pointillés et la cote 200 nm sur la micrographie).

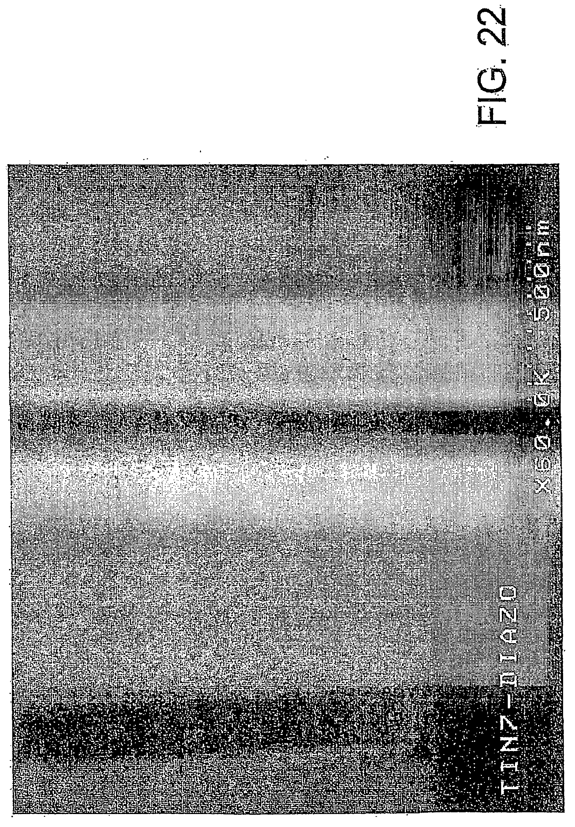

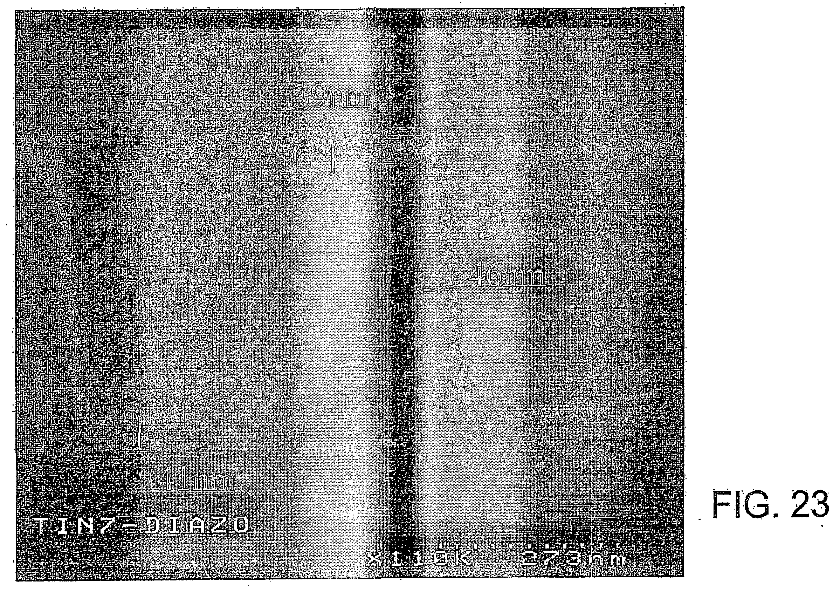

- Les figures 22 et 23 sont des micrographies de microscopie électronique à balayage (MEB) d'un substrat de silicium présentant des gravures régulières sous forme de tranchées de 200 nm de largeur environ, espacées de 300 nm, et ayant une profondeur de 400 nm revêtues d'une couche barrière de nitrure de titane de 10 nm environ, et revêtues d'un film d'un sel de diazonium électro-greffé servant à l'élaboration d'une couche de germination selon la présente invention, montrant la conformité du revêtement. Il s'agit de grossissements x60000 (figure 22) et x110000 (figure 23) (sur les micrographie, l'échelle est indiquée par les pointillés et la cote, respectivement 500 et 173 nm).

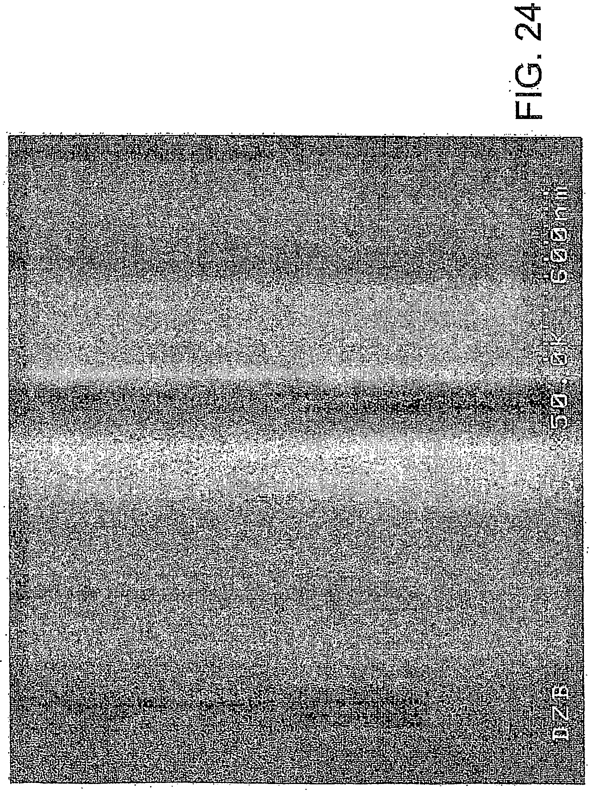

- La figure 24 est une micrographie de microscopie électronique à balayage (MEB) montrant l'effet produit par le même traitement que celui utilisé pour obtenir le résultat des figures 22 et 23, mais sur une gravure plus fine, de 0,12 µm. Il s'agit d'un grossissement x50000 (sur les micrographie, l'échelle est indiquée par les pointillés et la cote 600 nm).

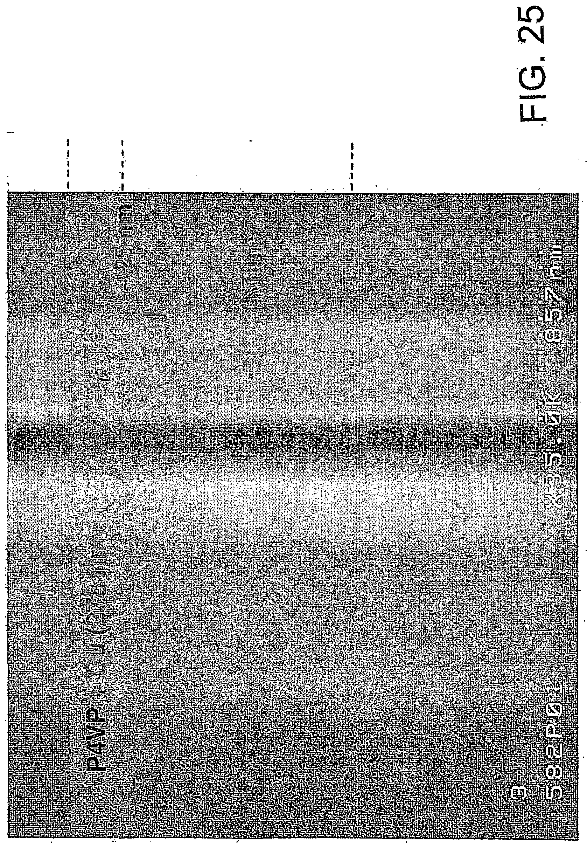

- La figure 25 est une micrographie de microscopie électronique à balayage (MEB) d'une tranche d'un substrat de silicium sans gravures (surface plane) revêtu d'une couche barrière de nitrure de titane de 10 nm environ, et d'un film de P4VP électro-greffé servant à l'élaboration d'une couche de germination selon la présente invention, montrant la conformité du revêtement. Il s'agit d'un grossissement x35000 (sur la micrographie, l'échelle est indiquée par les pointillés et la cote 857 nm). Les pointillés indiquent les différentes couches de matériaux.

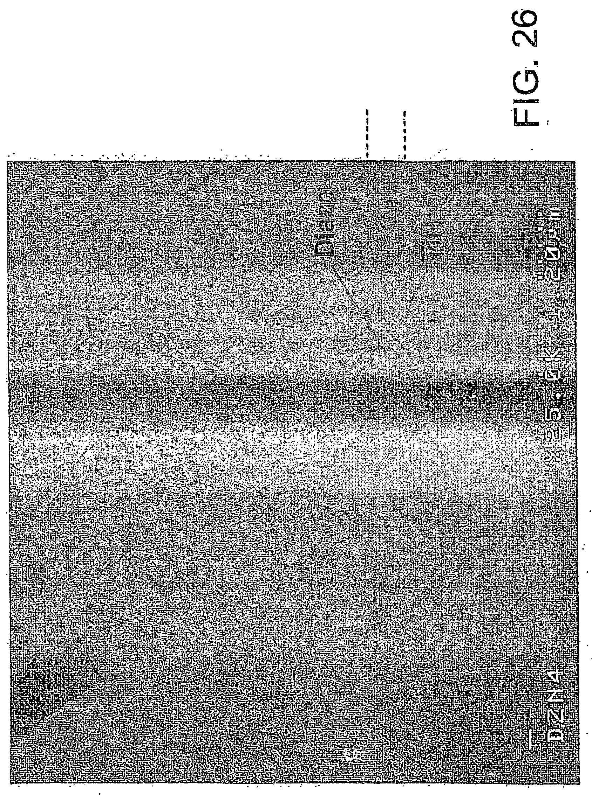

- La figure 26 est une micrographie de microscopie électronique à balayage (MEB) d'une tranche d'un substrat de silicium avec gravures revêtu d'une couche barrière de nitrure de titane de 10 nm environ, d'un film de germination a base d'un sel de diazonium électro-greffé, et d'une couche de cuivre formée à partir de, et sur, la couche de germination, montrant la conformité du revêtement de cuivre sur les gravures. Il s'agit d'un grossissement x25000 (sur la micrographie, l'échelle est indiquée par les pointillés et la cote 1,20 nm).

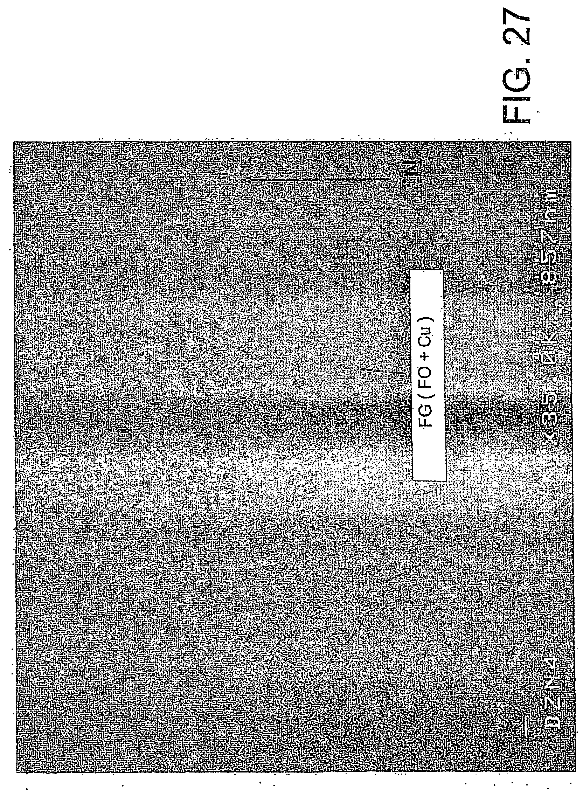

- La figure 27 est une micrographie de microscopie électronique à balayage (MEB), obtenue à un autre endroit du substrat de la figure 26. Il s'agit d'un grossissement x35000 (sur la micrographie, l'échelle est indiquée par les pointillés et la cote 857 nm).

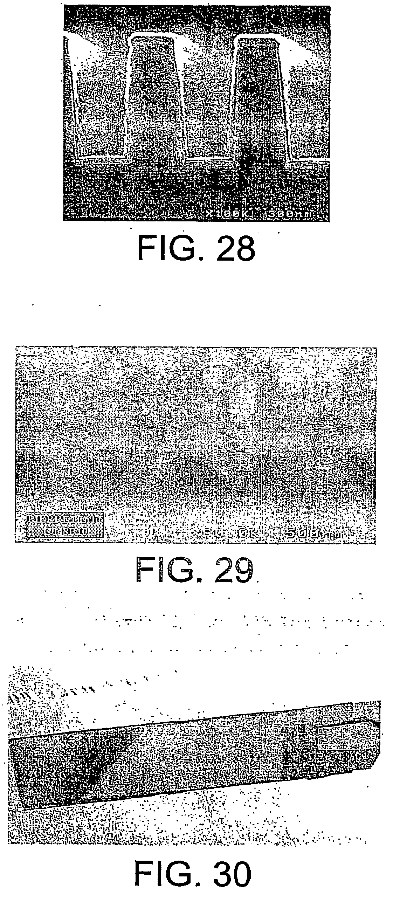

- La Figure 28 : Cliché en microscopie électronique à balayage de la tranche d'un coupon montrant la formation, sur TiN, d'une couche de germination de cuivre, estimée à 10 nm environ, obtenue à partir d'un film d'aryldiazonium électro-greffé.
- La Figure 29 : Cliché en microscopie électronique à balayage de la tranche d'un coupon montrant le remplissage, par du cuivre, de tranchées de 0,22 µm portant une couche de germination préalablement obtenue par électro-greffage d'un aryldiazonium métallisé par du palladium.
- La Figure 30 : Cliché macroscopique d'une lame plane de silicium portant une couche de SiO2 de 400 nm et une couche de TiN de 10 nm, portant une couche de cuivre obtenue par électro-greffage à partir d'une solution de 4-VP et de précurseurs de cuivre dans la DMF. La surface de TiN a été rayé jusqu'à la silice, et on n'observe de dépôt que sur la partie ayant trempé dans le bain d'électro-greffage et qui était connectée via le TiN.

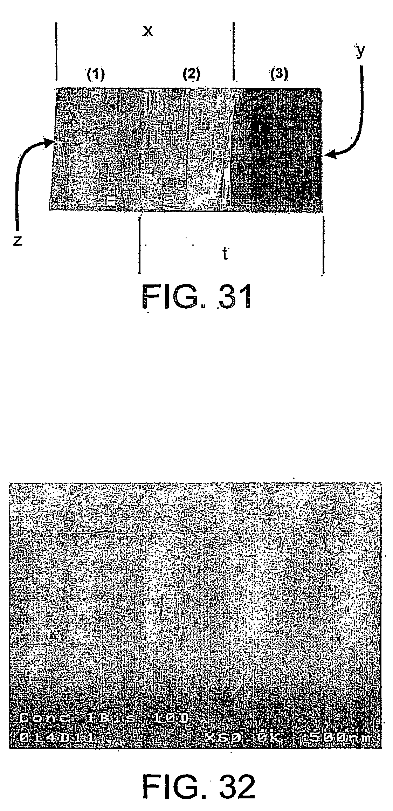

- La Figure 31 : Cliché d'un coupon structuré après couche de germination obtenue par électro-greffage de 4-VP et ECD : (1) zone avec couche de germination ; (2) zone avec couche de germination + ECD ; (3) zone avec barrière seule.
- La Figure 32 : Cliché en microscopie électronique à balayage de la tranche d'un coupon montrant le remplissage, par du cuivre, de tranchées de 0,22 µm portant une couche de germination préalablement obtenue par électro-greffage à partir d'une solution de 4-VP et de précurseurs de cuivre.

### EXEMPLES

### Exemple n°1 : Remplissage d'un film ultra-mince de poly-4-vinyl pyridine (P4VP) électro-greffé sur or par des précurseurs ioniques (non conforme à l'invention revendiquée mais utile à sa compréhension).

Cet exemple permet de démontrer que la présente invention permet de préserver et d'exploiter les propriétés de complexation d'un film de poly-4-vinyl pyridine (P4VP), même lorsque celui-ci est de très faible épaisseur, en l'occurrence il peut avoir une épaisseur de l'ordre de 30 nm.

Cet exemple permet d'illustrer, de façon générique, le fait qu'un film organique ultra-mince peut être rempli avec des précurseurs métalliques sous forme ionique. On illustre également le fait que les propriétés complexantes du film sont un bon moyen de s'affranchir de la ré-expulsion spontanée des précurseurs hors du film lorsque celui-ci, une fois rempli et malgré les gradients de diffusion défavorables, est plongé dans une solution ne contenant pas de précurseurs.

On réalise tout d'abord sur une lame d'or - 5 →m d'or évaporé par effet Joule sur lame de microscope en verre, pré-traitée par un voile de chrome servant de primaire d'adhésion - un film électro-greffé de P4VP de 30 nm d'épaisseur en soumettant la surface d'or, plongée dans une solution à 40% en volume de 4-vinyl pyridine dans la DMF (Di-Méthyle Formamide), en présence de 5.10⁻² mol/l de TEAP (Tetra-Ethyle Ammonium Perchlorate), à 50 balayages voltammétriques de -0,7 à -2,9 V/(Ag⁺/Ag) à 200 mV/s. On utilise pour cela une contre-électrode en platine de grande surface. Ce film électrogreffé constitue le film organique au sens de la présente invention.

La lame ainsi traitée est rincée à la DMF puis séchée sous courant d'argon. On réalise son spectre Infra-Rouge en réflexion (IRRAS) : un grossissement de la zone située entre 1400 et 1700 cm⁻¹ montre la présence des pics caractéristiques des vibrations du cycle pyridine du polymère formé, et en particulier le pic vers 1605 cm⁻¹ (Figure 5a). La lame est ensuite trempée pendant 25 minutes dans une solution agitée de 10 g de sulfate de cuivre [CuSO₄, 5 H₂O] en tant que précurseur du matériau métallique (ici du cuivre) selon l'invention dans 200 ml d'eau désionisée pour l'insertion de ce précurseur au sein du film organique. Une des structures obtenues suivant cet exemple est représentée schématiquement sur la figure 4 où « g » indique les point de greffage du film sur la surface, Cu²⁺ le précurseur du matériau métallique, et h = 100 nm, l'épaisseur du film organique.

La lame est ensuite rapidement rincée avec quelques jets d'eau désionisée, puis séchée sous courant d'argon. Son spectre IRRAS est indiqué à la Figure 5b : on observe un dédoublement du pic caractéristique du cycle pyridine, avec apparition d'un pic complémentaire vers 1620 cm⁻¹. Ce nouveau pic est dû aux cycles pyridine quaternisés, cette quaternisation accompagnant la formation des complexes pyridine/Cu²⁺, puisqu'on observe le même dédoublement lorsque la P4VP est simplement quaternisée par traitement en milieu acide (Figure 5c). Il caractérise donc la complexation du cuivre par le film ultra-mince.

Le spectre IRRAS de la Figure 5b n'est pas modifié lorsque la lame est replongée dans une solution agitée d'eau désionisée à température ambiante pendant 25 minutes, sortie puis séchée par un courant d'argon. Ceci montre que les propriétés complexantes du film électro-greffé permettent d'éviter que les précurseurs ne ressortent du film lorsqu'il est replongé dans une solution qui ne contient pas de précurseurs.

Les inventeurs ont noté une décomplexation et une expulsion des ions cuivriques hors du film lorsque celui-ci est trempé soit dans une solution d'eau désionisée chaude (80°C), soit dans une solution d'hydroxyde d'ammonium. Les Figures 6 montrent en effet les spectres IRRAS d'une lame obtenue selon le protocole ci-dessus (Figure 6a), chargée en ions cuivriques selon le protocole ci-dessus (Figure 6b), puis traitée pendant 5 minutes dans une solution d'hydroxyde d'ammonium à 9 mol/l (Figure 6c). Des spectres analogues sont obtenus en traitant le film chargé en ions cuivriques par de l'eau bouillante pendant 25 minutes.

### Exemple n°2 : Electro-réduction de précurseurs métalliques au sein un film ultra-mince de poly-4-vinyl pyridine (P4VP) électro-greffé sur inox 316L (non conforme à l'invention revendiquée mais utile à sa compréhension).

Dans cet exemple, on illustre la réduction d'ions précurseurs préalablement piégés dans un film de polymère électro-greffé sur une surface métallique. On parvient ainsi à former, au sein du film électro-greffé, un film de métal, identifiable par spectroscopie de photoélectrons. La réduction est réalisée par électrolyse, dans une solution qui contient des ions précurseurs. Ceci illustre également le fait que l'on peut obtenir un film métallique au sein d'un film organique selon un mode de réalisation où le piégeage des précurseurs et la formation du film métallique ont lieu dans un bain unique.

Selon le même protocole que celui de l'exemple n°1 précédent, on réalise un film mince de P4VP sur trois lames d'inox 316L (lames (a), (b), (c)) de 1 x 10 cm, préalablement dégraissées par traitement sous ultrasons dans le dichloro-méthane. Les lames sont rincées à la DMF, séchées sous courant d'argon, puis trempées pendant 25 minutes dans une solution de 10 g de sulfate de cuivre [CuSO₄, 5 H₂O] dans 200 ml d'eau désionisée. Une contre-électrode de platine étant également plongée dans la solution, on soumet chacune de ces lames, l'une après l'autre, à une polarisation cathodique à un potentiel constant de -1,15 V/ECS pendant un temps T = 50 (lame (a)), 120 (lame (b)) et 240 (lame c)) secondes.

Les lames sont ensuite rincées à la DMF sous ultrasons pendant 2 minutes, séchées sous courant d'argon. Elles sont représentées sur photographie de la Figure 7.

Elles sont analysées en spectroscopie de photoélectrons. Les résultats de cette analyse sont représentés sur la Figure 8. Sur cette figure le spectre de la lame (a) est celui obtenu, dans la zone des orbitales 2p du cuivre, juste après l'étape de trempage dans la solution d'ions cuivriques, c'est à dire avant réduction des précurseurs dans le film de P4VP. On y observe, respectivement vers 938 et 958 eV, les raies 2p^{1/2} et 2p^{3/2} des ions cuivriques. Le spectre (b) est celui obtenu après une polarisation de 50 s, qui montre, après rinçage, essentiellement les ions cuivriques, et un très léger épaulement vers 932 eV, caractéristique des niveaux 2p^{3/2} du cuivre métallique. Les spectres (c) et (d) sont ceux obtenus respectivement après un dépôt du matériau de renfort suite à une polarisatior de 120 et 240 s : ils montrent nettement la disparition des pics des niveaux 2p des ions cuivriques, au profit de ceux des niveaux 2p du cuivre métallique, montrant la formation du dépôt métallique.

Comme le montrent les images de la Figure 7, on observe nettement la formation d'un dépôt de cuivre sur la surface pour les lames ayant subi une polarisation suffisante. Ce dépôt est adhérent. Il résiste en particulier à un rinçage de 2 minutes sous ultrasons dans la DMF.

### Exemple n°3 : Fixation directe d'un film de germination à partir d'un film organique d'un polymère déposé au trempé (non conforme à l'invention revendiquée mais utile à sa compréhension).

Cet exemple illustre la formation d'un film métallique à partir de précurseurs du matériau métallique piégés dans un film de polymère simplement déposé sur une surface métallique par « spin-coating ». Le polymère résiste au bain de trempage ce qui permet de piéger les précurseurs grâce au fait qu'il n'est que gonflé par ce bain, mais n'y est pas soluble.

Dans cet exemple, on réalise le dépôt du film organique par « spin-coating » à partir d'une solution à 5% en masse de P4VP dans la DMF, de manière à obtenir un dépôt de P4VP d'environ 100 nm sur une lame d'or analogue à celle de l'exemple n°1. La lame ainsi traitée est séchée au sèche-cheveux, puis trempée pendant 25 minutes dans une solution contenant 10 g de sulfate de cuivre dans 200 ml d'eau désionisée pou l'insertion du précurseur du matériau métallique. La lame est ensuite rincée à l'eau désionisée, puis plongée dans un bain d'électrolyse contenant 2 g de sulfate de cuivre et 3 g de NaCl dans 500 ml d'eau désionisée pour la transformation du précurseur du matériau métallique en ledit matériau métallique, ici du cuivre. Elle est ensuite soumise à 10 balayages voltammétriques entre 0 et -0,5 V/ECS à 200 mV/s, sortie, rincée à l'eau désionisée, puis décomplexée des ions cuivriques en excès par un trempage pendant 20 minutes dans une solution aqueuse d'ammoniac à 10%, et finalement rincée par trempage pendant 2h30 dans une solution de DMF.

Les Figures 9A et 9B montrent les spectres infrarouge des lames obtenues aux différentes étapes ci-dessus, dans la zone des modes de vibration du cycle pyridine du polymère. Les spectres (a) et (d) (Figures 9A et 9B) sont identiques, et correspondent au film de P4VP déposé sur la surface d'or par « spin-coating ». La bande à 1600 cm⁻¹ est caractéristique du groupement pyridine. Les spectres (b) et (d) (Figures 9a et 9B) sont obtenus après trempage de la lame recouverte du film de P4VP dans la solution concentrée en cuivre : on observe un dédoublement du pic précédent, avec apparition d'un second pic vers 1620 cm⁻¹, caractéristique du complexe formé entre les cycles pyridine et les ions cuivriques. Le spectre (c) (Figure 9A) est celui obtenu après réduction des ions cuivriques selon le protocole ci-dessus : on observe nettement les bandes caractéristiques du film de P4VP tel que déposé à l'origine, à la différence que ce film a résisté au rinçage à la DMF pendant 2h30. Un examen visuel de la lame montre qu'on a un dépôt de cuivre. Le spectre (f) (Figure 9B) est celui obtenu en effectuant directement les étapes de rinçage de la lame après trempage dans la solution contenant les précurseurs, sans procéder à la réduction : on observe que la lame a été quasiment complètement lavée.

La P4VP étant donc lavée par une solution de DMF sous ultrasons, ces résultats montrent que la réduction des précurseurs métalliques en ledit matériau métallique a bien eu lieu dans le film, puisqu'elle a pu contribuer à la rendre insoluble et éviter que le film soit lavée par un traitement ultérieur dans une solution de rinçage, même lorsque celle-ci est un bon solvant du film organique initial.

### Exemple n°4 Chute ohmique le long d'une surface de nitrure de titane (TiN) (non conforme à l'invention revendiquée mais utile à sa compréhension).

Dans cet exemple, on illustre ce que peut représenter une surface qui ne constitue pas une équipotentielle, et présente donc une topologie de chute ohmique. Les exemples qui suivront permettront d'illustrer que l'on parvient à réaliser des films métalliques uniformes, voire conformes, sur de telles surfaces, alors que cela est impossible selon les techniques de l'art antérieur. L'illustration porte sur une lame de nitrure de titane (TiN), semi-conductrice.

On établit un contact électrique à l'aide d'une pince crocodile à une extrémité d'une lame de silicium de 2 x 10 cm, recouverte, par dépôt chimique en phase vapeur (CVD, Chemical Vapor Deposition, en anglais), d'une couche de TiN de 20 nm d'épaisseur environ. Un second contact est pris de la même façon à des distances croissantes du premier, de 5 à 45 mm

On mesure l'impédance entre ces deux points, dans la gamme de fréquences comprise entre 0,5 Hz et 100 kHz (Figure 10) : respectivement 5 mm → 666Ω ; 25 mm → 154CQ ; 30 mm → 1620Ω ; et 45 mm → 2240Q. On observe que l'impédance du circuit est quasiment constante sur toute la gamme de fréquences, et de plus en plus élevée à mesure que les deux points de contact sur le nitrure de titane sont éloignés. Le tracé de l'impédance, mesurée sur les plateaux de la Figure 10, en fonction de la distance entre les deux points révèle que la résistance est de l'ordre de 400 Ohms/cm.

Ceci situe la chute ohmique maximale entre le bord et le centre d'une plaquette de circuit imprimé (« water ») de 300 mm à 600 mV pour un courant de 100 µA, ce qui - comme on le verra - reste acceptable pour obtenir des revêtements conformes grâce par exemple à l'électro-greffage selon le procédé de la présente invention.

### Exemple n°5 : Greffage d'un film organique sur TiN via l'électro-réduction de sels de diazonium (non conforme à l'invention revendiquée mais utile à sa compréhension).

Cet exemple illustre l'obtention d'un film organique, par électro-greffage de sels de diazonium, sur nitrure de titane, matériau utilisé dans la confection de couches barrières dans les procédés Damascène et dual Damascène en micro-électronique. Cette voie de synthèse esL commode, car les sels de diazonium peuvent être diversement pré-fonctionnalisés, notamment par des groupements fonctionnels complexants, de façon à produire des couches de précurseurs de films métalliques. De plus, le film organique obtenu est très mince (épaisseur inférieure à 10 nm), ce qui rend ce mode de réalisation très intéressant pour la réalisation de couches de germination selon l'invention dans l'application micro-électronique pour des gravures très fines de 100 nm ou moins : certes le film organique obtenu ici ne comporte pas de groupements complexants susceptibles de complexer des précurseurs métalliques à l'analogue des films de P4VP des exemples précédents, mais on sait que cela peut être facilement obtenu en pré-fonctionnalisant au départ le sel de diazonium avec les groupements adéquats (à titre d'information, on sait par exemple réaliser la réduction des groupements nitro de films de 4NPD électro-greffés en groupements amines (NH₂) par traitement chimique : ces groupements amines sont de très bons complexants pour divers précurseurs métalliques, et notamment des ions cuivriques). Cet exemple montre cependant que l'électro-greffage de sels de diazonium constitue un bon candidat pour la réalisation de films organiques très adhérents présentant des groupements fonctionnels à façon.

Une lame de TiN identique à celle de l'exemple n°4 précédent, une contre-électrode de platine et une électrode de référence (Ag⁺/Ag) sont trempées dans une solution à 5.10⁻³ mol/l de tétrafluoroborate de 4-nitro phényle diazonium (4NPD) dans l'acétonitrile à 5.10⁻² mol/l en TEAP. On effectue sur la lame de TiN 3 balayages voltammétriques de + 1,15 à - 1,52 V/(Ag⁺/Ag). La lame est ensuite rincée pendant 2 minutes sous ultrasons dans l'acétonitrile, puis séchée sous courant d'argon.

La région N1s du spectre XPS de la lame ainsi traitée est présentée sur la Figure 11, en comparaison de celui, dans la même gamme d'énergie, de la lame de TiN avant traitement. On observe à 397 eV le pic des atomes d'azote du TiN et, sur la lame traitée, les pics caractéristiques à 406,5 eV des groupements nitro (NO₂) des radicaux 4-nitro phényle greffés sur la surface. Dans le même temps, on observe un abaissement de l'intensité du pic à 397 eV sur la lame traitée, ce qui montre la formation d'un film sur cette surface, d'une épaisseur toutefois inférieure à 10 nm environ (qui est la profondeur de pénétration de l'XPS) et suggère la formation d'un film très mince. Ceci est confirmé par la comparaison, avant et après électro-greffage, des spectres XPS des lames dans la région des orbitales 2p du titane (Figure 12), où l'on constate une très forte diminution des pics du titane après traitement, pourtant toujours présents.

Le pic vers 400 eV est connu dans la littérature portant sur l'électro-greffage de sels de diazonium, et correspondrait à la formation de groupements diazo -N=N- issus de copulations parasites entre des radicaux produits par l'électro-réduction des sels de diazonium et des groupements déjà greffés.

### Exemple n°6 : Greffage d'un film organique sur TiN par trempage dans une solution contenant des sels de diazonium (non conforme à l'invention revendiquée mais utile à sa compréhension).

Cet exemple illustre la possibilité d'utiliser les sels de diazonium pour faire un greffage chimique direct d'une couche organique sur des couches barrières par simple trempage (« dip coating »). Les sels de diazonium étant facilement pré-fonctionnalisables, cet exemple montre comment on peut appliquer la présente invention via une succession d'étapes sans courant, c'est à dire en processus autocatalytique (« electroless ».

Une lame de TiN identique à celle de l'exemple n°5 précédent est mise à tremper dans une solution de tétrafluoroborate de 4-nitro-phényl diazonium (4NPD) à 10⁻³ mol/l dans l'acétonitrile pendant 24 heures. La lame est ensuite sortie, rincée par trempage rapide dans l'acétonitrile, puis 2 minutes dans l'eau désionisée sous ultrasons puis séchée sous courant d'argon.

La Figure 13 montre la région N1s du spectre XPS de la surface ainsi traitée, en comparaison d'une part de la lame de TiN initiale, et d'autre part du film organique obtenu selon l'exemple n°5. On observe, respectivement vers 400,5 eV et 406,5 eV, les pics caractéristiques d'une couche de radicaux 4-nitro phényles greffés sur la surface. On observe que le film organique ainsi obtenu est beaucoup moins épais que celui de l'exemple n°5.

Ce résultat indique donc que le dépôt autocatalytique de sels de diazonium peut constituer une voie intéressante d'accès vers les épaisseurs ultra faibles, d'usage d'autant plus aisé que la fixation des radicaux associés au sel de diazonium initial est spontanée.

### Exemple n°7 Electro-greffage d'un film de P4VP sur TiNSi (non conforme à l'invention revendiquée mais utile à sa compréhension).

Cet exemple permet d'étendre le mode de réalisation qui a été vu dans l'exemple n°1 précédent au cas de la surface d'une couche barrière telle qu'utilisée dans les procédés Damascène et dual Damascène en micro-électronique. La couche barrière utilisées ici est dénommée TiNSi, et correspond à du nitrure de titane légèrement dopé au silicium.

Une lame de silicium, recouverte, par CVD, d'une couche de 20 nm de TiNSi, plongée dans une solution à 40% en volume de 4-vinyl pyridine dans la di-méthyle formamide (DMF), en présente de 5.10⁻² mol/l de perchlorate de tétra-éthyle ammonium (TEAP), est reliée à un potentiostat en tant qu'électrode de travail. Le circuit est complété avec une contre-électrode en platine et une électrode de référence basée sur le couple (Ag⁺/Ag) (AgClO₄/TEAP). L'électrode de TiNSi est soumise à 25 balayages voltammétriques de - 0,6 à - 2,9 V/(Ag'/Ag; à 200 mV/s. La lame est rincée à la DMF puis séchée sous courant d'argon.

La Figure 14 montre la région N1s du spectre XPS de la lame ainsi traitée, en comparaison de celui de la lame de TiNSi de départ. On observe nettement l'apparition d'un pic vers 400 eV, caractéristique des atomes d'azote des groupements pyridine de la P4VP, ainsi qu'une diminution du pic dû aux atomes d'azote du TiNSi de la surface du substrat. La présence de ce dernier pic révèle que le film de P4VP obtenu est d'une épaisseur inférieure à 10 nm.

### Exemple n°8 : Formation d'un film de germination d'un matériau métallique au sein d'un film de P4VP électro-greffé sur TiN (Protocole 1) (non conforme à l'invention revendiquée mais utile à sa compréhension).

Cet exemple permet d'illustrer la formation d'un film métallique uniforme selon l'invention sur une surface semi-conductrice, et ce malgré le caractère non équipotentiel de la surface. Le protocole utilisé ici (appelé Protocole 1) est comparable à celui utilisé sur métal dans l'exemple n°2 précédent : un bain unique sert pour le remplissage du film avec les précurseurs métalliques et pour la réduction de ces précurseurs au sein du film.

Sur une lame de TiN de l'exemple n°4 précédent, on réalise - par électro-greffage - le dépôt d'un film de P4VP de 30 nm environ, selon un protocole analogue à celui de l'exemple n°7.

La lame de TiN ainsi recouverte de P4VP, reliée à un potentiostat en tant qu'électrode de travail, est d'abord trempée sans courant pendant 25 minutes dans une solution aqueuse contenant 11 g de sulfate de cuivre [CuSO₄, 5 H₂O], 3 g d'acide sulfurique H₂SO₄ (d=1.38), 6 mg de chlorure de sodium NaCl, le tout dans 50 ml d'eau désionisée à 18 MΩ. Une contre-électrode de platine et une électrode de référence au calomel saturée son rajoutés au montage. A la fin de la phase de trempage, la lame, qui n'est pas sortie, est polarisée pendant 2 minutes à un potentiel de - 0,5 V/ECS. La lame est ensuite sortie, rincée à l'eau désionisée puis séchée sous un courant d'argon.

La région des orbitales 2p du cuivre du spectre XPS de la lame est représentée sur la partie supérieure de la Figure 15, et compare les spectres obtenus en incidence normale et rasante. L'incidence normale permet d'obtenir des informations sur toute la profondeur de sonde de l'XPS (soit environ 10 nm), alors qu l'incidence rasante permet de restreindre à une « peau » plus fine, et donne donc des informations sur l'extrême surface de l'échantillon.

Les pics caractéristiques des ions cuivriques sont observés vers 943 et 964 eV, respectivement, alors que ceux dus au cuivre métallique sont obtenus vers 933 et 954 eV, respectivement.

On observe ainsi (Figure 15-1, incidence normale) la formation de cuivre métallique au sein du film de P4VP, conformément à l'invention. Une inspection visuelle révèle un film métallique d'une grande uniformité, et ce malgré le fait que la surface de TiN ne constitue pas une équipotentielle, étant semi-conductrice. La Figure 16-1 représente la région N1s du spectre XPS : on observe, en incidence normale, la présence de 3 pics à 397, 399,5 et 402 eV, et correspondant respectivement aux atomes d'azote des cycles pyridines liés au cuivre métallique (réduit), aux azotes des cycles pyridines libres et aux azotes des cycles pyridine liés aux ions cuivriques. La disparition du pic à 397 eV sur le spectre obtenu en incidence rasante sur la Figure 16-1 montre que le cuivre métallique est présent au fond du film mais pas en surface.

### Exemple n°9 : Formation d'un film de germination métallique au sein d'un film de P4VP électro-greffé sur TiN (Protocole 2) (non conforme à l'invention revendiquée mais utile à sa compréhension).

Cet exemple utilise une lame de TiN recouverte de P4VP selon le même protocole que celui de l'exemple n°8. Il illustre un second protocole de remplissage/réduction (appelé Protocole 2) dans lequel on utilise deux bains successifs : un bain servant au remplissage du film par les précurseurs métalliques, puis un autre bain servant à la réduction des précurseurs dans le film, et dont la particularité est de ne pas contenir lesdits précurseurs. On observe que le film métallique obtenu contient moins de précurseurs que dans le cas précédent.

La lame de TiN, recouverte de P4VP comme dans l'exemple n°8, est trempée pendant 25 minutes dans une solution aqueuse contenant 11 g de sulfate de cuivre [CuSO₄, 5 H₂O], 3 g d'acide sulfurique H₂SO₄ (d =1,38), 6mg de chlorure de sodium NaCl, le tout dans 50 ml d'eau désionisée à 18 MΩ.

Elle est ensuite sortie, brièvement rincée à l'eau désionisée, reliée à un potentiostat en tant qu'électrode de travail, puis trempée dans une solution contenant 3 g d'acide sulfurique H₂SO₄ (d=1.38), 6 mg de chlorure de sodium NaCl, le tout dans 50 ml d'eau désionisée à 18 MΩ. Une contre-électrode de platine et une électrode de référence au calomel saturée son rajoutés au montage. La lame est polarisée pendant 2 minutes à un potentiel de - 0,5 V/ECS, sortie, rincée à l'eau désionisée puis séchée sous un courant d'argon.

La région des orbitales 2p du cuivre du spectre XPS de la lame est représentée sur la partie inférieure de la Figure 15, et compare les spectres obtenus en incidence normale et rasante. L'incidence normale permet d'obtenir des informations sur toute la profondeur de sonde de l'XPS (soit environ 10 nm), alors qu l'incidence rasante permet de restreindre à une « peau » plus fine, et donne donc des informations sur l'extrême surface de l'échantillon.

Les pics caractéristiques des ions cuivriques sont observés vers 943 et 964 eV, respectivement, alors que ceux dus au cuivre métallique sont obtenus vers 933 et 954 eV, respectivement.

On observe ainsi (Figure 15-2, incidence normale) la formation de cuivre métallique au sein du film de P4VP, conformément à l'invention. Une inspection visuelle révèle un film métallique d'une grande uniformité, et ce malgré le fait que la surface de TiN ne constitue pas une équipotentielle, étant semi-conductrice. La comparaison des spectres obtenus en incidence rasante pour les Protocoles 1 (exemple n°8) et 2 (présent exemple) montre qu'il y a moins d'ions cuivriques dans le cas du Protocole n°2 que dans celui du Protocole n°1. Ceci illustre un des modes préférés de réalisation de l'invention, où le remplissage par les précurseurs et la réduction sont faits dans des bains différents, ce qui permet d'éviter le réapprovisionnement du film par les précurseurs lors de la réduction. La Figure 16-2 représente la région N1s du spectre XPS : on observe, en incidence normale, la présence de 2 pics à 397 et 399,5, et correspondant respectivement aux atomes d'azote des cycles pyridines liés au cuivre métallique (réduit) et aux azotes des cycles pyridines libres. Contrairement au Protocole 1 (exemple n°8), on n'observe pas de pic correspondant aux azotes liés aux ions cuivriques vers 402 eV, ce qui laisse supposer que ce pic, sur la Figure 16-1 (exemple n°8) était effectivement dû à des ions cuivriques insérés lors de la réduction, en réapprovisionnement du film au cours de la réduction. La disparition du pic à 397 eV sur le spectre obtenu en incidence rasante sur la Figure 16-1 montre également que le cuivre métallique est présent au fond du film mais pas en surface.

Comme pour l'exemple n°8, on observe que le protocole de potentiel utilisé ici pour la réduction n'est pas suffisant pour réduire tous les ions cuivriques. Il suffit pour cela d'augmenter le potentiel de réduction et/ou le temps d'hydrolyse. Le choix du protocole de potentiel du présent exemple a permis toutefois d'illustrer de façon semi quantitative l'effet des Protocoles 1 et 2 sur l'alimentation des films par les ions précurseurs.

### Exemple n'10 : Obtention d'un film organique conforme sur une gravure à 1 µm par trempage dans une solution contenant des sels de diazonium.

La présente invention repose sur le fait qu'il est envisageable de réaliser des revêtements organiques conformes de façon plus aisée que des couches métalliques conformes, et que l'on peut exploiter ce fait pour faire des couches métalliques conformes là où cela est d'ordinaire impossible ou très difficile.

Cet exemple illustre la conformité de haute qualité qui peut être obtenue avec l'un des modes de réalisation de l'invention, où l'on effectue le greffage chimique de sels de diazonium sur une surface semi-conductrice portant une gravure en réseau à 1 →m.

Une lame de TiN vierge du même type que celle des exemples précédents est utilisée pour cet exemple. A la différence - toutefois - des exemples précédents, cette lame porte une gravure réalisée grâce aux procédés habituels de la micro-électronique. La gravure est constituée par un ensemble de lignes parallèles de 1 →m de large, espacées de 1 →m, et profondes de 400 nm environ (voir figure 17 annexée).

La lame est traitée selon le même protocole que celui de l'exemple n°6. Elle est ensuite analysée par microscopie à force atomique (AFM, Nanoscope III, vitesse de scan 0,2 Hz), de façon à détecter les changements de profils (Figure 17). On observe que la largeur de la tranchée est passée de 1008 nm à 966 nm, ce qui - compte tenu de la précision de mesure à cette échelle, qui est de l'ordre de 15 nm - montre la formation d'une couche conforme d'environ 34 ± 15 nm.

On observe, dans le même temps, que la profondeur de la tranchée est restée identique, à la précision de la mesure, ce qui assure d'un dépôt conforme, même au fond de la tranchée.

### Exemple n°11 : Obtention d'un film organique conforme sur une gravure à 3 µm par électro-greffage d'un film de P4VP.

Cet exemple, qui complète l'exemple n°10, permet d'illustrer la conformité qui peut être obtenue grâce à des films de polymères électro-greffés selon le procédé de la présente invention.

Une lame de TiN comparable, tant du point de vue de la composition que de la topologie de gravure, à celle de l'exemple précédent est utilisée dans le présent exemple. La largeur de gravure est toutefois de 3 →m, ce qui indique des tranchées de 3 →m de large et espacées de 3 →m (la profondeur étant toujours égale à 400 nm)(Figure 18).

La lame est traitée selon un protocole d'électro-greffage comparable à celui de l'exemple n°7, où l'on a rajouté de la divinyl benzène (DVB) à 10% en poids, et utilisé 20 balayages jusqu'à un potentiel d'arrêt de - 3,2 V/(Ag⁺/Ag). La lame ainsi traitée est examinée avec un AFM, selon le même mode que dans l'exemple n°10.

On observe (Figure 18) que la largeur des tranchées est passée de 3050 ± 15 nm à 2780 ± 15 nm, soit une épaisseur de film sur chaque paroi de l'ordre de 135 ± 15 nm. Dans le même temps, on constate que la profondeur de la tranchée reste la même, à la précision de la mesure, ce qui prouve qu'on a bien réalisé un revêtement conforme grâce au film électro-greffé.

Des images AFM (respectivement en module et en phase) de zones plus larges de la surface ainsi traitée, on montré que le résultat est obtenu de façon reproductible sur de grandes échelles.

### Exemple n°12 : Obtention d'un film organique conforme sur une gravure à 1 µm par électro-greffage d'un film de P4VP.

Le même mode opératoire que celui de l'exemple n°11 est appliqué ici sur une gravure à 1 →m, avec formation d'un film de P4VP conforme. On n'utilise que 15 balayages voltammétriques dans une solution sans DVB.

Les profils obtenus sont présentés à la Figure 19 annexée. On observe que le profil obtenu a une forme « en V », caractéristique des profils obtenus lorsque la gravure est de taille comparable à l'échancrure de la pointe du microscope AFM utilisé pour la mesure : ceci conduit à une image où la forme effective du profil est convoluée par la géométrie de la pointe, qui est inconnue. Ceci permet néanmoins d'affirmer que la profondeur apparemment mesurée sur les profils avec film de P4VP est une borne inférieure.

Malgré cela, on mesure une profondeur après électro-greffage qui est de 420 ± 15 nm, c'est-à-dire la même que celle avant électro-greffage. Les variations sur la largeur de la tranchée montrent la formation d'un film de 252 ± 15 nm, conforme à la topologie du substrat, même à grande échelle sur la surface.

### Exemple n°13 : Obtention d'un film organique conforme sur une gravure à 300 nm par électro-greffage d'un film de P4VP.

Cet exemple illustre l'obtention d'un film de P4VP conforme, remplis de précurseurs métalliques, sur une gravure de 300 nm (c'est à dire comportant des tranchées de 300 nm de large et espacées de 300 nm, la profondeur étant toujours de 400 nm). Il montre donc les potentialités de l'invention sur des surfaces présentant de forts ratios d'aspect. Il montre également les potentialités de l'électro-greffage comme mode de réalisation pour travailler à des échelles compatibles avec les finesses de gravure actuelles et à venir dans le domaine de la micro-électronique.

Les lames de TiN sont comparables à celles utilisées précédemment. Le mode opératoire d'électro-greffage est du même type que celui utilisé pour l'exemple n°7 (avec seulement 10 balayages voltammétriques). Les films de P4VP obtenus sont remplis avec des ions cuivriques selon le même mode opératoire que celui utilisé dans les exemples 8 et 9. La réduction des précurseurs n'est volontairement pas effectuée, de manière à obtenir des films remplis de sulfate de cuivre, en tant que précurseur du matériau métallique, donc isolants. Ceci permet de faciliter la mise en évidence de la formation de la couche par microscopie électronique à balayage (MEB), tel qu'illustré sur les Figures 20 et 21 annexées sur la tranche de la lame qui a été cassée de façon à ce que le bord de fracture croise la direction des tranchées.

Ces images sont réalisées à une tension d'accélération de 20 kV, c'est-à-dire à une tension élevée à laquelle le film organique n'est pas forcément visible. A cette tension, un revêtement isolant conduit cependant à un contraste très clair, contrairement aux zones suffisamment conductrices qui conduisent à un contraste plus foncé.

Les Figures 20 et 21 montrent la topologie obtenue, sous deux mises au point différentes, et illustrent la conformité obtenue tant sur les parois qu'au fond des tranchées.

On observe une nette différence de contraste entre la surface d'une part, le corps des tranchées (silicium) d'autre part, et finalement la couche barrière, bien visible sur la Figure 20 et couvrant l'ensemble de la topologie.

La Figure 21 est un grossissement de la zone de la tranche de la lame, où l'on voit nettement une différence de contraste entre la couche barrière (foncée), et une couche supérieure (claire), très conforme, et due au film de P4VP remplie du sel des précurseurs métalliques.

On note au passage le contraste plus foncé de la surface restant sous le film, ce qui montre que le film ayant un contraste plus clair n'est pas la couche barrière, mais bien le film de germination de la présente invention.

### Exemple n°14 : Obtention d'un film organique conforme sur une gravure à 300 nm par électro-greffage de sels de diazonium.

Cet exemple illustre l'obtention d'un film de organique ultra-conforme obtenu par électro-greffage d'un sel de diazonium sur une surface de silicium gravée (gravure 200 nm, pas de 300 nm, profondeur 400 nm), recouverte d'une couche barrière de TiN de 10 nm d'épaisseur et conforme à la gravure. Il montre donc la très grande conformité qui peut être atteinte grâce à des films organiques électro-greffés, notamment sur des surfaces présentant de forts ratios d'aspect, et illustre la topologie sur ou dans laquelle les films métalliques de germination peuvent être créés. Il montre également les potentialités de l'électro-greffage comme mode de réalisation pour travailler à des échelles compatibles avec les finesses de gravure actuelles et à venir dans le domaine de la micro-électronique.

On réalise l'électro-greffage d'un film organique sur des lames de TiN gravées identiques à celles utilisées dans l'exemple précédent selon le protocole suivant : la lame est plongée dans une solution à 5.10⁻³ mol/l de tétrafluoroborate de 4-nitrophényl diazonium dans une solution à 5.10⁻² mol/l de TEAP dans l'acétonitrile. On applique alors à cette surface, utilisée comme électrode de référence, 7 balayages voltammétriques à 20 mV/s, entre + 0,25 et - 2,00 V/(Ag⁺/Ag), en présence d'une lame d'or connectée en contre-électrode.

La lame ainsi traitée est rincée pendant 2 minutes dans l'acétone sous ultra-sons, puis séchée à l'argon. Elle est ensuite fracturée, de telle façon que la fracture croise perpendiculairement les lignes de gravure. La tranche ainsi obtenue est analysée au microscope électronique à balayage, tel qu'illustré sur les Figures 22 et 23.

La Figure 22 montre nettement le substrat de silicium muni de sa fine couche barrière de nitrure de titane (qui apparaît en clair), revêtu de la couche organique très conforme obtenue par le procédé, tant sur les parois qu'au fond des tranchées. La Figure 23 complète cette analyse, en révélant que l'épaisseur du revêtement organique obtenu est de 46 nm sur les parois, 41 nm en haut des gravures et 39 nm au fond des gravures. Ces résultats montrent en fait un revêtement complètement et rigoureusement homogène et conforme à la précision des mesures par MEB, qui est estimée à 5 nm.

La Figure 24 montre l'effet produit par le même traitement sur une gravure de TiN plus fine de 0,12 →m : on observe une conformité tojours excellente, même si les épaisseurs de film réalisées - toujours de 40 nm environ - sont ici mal adaptées pour la finesse de la gravure. Or, comme on l'a vu dans la partie descriptive, il est aisé de piloter l'épaisseur d'un film organique issu de sels de diazonium, notamment grâce au nombre de balayages, au potentiel final du balayage ou à la concentration en sel précurseur. La leçon supplémentaire de la Figure 24 est néanmoins que l'électro-greffage de sels de diazonium à partir de solutions organiques permet un mouillage très efficace, même aux très forts ratios d'aspect, ce qui est probablement une des raisons contribuant à l'efficacité et à la flexibilité du procédé.

### Exemple n°15 : Obtention d'un film uniforme de P4VP sur nitrure de tantale (non conforme à l'invention revendiquée mais utile à sa compréhension).

Cet exemple illustre l'obtention d'un film métallique (Cu) de germination obtenu à partir d'un film organique P4VP homogène obtenu par électro-greffage sur une surface plane de nitrure de tantale (TaN), recouverte de sa couche d'oxyde. Cet exemple illustre la versatilité de l'électro-greffage, capable de s'adapter à des surfaces présentant des couches d'oxyde, pour peu qu'elles demeurent au moins semiconductrices de l'électricité.

On utilise comme électrode de travail une lame de silicium recouverte d'une couche de 1 µm d'oxyde silicium (SiO₂), d'une couche barrière de nitrure de tantale enrichie en surface en tantale (plus conducteur), l'ensemble de la couche barrière ayant une épaisseur de l'ordre de 25 nm.

L'électrode est plongée dans une solution à 40% en 4VP et 5.10⁻² mol/l de TEAP dans la DMF. On lui applique 60 balayages voltammétriques à 200 mV/s entre - 0,9 et - 4,0 V/(Ag⁺/Ag), avec une contre-électrode en graphite. La surface ainsi traitée est rincée pendant 2 minutes aux ultra-sons dans l'acétone, puis plongée, pendant 6 minutes à température ambiante, dans une solution d'électroplastie identique à celle utilisée dans l'exemple n°8. Passé ce délai, la lame est marcottée en conditions potentiostatiques à 0,5 V/ECS pendant 6 minutes.

La lame est finalement rincée pendant 2 minutes à l'eau désionisée sous ultra-sons, puis pendant 2 minutes à l'acétone sous ultra-sons.

La Figure 25 montre la tranche obtenue après fracture de la lame traitée. On distinue nettement, du bas vers le haut de la Figure, le silicium, la couche de SiO₂ de 1 →m, la très fine couche barrière mixte de TaN/Ta, et une couche de 278 nm. L'analyse de surface révèle qu'il s'agit bien d'une couche de P4VP marcottée (imprégnée) au cuivre métallique.

### Exemple n°16 : Croissance d'un film de cuivre sur une couche de germination selon l'invention réalisée sur une surface de TiN.

Cet exemple illustre, à l'instar de ce qui a été démontré dans l'exemple n°2 avec un film de P4VP électro-greffé sur métal, la croissance conforme d'un film métallique à partir d'une couche de germination obtenue selon l'invention. L'illustration porte ici sur la croissanced'un film de cuivre sur une surface de TiN utilisée comme barrière sur une surface de silicium gravée.

Une lame de silicium gravée recouverte d'une couche barrière de nitrure de titane (TiN) est recouverte de façon conforme d'un film organique par électro-greffage d'un sel de diazonium, le tétrafluoroborate de 4-nitrophényl diazonium, selon un protocole comparable à celui de l'exemple n°14, avec 10 balayages voltammétriques à 20 mV/s entre + 0,25 et - 2,5 V/(Ag⁺/Ag), avec une contre-électrode en graphite. La lame ainsi traitée est rincée pendant 2 minutes dans l'acétone sous ultra-sons, puis plongée pendant 6 minutes à tempéraure ambiante dans une solution d'électroplastie identique à celle de l'exemple n°8. Passé ce délai, la lame est polarisée en conditions potentiostatiques à - 0,5 V/ECS pendant 8 minutes, puis on lui applique trois balayages voltammétriques à 100 mV/s entre 0 et - 2,5 V/ECS. La lame est ensuite rincée pendant 2 minutes aux ultrasons dans l'eau désionisée, et enfin 2 minutes sous ultra-sons dans l'acétone, puis séchée à l'argon avant analyse au MEB.

La Figure 26 montre une vue au MEB, à un grossissement de 25.000, de la tranche obtenue en fracturant la lame selon une ligne de fracture perpendiculaire à la direction des gravures. On voit nettement, de bas en haut, le silicium du substrat, la couche barrière de TiN, la couche organique de diazo, très conforme à la gravure située au milieu de l'image, et une épaisse couche de cuivre (dont on voir une partie de la surface en haut à gauche de l'image) . On observe que l'interface entre la couche de germination organique et la couche de cuivre est parfaitement contrôlée, tout le long du profil, et notamment dans les zones de forte aspérité comme autour de la gravure.

La Figure 27 montre le résultat obtenu à un autre endroit du même échantillon, sur une zone possédant des gravures à 120 nm : on observe une croissance du cuivre depuis le fond des gravures, ce qui montre l'effet bénéfique apporté par la couche de germination obtenue selon l'invention.

### Exemples supplémentaires

### Exemple 17 :

Dans cet exemple particulier, on illustre la formation complète d'une couche de germination (« seed-layer ») complète par électro-greffage d'une couche organique, insertion de précurseurs de cuivre dans cette couche, réduction des précurseurs pour donner une couche de cuivre métallique de germination hyperconforme, et son utilisation pour le remplissage de tranchées dans une structure interconnectée de type Damascene.

Les substrats sont constitués d'éprouvettes de silicium de 2x4 cm² recouvertes d'une couche d'oxyde de silicium (diélectrique) et d'une couche de 10 nm de TiN MOCVD en tant que barrière à la diffusion du cuivre. Ces substrats sont structurés, et présentent des tranchées de 200 nm de large, espacées de 200 nm, et profondes de 400 nm environ. Aucun traitement spécifique de nettoyage ou de surface n'a été réalisé avant l'électrogreffage. Les expériences n'ont pas été réalisées dans des conditions de salle blanche.

On réalise un film électro-greffé à partir d'une solution de tétrafluoroborate d'aryl diazonium substitué par des groupements ammonium dans l'acétonitrile, en présence de perchlorate de tétraéthyl-ammonium (TEAP) comme électrolyte support.

L'électrogreffage est réalisé à potentiel imposé dans un montage à 3 électrodes. La surface de TiN est utilisée comme électrode de travail (connexion à l'aide d'une pince crocodile), la contre-électrode est une surface de graphite, l'électrode de référence est une électrode Ag⁺/Ag, connectées sur un potentiostat EGG modèle 283 (Princeton Applied Research).

Comme pour les exemples précédents, on observe que le film électro-greffé est hyperconforme à la surface d'origine, et d'une épaisseur homogène d'environ 40 nm.

Sur la couche électro-greffée, on réalise l'insertion de précurseurs métalliques de la façon suivante : les lames de TiN portant les films électro-greffés sont trempées dans une solution contenant des ions palladium (Pd(II)). On observe que le palladium s'insère dans les films grâce à la complexation par les groupements amine présents dans les films électro-greffés. Les lames sont ensuite traitées par du DiMéthyl Amino Borane (DMAB) pour réduire la palladium à l'état métallique au sein du film. Les lames ainsi traitées sont trempées dans une solution de cuivre electroless : on observe un dépôt uniforme d'une très fine couche de cuivre, catalysée par les agrégats métalliques de palladium présents au sein du film électro-greffé. Sur le substrat TiN structuré, une observation au microscope électronique à balayage à haute résolution permet de constater que la couche de cuivre est - tout comme la couche électro-greffée d'origine - hyperconforme, et d'une épaisseur homogène d'environ 20 nm (figure 28 annexée).

L'électrodéposition de cuivre est ensuite réalisée sur la couche de germination ainsi obtenue en utilisant une solution de sulfate de cuivre dans l'acide sulfurique, dans des conditions galvanostatiques à environ 7 mA/cm². On observe rapidement la formation d'un dépôt uniforme de cuivre sur la surface préalablement traitée.

Le substrat est ensuite clivé, et l'on examine la tranche de la zone fracturée au microscope électronique à balayage à haute résolution. On observe un parfait remplissage des tranchées par le cuivre avec très peu de trous (« voids »), la couche de germination ayant parfaitement joué son rôle (figure 29 annexée).

### Exemple 18 :

Dans cet exemple, on illustre la formation complète d'une couche de germination (« seed-layer ») par électro-greffage à partir d'un mélange de monomères vinyliques et de précurseurs de cuivre, dans un seul et même bain, et son utilisation pour le remplissage de tranchées dans une structure interconnectée de type Damascene.

Les substrats sont des coupons de silicium plans de 2 x 4 cm², recouvert d'une couche de 400 nm de SiO₂ et d'une couche de 10 nm de TiN obtenue par MOCVD. De même que précédemment, aucun traitement spécifique de nettoyage ou de surface n'a été réalisé avant l'électrogreffage. Les expériences n'ont pas été réalisées dans des conditions de salle blanche.

On réalise un film électro-greffé sur ces substrats en les utilisant comme électrode de travail dans un montage à trois électrodes analogue à celui de l'exemple précédent. La solution d'électro-greffage est une solution de 4-vinyl pyridine et de bromure cuivreux dans la diméthyl formamide, en présence de perchlorate de tétraéthyl-ammonium (TEAP) comme électrolyte support. Les coupons sont trempés aux deux tiers de leur hauteur dans le bain d'électro-greffage, et le contact sur ces substrats est obtenu à l'aide d'une pince crocodile qui ne trempe pas dans le bain.

Des résultats spectaculaires sont obtenus : on observe une métallisation uniforme (les mesures au ménisque et à 5 cm du ménisque sont identiques, à la précision d'un microscope à force atomique (AFM)), même à quelques centimètres de l'électrode de contact.

On réalise ensuite une expérience complémentaire où le substrat est préalablement rayé horizontalement à un cinquième de sa hauteur à partir du bas environ, suffisamment profondément pour atteindre la couche de SiO₂ sous-jacente. Le coupon ainsi rayé est trempé dans le bain d'électro-greffage, rayure en bas, de sorte que la rayure est dans la solution. Le coupon est - comme précédemment - trempé aux deux tiers de sa hauteur et le contact (pince) ne trempe pas dans le bain.

En réalisant l'électro-greffage en conditions voltammétriques comme précédemment, on observe un dépôt uniforme de cuivre depuis le ménisque jusqu'à la rayure, mais rien entre la rayure et le bas de la lame : la partie de la surface TiN qui n'est plus électriquement connectée n'est pas recouverte. Ceci confirme que la croissance est bien électriquement activée, et que le dépôt n'est pas obtenu par un procédé de chimisorption sans courant (figure 30 annexée).

De même que sur le substrat plan sans rayure, des mesures d'épaisseur par AFM révèlent une grande uniformité du dépôt de cuivre, et donc une très faible sensibilité à la chute ohmique du substrat TiN semi-conducteur : même en présence du précurseur de cuivre, le mécanisme de croissance a les caractéristiques d'une réaction électro-initiée de l'électro-greffage.

En outre, les mêmes tentatives sans précurseur organique (4-vinyl pyridine) n'ont pas montré de dépôt métallique direct sur la barrière de TiN, à part au niveau du ménisque, ce qui est attribué aux effets connus de la chute ohmique du substrat.

Il doit être noté toutefois que les courants de mesure sont rapidement beaucoup plus élevés (de l'ordre de plusieurs mA) que ce qui était attendu d'un simple procédé d'électro-initiation. La majorité du courant traversant l'électrode correspondrait à la réduction des ions cuivreux en cuivre métallique sur la seed-layer naissante qui est formée dans les premiers instants. Les courants résiduels dus aux réactions d'électro-greffage ne sont probablement pas détectables lorsque la croissance du cuivre - au-delà de la seed-layer - est en marche.

Des tests complémentaires ont été enfin réalisés sur des échantillons comportant des motifs (tranchées de 0,22 →m de large, espacées de 0,22 →m et profondes de 0,4 →m), pour étudier les propriétés morphologiques des dépôts. Les mêmes conditions voltammétriques sont appliquées, dans les mêmes bains et selon le même montage. On observe - là encore - un dépôt macroscopique uniforme de cuivre.

Les coupons sont trempés aux deux tiers dans le bain, si bien que le dépôt de seed-layer est obtenu sur deux tiers du coupon, le dernier tiers étant du TiN non traité.

Des observations en microscopie électronique à balayage (SEM) sur les zones traitées montrent clairement un film métallique sur la couche barrière, qui est parfaitement continu et, de manière très intéressante, conforme à la surface. Ce résultat clé est en ligne avec la haute conformité obtenue avec une couche électrogreffée seule.

Ces couches de germination ont été utilisées pour initier un dépôt électrochimique (ECD) de cuivre à partir d'un bain commercial. A cet effet, on prend un contact électrique sur la partie précédemment électro-greffée des échantillons. Ainsi, au cours du dépôt de cuivre par ECD, l'échantillon a été renversé, et la zone de celui-ci qui n'a pas été antérieurement électrogreffée est exposée au bain d'électro-dépôt chimique du cuivre.

Après électrodéposition de cuivre, l'aspect des échantillons est très intéressant : une jolie couche de métallisation de cuivre uniforme est observée sur le tiers central du coupon, c'est-à-dire sur la surface précédemment électro-greffée de l'échantillon, alors qu'aucun cuivre n'est déposé sur la couche barrière TiN. De plus, comme précédemment, c'est sur le tiers supérieur de la lame - électro-greffé - que le contact a été pris, ce contact ne trempant pas dans le bain d'ECD et étant situé à plus d'un cm du ménisque : la couche de germination a donc été suffisamment continue et conductrice pour permettre le dépôt de cuivre ECD sur la zone traitée trempant dans le bain (figure 31). Sur la figure 31, « x » représente la partie de la lame où est effectué l'électrogreffage ; « y » représente la zone de contact pour l'élèctrogreffage ; « z » représente le contact pour l'électrodéposition ; et « t » représente la partie de la lame sur laquelle il y a électrodéposition.

D'un point de vue microscopique, l'examen du remplissage du cuivre a été réalisé par SEM sur des coupes d'échantillon réalisées par nano-usinage (FIB : faisceau d'ions focalisés, « Focused Ion Beam » en anglais). On observe un remplissage satisfaisant des tranchées, même si quelques vides apparaissent. Les inventeurs pensent que dans des conditions plus favorables (salle blanche, contrôle amélioré des surfaces chimiques et de barrière, etc. les performances de remplissage des tranchées peuvent être nettement améliorées (figure 32 annexée).

## Revendications

1. Procédé de revêtement d'une surface d'un substrat par un film de germination d'un matériau métallique, ladite surface étant une surface conductrice ou semi-conductrice de l'électricité et présentant des creux et/ou des saillies, ledit procédé comprenant les étapes suivantes :
- disposer sur ladite surface un film organique adhérant à ladite surface et ayant une épaisseur telle que la face libre de ce film suit de manière conforme les creux et/ou saillies de ladite surface conductrice ou semi-conductrice de l'électricité sur laquelle il est disposé,
- insérer au sein dudit film organique disposé sur ladite surface un précurseur du matériau métallique, en même temps que, ou après, l'étape consistant à disposer sur ladite surface ledit film organique,
- transformer ledit précurseur du matériau métallique inséré au sein dudit film organique en ledit matériau métallique de manière à ce que ce matériau métallique se forme conformément audits creux et/ou saillies de ladite surface à revêtir et au sein dudit film organique pour constituer avec ce dernier ledit film de germination.

2. Procédé de fabrication d'interconnexions d'un circuit intégré en microélectronique, lesdites interconnexions étant constituées d'un matériau métallique, ledit procédé comprenant, dans cet ordre, les étapes consistant à :
a) graver dans un substrat diélectrique des motifs d'interconnexions, lesdits motifs formant des creux, et éventuellement des saillies, sur et/ou à travers ledit substrat,
b) déposer sur ledit substrat diélectrique gravé une couche barrière conductrice empêchant la migration du matériau métallique d'interconnexions dans ledit substrat, ladite couche barrière ayant une épaisseur telle que la face libre de cette couche suit de manière conforme les motifs d'interconnexions dudit substrat sur laquelle elle est déposée,
c) revêtir la couche barrière conductrice déposée sur le substrat gravé par un film de germination d'un matériau métallique au moyen du procédé de la revendication 1,
d) remplir les creux par ledit matériau métallique à partir dudit film de germination pour former lesdites interconnexions métallique constituées dudit matériau métallique.

3. Procédé selon la revendication 1 ou 2, dans lequel le film organique est une macromolécule organique ou un polymère.

4. Procédé selon la revendication 1 ou 2, dans lequel le film organique est obtenu à partir d'un précurseur chimique de celui-ci choisi dans le groupe constitué des monomères vinyliques, d'ester de l'acide méthacrylique ou acrylique, des sels de diazonium fonctionnalisés ou non, des sels de sulfonium fonctionnalisés ou non, des sels de phosphonium fonctionnalisés ou non, des sels d'iodonium fonctionnalisés ou non, des précurseurs de polyamides obtenus par polycondensation, des monomères cycliques clivables par attaque nucléophile ou électrophile et de leurs mélanges.

5. Procédé selon la revendication 1 ou 2, dans lequel le film organique est obtenu à partir d'un ou de plusieurs monomère(s) vinylique(s) activé(s), de structure (I) suivante : 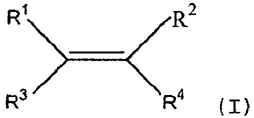 dans laquelle R¹, R², R³, R⁴, sont des groupements organiques choisis indépendamment les uns des autres dans le groupe constitué des fonctions organiques suivantes : hydrogène, hydroxyle, amine, thiol, acide carboxylique, ester, amide, imide, imido-ester, halogénure d'acide, anhydride d'acide, nitrile, succinimide, phtalimide, isocyanate, époxyde, siloxane, benzoquinone, benzophénone, carbonyle-diimidazole, para-toluène sulfonyle, para-nitrophényl chloroformiate, éthylénique, vinylique, et aromatique.

6. Procédé selon la revendication 5, dans lequel, au moins un de R¹, R², R³, R⁴ est un groupement fonctionnel pouvant piéger le précurseur du matériau métallique.

7. Procédé selon la revendication 1 ou 2, dans lequel le film organique est un polymère obtenu par polymérisation d'un monomère vinylicue choisi dans le groupe constitué des monomères vinyliques comme l'acrylonitrile, le méthacrylonitrile, le méthacrylate de méthyle, le méthacrylate d'éthyle, le méthacrylate de butyle, le méthacrylate de propyle, le méthacrylate d'hydroxyéthyle, le méthacrylate d'hydroxypropyle, le méthacrylate de glycidyle, les acrylamides et notamment les méthacrylamides d'amino- éthyle, propyle, butyle, pentyle et hexyle, les cyanoacrylates, le polyéthylène glycol di-méthacrylate, l'acide acrylique, l'acide méthacrylique, le styrène, le parachloro-styrène, la N-vinyl pyrrolidone, la 4-vinyl pyridine, les halogénures de vinyle, le chlorure d'acryloyle, le chlorure de méthacryloyle, et de leur dérivés.

8. Procédé selon la revendication 1, dans lequel le film organique comprend des groupes fonctionnels ligands pour des ions métalliques précurseurs du matériau métallique.

9. Procédé selon la revendication 1 ou 2, dans lequel le film organique est déposé sur la surface au moyen d'une technique choisie parmi une polymérisation électro-suivie, une centrifugation, un trempage et une pulvérisation.

10. Procédé selon la revendication 1 ou 2, dans lequel, du fait des dimensions des creux et/ou saillies, le film organique est disposé sur la surface avec une épaisseur de 0,001 à 500µm ou de 0,001 à 100µm.

11. Procédé selon la revendication 1 ou 2, dans lequel, du fait des dimensions des creux et/ou saillies, le film organique est disposé sur la surface avec une épaisseur de 0,001 à 10µm.

12. Procédé selon la revendication 1 ou 2, dans lequel le précurseur du matériau métallique est choisi tel qu'il peut être transformé en ledit matériau métallique par une technique choisie parmi une précipitation, une cristallisation, une réticulation, une agrégation ou une électrodéposition.

13. Procédé selon la revendication 1 ou 2, dans lequel le précurseur du matériau métallique est un ion dudit matériau métallique.

14. Procédé selon la revendication 1 ou 2, dans lequel le précurseur du matériau métallique est choisi dans le groupe constitué par les ions du cuivre, les ions du zinc, les ions de l'or, les ions de l'étain, du titane, du vanadium, du chrome, du fer, du cobalt, du lithium, du sodium, de l'aluminium, du magnésium, du potassium, du rubidium, du césium, du strontium, de l'yttrium, du niobium, du molybdène, du ruthénium, du rhodium, du palladium, de l'argent, du cadmium, de l'indium, du lutécium, de l'hafrium, du tantale, du tungstène, du rhénium, de l'osmium, de l'iridium, du platine, du mercure, du thallium, du plomb, du bismuth, des lanthanides et des actinides.

15. Procédé selon la revendication 1 ou 2, dans lequel le matériau métallique est du cuivre ou du platine.

16. Procédé selon la revendication 1 ou 2, dans lequel le précurseur est sous la forme de particules ou d'agrégats métalliques enrobés dans une gangue de protection choisie dans le groupe constitué des micelles, des nanosphères de polymères, des fullerènes, des nanotubes de carbone, et des cyclodextrines, et dans lequel l'étape de transformation du précurseur en ledit matériau métallique est réalisée par libération des particules ou des agrégats métalliques de leur gangue.

17. Procédé selon la revendication 1 ou 2, dans lequel le précurseur du matériau métallique est inséré dans le film organique au moyen d'une technique de trempage ou de centrifugation.

18. Procédé selon la revendication 1 ou 2, dans lequel le précurseur du matériau métallique est inséré au sein du film organique, disposé sur la surface, au moyen d'une solution d'insertion qui est à la fois un solvant du précurseur du matériau métallique, et un solvant du film organique, ladite solution d'insertion comprenant ledit précurseur du matériau métallique.

19. Procédé selon la revendication 1 ou 2, dans lequel le précurseur du matériau métallique est inséré au sein du film organique, disposé sur la surface, au moyen d'une solution d'insertion qui est à la fois un solvant ou un dispersant du précurseur du matériau métallique, et une solution qui gonfle le premier matériau, ladite solution d'insertion comprenant ledit précurseur du matériau métallique.

20. Procédé selon la revendication 1 ou 2, dans lequel l'étape consistant à insérer le précurseur du matériau métallique au sein du film organique disposé sur ladite surface est réalisée en même temps que l'étape consistant à disposer sur ladite surface le film organique au moyen d'une solution d'insertion comprenant à la fois ledit film organique ou un précurseur dudit film organique, et le précurseur du matériau métallique.

21. Procédé selon la revendication 1 ou 2, dans lequel l'étape d'insertion du précurseur du matériau métallique dans le film organique est réalisée au moyen d'une première solution contenant le précurseur du matériau métallique, et dans lequel l'étape de transformation du précurseur métallique en ledit matériau métallique au sein du film organique est réalisée au moyen d'une deuxième solution ne contenant pas ledit précurseur du matériau métallique.

22. Procédé selon la revendication 21, dans lequel les étapes d'insertion du précurseur du matériau métallique dans le film organique et de transformation dudit précurseur en ledit matériau métallique sont répétées plusieurs fois alternativement.

23. Procédé selon la revendication 17, 18, 19 ou 20, dans lequel la solution d'insertion est une solution aqueuse.

24. Procédé selon la revendication 1 ou 2, dans lequel le précurseur du matériau métallique est transformé en ledit matériau métallique par électrodéposition, précipitation, ou transformation autocatalytique.

25. Procédé selon la revendication 1 ou 2, dans lequel la surface est une surface conductrice ou semi-conductrice, le film organique est constitué d'un polymère vinylique, et le matériau métallique est du cuivre ou du platine, le précurseur du matériau métallique étant un ion du cuivre ou du platine.

26. Procédé selon la revendication 1, dans lequel la surface présentant des creux et/ou des saillies est une surface de micropuce.

27. Procédé selon la revendication 1, dans lequel ledit substrat comporte à sa surface conductrice et/ou semi-conductrice de l'électricité présentant des creux et/ou des saillies une couche barrière empêchant une migration du matériau métallique dans ledit substrat, ladite couche barrière ayant une épaisseur telle que la face libre de cette couche suit de manière conforme les creux et/ou saillies dudit substrat sur laquelle elle est déposée.

28. Procédé selon la revendication 27, dans lequel, avant l'étape consistant à disposer sur ladite surface du substrat le film organique, le procédé comprend en outre une étape consistant à déposer ladite couche barrière.

29. Procédé selon la revendication 2 ou 27, dans lequel la couche barrière est une couche d'un matériau choisi dans le groupe constitué de titane ; de tantale ; des nitrures de titane, de tantale et de tungstène ; de carbure de titane et de tungstène ; de carbonitrure de tantale, tungstène et chrome ; de nitrure de titane ou tantale dopé au silicium ; et d'alliages ternaires comportant du cobalt ou du nickel allié à un réfractaire tel que du molybdène, du rhénium ou du tungstène, et à un dopant tel que du phosphore ou du bore.

30. Procédé selon la revendication 2 ou 27, dans lequel la couche barrière est déposée par une technique choisi dans le groupe constitué des techniques de dépôt chimique ou physique en phase vapeur.

31. Procédé selon la revendication 2 ou 27, dans lequel la couche barrière est une couche de TiN ou de TiN(Si), et le matériau métallique du cuivre.

32. Procédé selon la revendication 2 ou 27, dans lequel le substrat est une couche isolante inter niveaux pour la fabrication d'un circuit intégré.

33. Procédé selon la revendication 2 ou 27, dans lequel l'étape de remplissage des creux est réalisée au moyen d'une technique de dépôt autocatalytique à partir d'une solution de précurseur du matériau métallique, ou au moyen d'une technique de dépôt électrolytique dudit matériau métallique.

34. Procédé selon la revendication 2 ou 27, comprenant après l'étape de remplissage des creux par le matériau métallique, une étape de polissage du matériau métallique qui se trouve en excès sur ladite surface.

35. Utilisation du procédé selon la revendication 1 pour la fabrication d'un élément d'interconnexion en microélectronique.

36. Utilisation du procédé selon la revendication 1 ou 2 pour la fabrication d'un microsystème électronique.

37. Circuit intégré susceptible d'être obtenu par la mise en oeuvre du procédé de la revendication 2.

38. Microsystème électronique susceptible d'être obtenu par la mise en oeuvre du procédé de la revendication 2.

39. Circuit intégré **caractérisé en ce qu'**il comprend un film de germination obtenu par le procédé selon la revendication 1.

40. Microsystème **caractérisé en ce qu'**il comprend un film de germination obtenu par le procédé selon la revendication 1.

41. Procédé de galvanisation d'une surface, ladite surface étant une surface conductrice ou semi-conductrice de l'électricité et présentant des creux et/ou des saillies, ledit procédé comprenant les étapes suivantes :
- revêtement de ladite surface par un film de germination d'un matériau métallique suivant le procédé de la revendication 1, et
- dépôt galvanique d'une couche métallique dudit matériau métallique à partir dudit film de germination obtenu.

## Patentansprüche

1. Verfahren zur Beschichtung einer Oberfläche eines Substrats mit einem Film zur Keimung für ein Metallmaterial, wobei die Oberfläche eine elektrisch leitende oder halbleitende Oberfläche ist und Aushöhlungen und/oder Vorsprünge aufweist, wobei das Verfahren die folgenden Schritte umfasst:
- Anordnen eines organischen Films auf der Oberfläche, der an der Oberfläche haftet und eine Dicke derart hat, dass die freie Fläche dieses Films in konformer Weise den Aushöhlungen und/oder Vorsprüngen der elektrisch leitenden oder halbleitenden Oberfläche folgt, auf der er angeordnet ist,
- Einfügen eines Präkursors des Metallmaterials in den organischen Film, der auf der Oberfläche angeordnet ist, gleichzeitig mit oder nach dem Schritt des Anordnens des organischen Films auf der Oberfläche,
- Transformieren des in den organischen Film eingefügten Präkursors des Metallmaterials in das Metallmaterial derart, dass sich dieses Metallmaterial konform mit den Aushöhlungen und/oder Vorsprüngen der zu beschichtenden Oberfläche und in dem organischen Film bildet, um mit diesem zusammen den Keimungsfilm zu bilden.

2. Verfahren zur Herstellung von Zwischenverbindungen einer integrierten mikroelektronischen Schaltung, wobei die Zwischenverbindungen aus einem Metallmaterial gebildet sind, wobei das Verfahren in dieser Reihenfolge die folgenden Schritte umfasst:
a) Gravieren von Zwischenverbindungsmotiven in ein dielektrisches Substrat, wobei die Motive Aushöhlungen und gegebenenfalls Vorsprünge bilden, auf dem und/oder durch das Substrat hindurch,
b) Aufbringen einer leitenden Barriereschicht auf das gravierte dielektrische Substrat, die die Migration des Metallmaterials der Zwischenverbindungen in das Substrat verhindert, wobei die Barriereschicht eine Dicke derart hat, dass die freie Fläche dieser Schicht in konformer Weise den Zwischenverbindungsmotiven des Substrats folgt, auf dem sie aufgebracht ist,
c) Beschichten der auf dem gravierten Substrat aufgebrachten leitenden Barriereschicht mit einem Film zur Keimung eines Metallmaterials mit Hilfe des Verfahrens nach Anspruch 1,
d) Füllen der Aushöhlungen mit dem Metallmaterial ausgehend von dem Keimungsfilm zum Bilden der metallischen Zwischenverbindungen, die aus dem Metallmaterial gebildet sind.

3. Verfahren nach Anspruch 1 oder 2, wobei der organische Film ein organisches Makromolekül oder ein Polymer ist.

4. Verfahren nach Anspruch 1 oder 2, wobei der organische Film erhalten wird ausgehend von einem chemischen Präkursor davon, ausgewählt aus der Gruppe gebildet durch die Vinyl-, Methacrylsäureester- oder Acrylsäureestermonomere, die wohl oder nicht funktionalisierten Diazoniumsalze, die wohl oder nicht funktionalisierten Sulfoniumsalze, die wohl oder nicht funktionalisierten Phosphoniumsalze, die wohl oder nicht funktionalisierten Iodoniumsalze, die durch Polykondensation erhaltenen Polyamidpräkursoren, die durch nukleophilen oder elektrophilen Angriff spaltbaren zyklischen Monomere und ihre Mischungen.

5. Verfahren nach Anspruch 1 oder 2, bei dem der organische Film erhalten wird ausgehend von einem oder mehreren aktivierten Vinylmonomer(en) mit der folgenden Struktur (I): 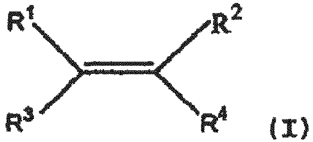 wobei R¹, R², R³, R⁴ organische Gruppen sind, die unabhängig voneinander aus der Gruppe ausgewählt werden, gebildet durch die folgenden organischen Funktionen: Wasserstoff, Hydroxyl, Amin, Thiol, Carboxylsäure, Ester, Amid, Imid, Imid-Ester, Säurehalogenid, Säureanhydrid, Nitril, Sukzinimid, Phtalimid, Isozyanat, Epoxid, Siloxan, Benzokinon, Benzophenon, Karbonyl-Diimidazol, Para-Toluol-Sulfonyl, Para-Nitrophenyl-Chloroformiat, Äthylen, Vinyl und Aromat.

6. Verfahren nach Anspruch 5, wobei wenigstens eines von R¹, R², R³, R⁴ eine funktionale Gruppe ist, die den Präkursor des Metallmaterials einfangen kann.

7. Verfahren nach Anspruch 1 oder 2, wobei der organische Film ein Polymer ist, erhalten durch Polymerisation eines Vinylmonomers, ausgewählt aus der Gruppe gebildet durch die Vinylmonomere wie Acrylonitril, Methacrylonitril, Methylmethacrylat, Ethylmethacrylat, Butylmethacrylat, Propylmethacrylat, Hydroxyethylmethacrylat, Hydroxypropylmethacrylat, Glycidylmethacrylat, die Acrylamide und insbesondere die Methacrylamide von Amino-Ethyl, Propyl, Butyl, Pentyl und Hexyl, die Cyanacrylate, Polyethylen-Glykol-Di-Methacrylat, Acrylsäure, Methacrylsäure, Styrol, Parachlorstyrol, N-Vinylpyrrolidon, 4-Vinyl-Pyridin, die Vinylhalogenide, Acryloyl-Chlorid, Methacryloyl-Chlorid und ihre Derivate.

8. Verfahren nach Anspruch 1, wobei der organische Film funktionale Gruppen als Liganden für Präkursor-Metallionen des Metallmaterials umfasst.

9. Verfahren nach Anspruch 1 oder 2, wobei der organische Film auf der Oberfläche mit Hilfe einer Technik aufgebracht wird, ausgewählt aus einer Elektrofolge-Polymerisation, einer Zentrifugierung, einem Eintauchen und einer Pulverisierung.

10. Verfahren nach Anspruch 1 oder 2, wobei aufgrund der Abmessungen der Aushöhlungen und/oder Vorsprünge der organische Film auf der Oberfläche mit einer Dicke von 0,001 bis 500µm oder von 0,001 bis 100µm aufgebracht wird.

11. Verfahren nach Anspruch 1 oder 2, wobei aufgrund der Abmessungen der Aushöhlungen und/oder Vorsprünge der organische Film auf der Oberfläche mit einer Dicke von 0,001 bis 10µm aufgebracht wird.

12. Verfahren nach Anspruch 1 oder 2, wobei der Präkursor des Metallmaterials derart ausgewählt wird, dass er in das Metallmaterial transformiert werden kann mittels einer Technik, ausgewählt aus einer Fällung, einer Kristallisation, einer Vernetzung, einer Aggregation oder einer Elektroabscheidung.

13. Verfahren nach Anspruch 1 oder 2, wobei der Präkursor des Metallmaterials ein Ion des Metallmaterials ist.

14. Verfahren nach Anspruch 1 oder 2, wobei der Präkursor des Metallmaterials ausgewählt ist aus der Gruppe gebildet durch die Kupferionen, die Zinkionen, die Goldionen, die Zinnionen, Titan, Vanadium, Chrom, Eisen, Kobalt, Lithium, Natrium, Aluminium, Magnesium, Kalium, Rubidium, Caesium, Strontium, Yttrium, Niob, Molybdän, Ruthenium, Rhodium, Palladium, Silber, Kadmium, Indium, Lutetium, Hafnium, Tantal, Wolfram, Rhenium, Osmium, Iridium, Platin, Quecksilber, Thallium, Blei, Wismut, Lanthanide und Actinide.

15. Verfahren nach Anspruch 1 oder 2, wobei das Metallmaterial Kupfer oder Platin ist.

16. Verfahren nach Anspruch 1 oder 2, wobei der Präkursor die Form von metallischen Partikeln oder Aggregaten hat, eingebettet in eine Schutzmatrix ausgewählt aus der Gruppe gebildet durch die Mizellen, die Polymer-Nanokügelchen, die Fullerene, die Kohlenstoffnanoröhrchen, und die Cyclodextrine, und wobei der Schritt der Transformation des Präkursors in das Metallmaterial realisiert wird durch Freisetzung der metallischen Partikel oder Aggregate von ihrer Matrix.

17. Verfahren nach Anspruch 1 oder 2, wobei der Präkursor des Metallmaterials in den organischen Film mittels einer Eintauch- oder Zentrifugiertechnik eingefügt wird.

18. Verfahren nach Anspruch 1 oder 2, wobei der Präkursor des Metallmaterials in den auf der Oberfläche angeordneten organischen Film mittels einer Einfügelösung eingefügt wird, die gleichzeitig ein Lösungsmittel des Präkursors des Metallmaterials und ein Lösungsmittel des organischen Films ist, wobei die Einfügelösung den Präkursor des Metallmaterials enthält.

19. Verfahren nach Anspruch 1 oder 2, wobei der Präkursor des Metallmaterials in den auf der Oberfläche angeordneten organischen Film mittels einer Einfügelösung eingefügt wird, die gleichzeitig ein Lösungsmittel oder ein Dispersionsmittel des Präkursors des Metallmaterials ist, und eine Lösung, die das erste Material aufquellt, wobei die Einfügelösung den Präkursor des Metallmaterials umfasst.

20. Verfahren nach Anspruch 1 oder 2, wobei der Schritt des Einfügens des Präkursors des Metallmaterials in den auf der Oberfläche angeordneten organischen Film gleichzeitig mit dem Schritt des Anordnens des organischen Films auf der Oberfläche mit Hilfe einer Einfügelösung realisiert wird, die gleichzeitig den organischen Film oder einen Präkursor des organischen Films und den Präkursor des Metallmaterials umfasst.

21. Verfahren nach Anspruch 1 oder 2, wobei der Schritt des Einfügens des Präkursors des Metallmaterials in den organischen Film mit Hilfe einer ersten Lösung realisiert wird, die den Präkursor des Metallmaterials enthält, und wobei der Schritt der Transformation des Metallpräkursors in das Metallmaterial in dem organischen Film mit Hilfe einer zweiten Lösung realisiert wird, die den Präkursor des Metallmaterials nicht enthält.

22. Verfahren nach Anspruch 21, wobei die Schritte des Einfügens des Präkursors des Metallmaterials in den organischen Film und der Transformation des Präkursors in das Metallmaterial mehrere Male alternierend wiederholt werden.

23. Verfahren nach Anspruch 17, 18, 19 oder 20, wobei die Einfügelösung eine wässrige Lösung ist.

24. Verfahren nach Anspruch 1 oder 2, wobei der Präkursor des Metallmaterials in das Metallmaterial transformiert wird durch Elektroabscheidung, Fällung oder autokatalytische Transformation.

25. Verfahren nach Anspruch 1 oder 2, wobei die Oberfläche eine leitende oder halbleitende Oberfläche ist, der organische Film durch ein Vinylpolymer gebildet ist, und das Metallmaterial Kupfer oder Platin ist, wobei der Präkursor des Metallmaterials ein Kupfer- oder Platinion ist.

26. Verfahren nach Anspruch 1, wobei die Oberfläche, die Aushöhlungen und/oder Vorsprünge aufweist, eine Mikrochip-Oberfläche ist.

27. Verfahren nach Anspruch 1, wobei das Substrat an seiner elektrisch leitenden und/oder halbleitenden Oberfläche, die Hohlräume und/oder Vorsprünge aufweist, eine Barriereschicht umfasst, die eine Migration des Metallmaterials in das Substrat verhindert, wobei die Barriereschicht eine Dicke derart hat, dass die freie Fläche dieser Schicht in konformer Weise den Aushöhlungen und/oder Vorsprüngen des Substrats folgt, auf dem sie aufgebracht ist.

28. Verfahren nach Anspruch 27, wobei vor dem Schritt des Aufbringens des organischen Films auf der Oberfläche des Substrats das Verfahren ferner einen Schritt des Aufbringens der Barriereschicht umfasst.

29. Verfahren nach Anspruch 2 oder 27, wobei die Barriereschicht eine Schicht aus einem Material ist, ausgewählt aus der Gruppe gebildet durch Titan, Tantal, die Ninitride von Titan, von Tantal und von Wolfram, Titan- und Wolframkarbid, Tantal-, Wolfram- und Chrom-Karbonitrid, Titan- oder Tantalnitrid, dotiert mit Silicium, und ternäre Legierungen umfassend Kobalt oder Nickel, vermischt mit einem hochschmelzenden Material wie Molybden, Rhenium oder Wolfram, und mit einem Dotierungsmittel wie Phosphor oder Bor.

30. Verfahren nach Anspruch 2 oder 27, wobei die Barriereschicht durch eine Technik aufgebracht wird, ausgewählt aus der Gruppe gebildet durch die chemischen oder physikalischen Dampfphasentechniken.

31. Verfahren nach Anspruch 2 oder 27, wobei die Barriereschicht eine TiN- oder TiN(Si)-Schicht ist, und das Metallmaterial Kupfer ist.

32. Verfahren nach Anspruch 2 oder 27, wobei das Substrat eine isolierende Zwischenniveauschicht für die Herstellung einer integrierten Schaltung ist.

33. Verfahren nach Anspruch 2 oder 27, wobei der Schritt des Füllens der Aushöhlungen realisiert wird mit Hilfe einer autokatalytischen Abscheidetechnik ausgehend von einer Lösung des Präkursors des Metallmaterials oder mit Hilfe einer Technik zur elektrolytischen Abscheidung des Metallmaterials.

34. Verfahren nach Anspruch 2 oder 27, umfassend, nach dem Schritt des Füllens der Aushöhlungen mit dem Metallmaterial, einen Schritt des Polierens des Metallmaterials, das sich im Überschuss auf der Oberfläche befindet.

35. Verwendung des Verfahrens nach Anspruch 1 zur Herstellung eines mikroelektronischen Zwischenverbindungselements.

36. Verwendung des Verfahrens nach Anspruch 1 oder 2 für die Herstellung eines elektronischen Mikrosystems.

37. Integrierte Schaltung, die erhältlich ist durch Verwendung des Verfahrens nach Anspruch 2.

38. Elektronisches Mikrosystem, das erhältlich ist durch die Verwendung des Verfahrens nach Anspruch 2.

39. Integrierte Schaltung, **dadurch gekennzeichnet, dass** sie einen Keimungsfilm umfasst, der durch das Verfahren nach Anspruch 1 erhalten ist.

40. Mikrosystem, **dadurch gekennzeichnet, dass** es einen Keimungsfilm enthält, der durch das Verfahren nach Anspruch 1 erhalten ist.

41. Verfahren zum Galvanisieren einer Oberfläche, wobei die Oberfläche eine elektrisch leitende oder halbleitende Oberfläche ist und Aushöhlungen und/oder Vorsprünge aufweist, wobei das Verfahren die folgenden Schritte umfasst:
- Beschichten der Oberfläche mit einem Keimungsfilm für ein Metallmaterial gemäß dem Verfahren nach Anspruch 1, und
- Galvanische Abscheidung einer Metallschicht des Metallmaterials ausgehend von dem erhaltenen Keimungsfilm.

## Claims

1. Process for coating a surface of a substrate with a seed film of a metallic material, said surface being an electrically conductive or semiconductive surface and having recesses and/or projections, said process comprising the following steps:
- an organic film is placed on said surface, said film adhering to said surface and having a thickness such that the free face of this film conformally follows the recesses and/or projections of said electrically conductive or semiconductive surface on which it is placed;
- a precursor of the metallic material is inserted within said organic film placed on said surface, at the same time as, or after, the step consisting in placing said organic film on said surface; and
- said precursor of the metallic material inserted within said organic film is converted into said metallic material so that this metallic material forms conformally at said recesses and/or projections of said surface to be coated and within said organic film in order to form, with the latter, said seed film.

2. Process for fabricating interconnects for an integrated circuit in microelectronics, said interconnects consisting of a metallic material, said process comprising, in the following order, the steps consisting in:
a) etching interconnect patterns in a dielectric substrate, said patterns forming recesses and optionally projections on and/or through said substrate;
b) depositing a conducting barrier layer on said etched dielectric substrate, which layer prevents the metallic interconnect material from migrating into said substrate, said barrier layer having a thickness such that the free face of this layer conformally follows the interconnect patterns of said substrate on which said layer is deposited;
c) coating the conducting barrier layer deposited on the etched substrate with a seed film of a metallic material by means of the process of Claim 1; and
d) filling the recesses with said metallic material starting from said seed film in order to form said metal interconnects made of said metallic material.

3. Process according to Claim 1 or 2, in which the organic film is an organic macromolecule or a polymer.

4. Process according to Claim 1 or 2, in which the organic film is obtained from a chemical precursor thereof, selected from the group consisting of vinyl monomers, methacrylic or acrylic acid ester monomers, functionalized or unfunctionalized diazonium salts, functionalized or unfunctionalized sulphonium salts, functionalized or unfunctionalized phosphonium salts, functionalized or unfunctionalized iodonium salts, precursors for polyamides obtained by polycondensation, cyclic monomers that can be cleaved by nucleophilic or electrophilic attack, and mixtures thereof.

5. Process according to Claim 1 or 2, in which the organic film is obtained from one or more activated vinyl monomer(s) of the following structure (I): 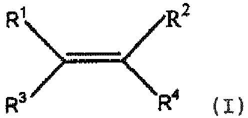 in which R¹, R², R³ and R⁴ are organic groups selected independently of one another from the group consisting of the following organic functions: hydrogen, hydroxyl, amine, thiol, carboxylic acid, ester, amide, imide, imidoester, acid halide, acid anhydride, nitrile, succinimide, phthalimide, isocyanate, epoxide, siloxane, benzoquinone, benzophenone, carbonyldiimidazole, p-toluenesulphonyl, p-nitrophenyl chloroformate, ethylene, vinyl and aromatic.

6. Process according to Claim 5, in which at least one of R¹, R², R³ and R⁴ is a functional group that can trap the precursor of the metallic material.

7. Process according to Claim 1 or 2, in which the organic film is a polymer obtained by the polymerization of a vinyl monomer selected from the group consisting of vinyl monomers, such as acrylonitrile, methacrylonitrile, methyl methacrylate, ethyl methacrylate, butyl methacrylate, propyl methacrylate, hydroxyethyl methacrylate, hydroxypropyl methacrylate, glycidyl methacrylate, acrylamides, and especially aminoethyl, aminopropyl, aminobutyl, aminopentyl and aminohexyl methacrylamides, cyanoacrylates, polyethylene glycol dimethacrylate, acrylic acid, methacrylic acid, styrene, p-chlorostyrene, N-vinylpyrrolidone, 4-vinylpyridine, vinyl halides, acryloyl chloride, methacryloyl chloride, and derivatives thereof.

8. Process according to Claim 1, in which the organic film includes functional groups that are ligands for precursor metal ions of the metallic material.

9. Process according to Claim 1 or 2, in which the organic film is deposited on the surface by means of a technique chosen from electro-mediated polymerization, spin coating, dip coating and spraying.

10. The process according to Claim 1 or 2, in which, owing to the dimensions of the recesses and/or projections, the organic film is placed on the surface with a thickness ranging from 0.001 to 500 *µ*m or from 0.001 to 100 *µ*m.

11. Process according to Claim 1 or 2, in which, owing to the dimensions of the recesses and/or projections, the organic film is placed on the surface with a thickness ranging from 0.001 to 10 *µ*m.

12. Process according to Claim 1 or 2, in which the precursor of the metallic material is chosen in such a way that it can be converted into said metallic material by a technique chosen from precipitation, crystallization, crosslinking, aggregation and electroplating.

13. Process according to Claim 1 or 2, in which the precursor of the metallic material is an ion of said metallic material.

14. Process according to Claim 1 or 2, in which the precursor of the metallic material is selected from the group consisting of copper ions, zinc ions, gold ions and ions of tin, titanium, vanadium, chromium, iron, cobalt, lithium, sodium, aluminium, magnesium, potassium, rubidium, caesium, strontium, yttrium, niobium, molybdenum, ruthenium, rhodium, palladium, silver, cadmium, indium, lutetium, hafnium, tantalum, tungsten, rhenium, osmium, iridium, platinum, mercury, thallium, lead, bismuth, lanthanides and actinides.

15. Process according to Claim 1 or 2, in which the metallic material is copper or platinum.

16. Process according to Claim 1 or 2, in which the precursor is in the form of metal particles or aggregates, optionally encapsulated in a protective gangue, selected from the group consisting of micelles, polymer nanospheres, fullerenes, carbon nanotubes, cyclodextrins, and in which the step of converting the precursor into said metallic material is carried out by releasing the metal particles or aggregates from their gangue.

17. Process according to Claim 1 or 2, in which the precursor of the metallic material is inserted into the organic film by means of a dipping or spin coating technique.

18. Process according to Claim 1 or 2, in which the precursor of the metallic material is inserted within the organic film, placed on the surface, by means of an insertion solution which is both a solvent for the precursor of the metallic material and a solvent for the organic film, said insertion solution including said precursor of the metallic material.

19. Process according to Claim 1 or 2, in which the precursor of the metallic material is inserted within the organic film, placed on the surface, by means of an insertion solution which is both a solvent or a dispersant for the precursor of the metallic material and a solution that swells the first material, said insertion solution including said precursor of the metallic material.

20. Process according to Claim 1 or 2, in which the step consisting in inserting the precursor of the metallic material within the organic film placed on said surface is carried out at the same time as the step consisting in placing the organic film on said surface by means of an insertion solution comprising both said organic film or a precursor of said organic film and the precursor of the metallic material.

21. Process according to Claim 1 or 2, in which the step of inserting the precursor of the metallic material into the organic film is carried out by means of a first solution containing the precursor of the metallic material, and in which the step of converting the precursor of the metallic material into said metallic material within the organic film is carried out by means of a second solution that does not contain said precursor of the metallic material.

22. Process according to Claim 21, in which the steps of inserting the precursor of the metallic material into the organic film and of converting said precursor into said metallic material are repeated several times alternately.

23. Process according to Claim 17, 18, 19 or 20, in which the insertion solution is an aqueous solution.

24. Process according to Claim 1 or 2, in which the precursor of the metallic material is converted into said metallic material by electroplating, precipitation or electroless conversion.

25. Process according to Claim 1 or 2, in which the surface is a conductive or semiconductive surface, the organic film consists of a vinyl polymer and the metallic material is copper or platinum, the precursor of the metallic material being a copper or platinum ion.

26. Process according to Claim 1, in which the surface having recesses and projections is a surface of a microchip.

27. Process according to Claim 1, in which said substrate includes on its electrically conductive and/or semiconductive surface having recesses and/or projections, a barrier layer that prevents the metallic material from migrating into said substrate, said barrier layer having a thickness such that the free face of this layer conformally follows the recesses and/or projections of said substrate on which said barrier layer is deposited.

28. Process according to Claim 27, in which, before the step consisting in placing the organic film on said surface of the substrate, it furthermore includes a step consisting in depositing said barrier layer.

29. Process according to Claim 2 or 27, in which the barrier layer is a layer of a material selected from the group consisting of titanium; tantalum; titanium, tantalum and tungsten nitrides; titanium and tungsten carbides; tantalum, tungsten and chromium carbonitrides; silicon-doped titanium or tantalum nitride; and ternary alloys comprising cobalt or nickel alloyed with a refractory such as molybdenum, rhenium or tungsten, and with a dopant such as phosphorus or boron.

30. Process according to Claim 2 or 27, in which the barrier layer is deposited by a technique selected from the group consisting of chemical or physical vapour deposition techniques.

31. Process according to Claim 2 or 27, in which the barrier layer is a TiN or TiN(Si) layer and the metallic material is copper.

32. Process according to Claim 2 or 27, in which the substrate is an inter-level insulating layer for the fabrication of an integrated circuit.

33. Process according to Claim 2 or 27, in which the step of filling the recesses is carried out by means of an electroless plating technique from a solution of the precursor of the metallic material, or by means of an electroplating technique for depositing said metallic material.

34. Process according to Claim 2 or 27, which includes, after the step of filling the recesses with the metallic material, a step of polishing the excess metallic material lying on said surface.

35. Use of the process according to Claim 1 for fabricating an interconnection element in microelectronics.

36. Use of the process according to Claim 1 or 2 for fabricating an electronic microsystem.

37. Integrated circuit that can be obtained by implementing the process of Claim 2.

38. Electronic microsystem that can be obtained by implementing the process of Claim 2.

39. Integrated circuit, **characterized in that** it includes a seed film obtained by the process according to Claim 1.

40. Microsystem, **characterized in that** it includes a seed film obtained by the process according to Claim 1.

41. Process for galvanically plating a surface, said surface being an electrically conductive or semiconductive surface and having recesses and/or projections, said process comprising the following steps:
- coating of said surface with a seed film of a metallic material using the process of Claim 1; and
- galvanic deposition of a metal layer of said metallic material starting from said seed film obtained.
